# EUROPEAN PATENT APPLICATION

(11) **EP 4 432 805 A1**
(43) Date of publication of application: **18.09.2024**
(21) Application number: 23211595.6
(22) Date of filing: 22.11.2023
(51) Int. Cl.: H10B 41/10, H10B 41/27, H10B 41/50, H10B 51/10, H10B 51/50

(54) **THREE-DIMENSIONAL SEMICONDUCTOR MEMORY DEVICE AND ELECTRONIC SYSTEM INCLUDING THE SAME**

(30) Priority: 14.03.2023 KR 20230033295
(71) Applicant: Samsung Electronics Co., Ltd., Suwon-si, Gyeonggi-do 16677 (KR)
(72) Inventor: BAEK, Seokcheon, 16677 Suwon-si (KR)
(74) Representative: Marks & Clerk LLP

(57) **Abstract**

A semiconductor device includes a substrate including a cell array region and a connection region in a first direction and a stack structure including electrode layers and interelectrode insulating layers alternately stacked in a second direction, the electrode layers including first electrode layers and second electrode layers alternately stacked, each of the first electrode layers includes a first connection portion in the cell array region and a first front end and a first back end spaced apart from each other in a third direction in the connection region and positioned at the same level as each other, the first front end and the first back end are connected to the first connection portion, the first front end has a first protrusion protruding toward the first back end, and the first protrusions of the first front ends do not overlap the second electrode layers.

## Description

### FIELD OF THE INVENTION

The present disclosure relates to semiconductor devices and electronic systems including the same, and more particularly, relates to three-dimensional semiconductor memory devices having improved reliability and integration, and electronic systems including the same.

### BACKGROUND

Recently, demand for higher integration of semiconductor devices has increased to obtain improved performance and/or low price for user needs. In semiconductor memory devices, higher integration may be particularly required, because integration is a significant factor in determining prices. In two dimensional or planar semiconductor devices, because the integration degree mainly depends on an area occupied by a unit memory cell, integration is affected by the technique(s) used to form fine patterns. To realize minute patterns, however, an increase in integration of the two dimensional semiconductor devices may be restricted since it may be necessary to install expensive equipment. Accordingly, three-dimensional semiconductor memory devices having three-dimensionally arranged memory cells have been proposed.

### SUMMARY

Objects of the present disclosure are to provide three-dimensional semiconductor memory devices with improved integration and reliability and electronic systems including the same.

The problems to be solved by the present disclosure are not limited to the problems mentioned above, and other problems not mentioned will be clearly understood by those skilled in the art from the description below.

A three-dimensional semiconductor memory device according to some example embodiments of the present disclosure includes a substrate including a cell array region and a connection region side by side in a first direction and a stack structure including electrode layers and inter-electrode insulating layers alternately stacked in a second direction perpendicular to the substrate, the electrode layers including first electrode layers and second electrode layers alternately stacked, each of the first electrode layers includes a first connection portion in the cell array region and a first front end and a first back end spaced apart from each other in a third direction crossing the first and second directions in the connection region and positioned at the same level as each other, the first front end and the first back end are connected to the first connection portion, the first front end has a first protrusion protruding toward the first back end, and the first protrusions of the first front ends do not overlap the second electrode layers.

A three-dimensional semiconductor memory device according to some example embodiments of the present disclosure includes a peripheral circuit structure and a cell array structure thereon, the cell array structure includes a substrate including a cell array region and a connection region side by side in a first direction, a source structure on the substrate, a stack structure including electrode layers and inter-electrode insulating layers alternately stacked in a second direction perpendicular to an upper surface of the source structure, the electrode layers including first electrode layers and second electrode layers alternately stacked, vertical patterns penetrating the stack structure and the source structure on the cell array region, and cell contacts penetrating an end of the stack structure on the connection region, each of the first electrode layers includes a first connection portion in the cell array region and a first front end and a first back end are spaced apart from each other in a third direction crossing the first and second directions in the connection region and positioned at the same level, the first front end and the first back end are connected to the first connection portion, the first front end has a first protrusion protruding toward the first back end, the first protrusions of the first front ends do not overlap the second electrode layers, each of the second electrode layers includes a second connection portion in the cell array region and a second front end and a second back end spaced apart from each other in the third direction in the connection region and positioned at the same level, the second front end and the second back end are connected to the second connection portion, the second back end has a second protrusion protruding toward the second front end, the second protrusions of the second front ends do not overlap the first electrode layers, and the cell contacts include first cell contacts passing through the first protrusions and second cell contacts passing through the second protrusions.

An electronic system according to some example embodiments of the present disclosure includes a semiconductor device comprising a peripheral circuit structure, a cell array structure thereon, and an input/output pad electrically connected to the peripheral circuit structure and a controller electrically connected to the semiconductor device through the input/output pad and configured to control the semiconductor device, the cell array structure includes a substrate including a cell array region and a connection region side by side in a first direction, and a stack structure including electrode layers and inter-electrode insulating layers alternately stacked in a second direction perpendicular to the substrate, the electrode layers including first electrode layers and second electrode layers alternately stacked, each of the first electrode layers includes a first connection portion in the cell array region and a first front end and a first back end spaced apart from each other in a third direction crossing the first and second directions in the connection region and positioned at the same level as each other, the first front end and the first back end are connected to the first connection portion, the first front end has a first protrusion protruding toward the first back end, and the first protrusions of the first front ends do not overlap the second electrode layers.

At least some of the above and other features of the invention are set out in the claims.

### BRIEF DESCRIPTION OF THE DRAWINGS

Example embodiments will be more clearly understood from the following brief description taken in conjunction with the accompanying drawings. The accompanying drawings represent non-limiting, example embodiments as described herein.
FIG. 1A is a diagram schematically illustrating an electronic system including a semiconductor device according to some example embodiments of the present disclosure.
FIG. 1B is a perspective view schematically illustrating an electronic system including a semiconductor device according to some example embodiments of the present disclosure.
FIGS. 1C and 1D are schematic cross-sectional views of semiconductor packages according to some example embodiments of the present disclosure.
FIG. 1E is a block diagram of a three-dimensional semiconductor memory device according to some example embodiments of the present disclosure.
FIG. 2 is a plan view of a three-dimensional semiconductor memory device according to some example embodiments of the present disclosure.
FIG. 3A is a cross-sectional view of FIG. 2 taken along line A-A' according to some example embodiments of the present disclosure.
FIG. 3B is a cross-sectional view of FIG. 2 taken along line B-B' according to some example embodiments of the present disclosure.
FIG. 3C is a cross-sectional view of FIG. 2 taken along line C-C' according to some example embodiments of the present disclosure.
FIG. 3D is a cross-sectional view of FIG. 2 taken along line D-D' according to some example embodiments of the present disclosure.
FIG. 4A illustrates a plan view of upper conductive lines according to some example embodiments of the present disclosure.
FIGS. 4B to 4G illustrate plan views of the electrode layers, respectively.
FIG. 5A is a partial perspective view of a three-dimensional semiconductor memory device having the plane of FIG. 2 according to some example embodiments of the present disclosure.
FIG. 5B is a partial perspective view of a three-dimensional semiconductor memory device according to some example embodiments of the present disclosure.
FIG. 6A is an enlarged view of portion 'P1' of FIG. 3B.
FIG. 6B is an enlarged view of portion 'P2' of FIG. 2.
FIG. 6C is an enlarged view of portion 'P3' of FIG. 3D.
FIG. 7 is an enlarged view of portion 'P4' of FIG. 3C according to some example embodiments of the present disclosure.
FIGS. 8A to 23A are plan views sequentially illustrating a manufacturing process of a three-dimensional semiconductor memory device having the plane of FIG. 2 according to some example embodiments of the present disclosure.
FIGS. 8B to 23B are cross-sectional views of FIGS. 8A to 23A taken along line A-A'.
FIGS. 8C, 9C, 11C to 16C, and 19C to 23C are cross-sectional views sequentially illustrating a process of manufacturing the three-dimensional semiconductor memory device of FIG. 3B.
FIGS. 11D and 18C are perspective views illustrating a process of manufacturing the three-dimensional semiconductor memory device of FIG. 5A.
FIGS. 19D and 19E are plan views illustrating a manufacturing process of the three-dimensional semiconductor memory device having the plane of FIG. 2.
FIG. 24 is a plan view of a three-dimensional semiconductor memory device according to some example embodiments of the present disclosure.
FIG. 25A is a cross-sectional view of FIG. 24 taken along line A-A'.
FIG. 25B is a cross-sectional view of FIG. 24 taken along line B-B'.
FIG. 26 is a partial perspective view of the three-dimensional semiconductor memory device having the plane of FIG. 24.
FIG. 27 is a plan view of a first electrode layer positioned at a lowermost level in a three-dimensional semiconductor memory device according to some example embodiments of the present disclosure.
FIG. 28 is a cross-sectional view of a semiconductor device according to some example embodiments of the present disclosure.

### DETAILED DESCRIPTION

Hereinafter, to explain the present disclosure in more detail, embodiments according to the present disclosure will be described in more detail with reference to the accompanying drawings.

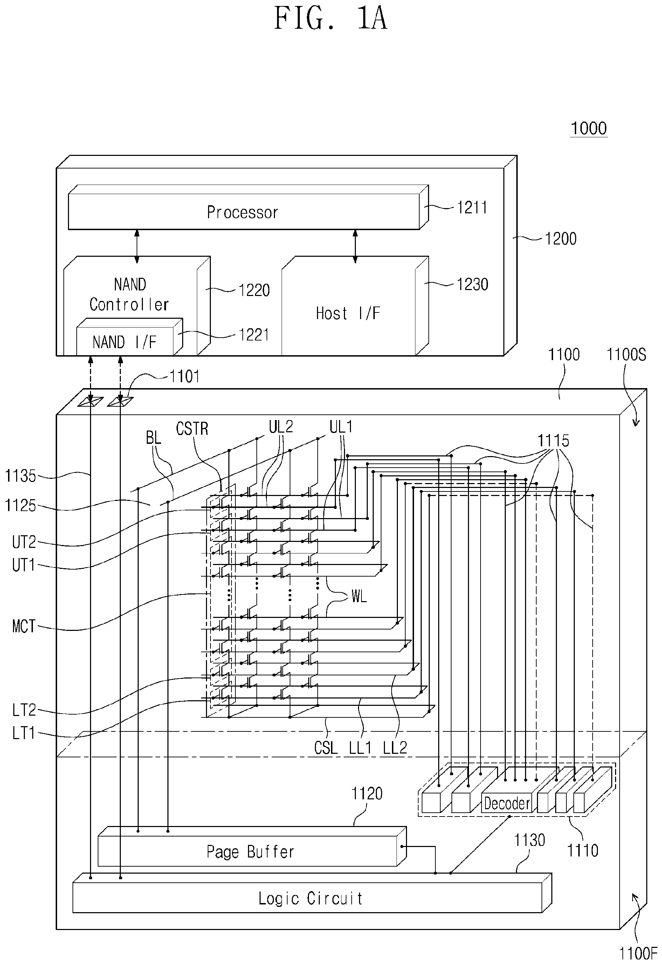

FIG. 1A is a diagram schematically illustrating an electronic system including a semiconductor device according to some example embodiments of the present disclosure.

Referring to FIG. 1A, an electronic system 1000 according to some example embodiments of inventive concepts may include a semiconductor device 1100 and a controller 1200, which are electrically connected to each other. The electronic system 1000 may be or may include a storage device including one or more semiconductor devices 1100 and/or an electronic device including the storage device. For example, the electronic system 1000 may be or may include at least one of a solid state drive (SSD) device, a universal serial bus (USB), a computing system, a medical system, or a communication system, in which at least one semiconductor device 1100 is provided.

The semiconductor device 1100 may be a nonvolatile memory device (e.g., a NAND FLASH memory device). The semiconductor device 1100 may include a first structure 1100F and a second structure 1100S on the first structure 1100F. As an example, the first structure 1100F may be disposed beside the second structure 1100S. The first structure 1100F may be a peripheral circuit structure including a decoder circuit 1110, a page buffer 1120, and a logic circuit 1130. The second structure 1100S may be a memory cell structure including a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of the lower transistors LT1 and LT2 and the number of the upper transistors UT1 and UT2 may be variously changed, according to some example embodiments.

In some example embodiments, at least one of the upper transistors UT1 and UT2 may include the string selection transistor, and at least one of the lower transistors LT1 and LT2 may include a ground selection transistor. The gate lower lines LL1 and LL2 may be used as gate electrodes of the lower transistors LT1 and LT2, respectively. The word lines WL may be used as gate electrodes of the memory cell transistors MCT, and the gate upper lines UL1 and UL2 may be used as gate electrodes of the upper transistors UT1 and UT2, respectively.

In some example embodiments, the lower transistors LT1 and LT2 may include a lower erase control transistor LT1 and a ground selection transistor LT2, which are connected in series. The upper transistors UT1 and UT2 may include a string selection transistor UT1 and an upper erase control transistor UT2, which are connected in series. At least one of the lower and upper erase control transistors LT1 and UT2 may be used for an erase operation of erasing data, which are stored in the memory cell transistors MCT, using a gate-induced drain leakage (GIDL) phenomenon.

The common source line CSL, the first and second gate lower lines LL1 and LL2, the word lines WL, and the first and second gate upper lines UL1 and UL2 may be electrically connected to the decoder circuit 1110 through first connection lines 1115, which are extended from a region in the first structure 1100F to a region in the second structure 1100S. The bit lines BL may be electrically connected to the page buffer 1120 through second connection lines 1125, which are extended from a region in the first structure 1100F to a region in the second structure 1100S.

In the first structure 1100F, the decoder circuit 1110 and the page buffer 1120 may be configured to control an operation, which is performed on at least one of the memory cell transistors MCT by a selection memory cell transistor. The decoder circuit 1110 and the page buffer 1120 may be controlled by the logic circuit 1130. The semiconductor device 1100 may communicate with the controller 1200 through an input/output pad 1101, which is electrically connected to the logic circuit 1130. The input/output pad 1101 may be electrically connected to the logic circuit 1130 through an input/output connection line 1135, which is provided in the first structure 1100F and is extended into the second structure 1100S.

The controller 1200 may include a processor 1211, a NAND controller 1220, and a host interface (I/F) 1230. In some example embodiments, the electronic system 1000 may include a plurality of semiconductor devices 1100, and in this case, the controller 1200 may control the semiconductor devices 1100.

The processor 1211 may control overall operations the electronic system 1000 including the controller 1200. The processor 1211 may be operated depending on a specific firmware and may control the NAND controller 1220 to access the semiconductor device 1100. The NAND controller 1220 may include a NAND interface (I/F) 1221 which is used for communication with the semiconductor device 1100. The NAND interface 1221 may be used to transmit and receive control commands, which are used to control the semiconductor device 1100, data, which will be written in or read from the memory cell transistors MCT of the semiconductor device 1100, and so forth. The host interface 1230 may be configured to allow for communication between the electronic system 1000 and an external host. When a control command is received from the external host through the host interface 1230, the processor 1211 may control the semiconductor device 1100 in response to the control command.

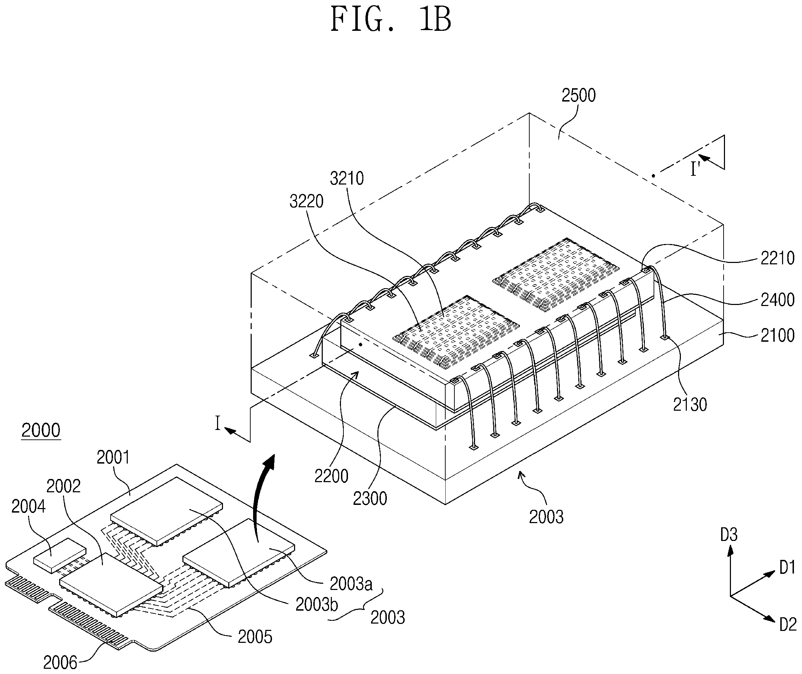

FIG. 1B is a perspective view schematically illustrating an electronic system including a semiconductor device according to some example embodiments of the present disclosure.

Referring to FIG. 1B, an electronic system 2000 according to some example embodiments of the inventive concepts may include a main substrate 2001 and a controller 2002, at least one semiconductor package 2003, and a dynamic random-access memory (DRAM) 2004, which are mounted on the main substrate 2001. The semiconductor package 2003 and the DRAM 2004 may be connected to the controller 2002 through interconnection patterns 2005, which are formed on or in the main substrate 2001.

The main substrate 2001 may include a connector 2006, which includes a plurality of pins coupled to an external host. In the connector 2006, the number and arrangement of the pins may depend on a communication interface between the electronic system 2000 and the external host. In some example embodiments, the electronic system 2000 may communicate with the external host, in accordance with an interface, such as universal serial bus (USB), peripheral component interconnect express (PCI-Express), serial advanced technology attachment (SATA), universal flash storage (UFS) M-PHY, or the like. In some example embodiments, the electronic system 2000 may be driven by electric power that is supplied from the external host through the connector 2006. The electronic system 2000 may further include a power management integrated circuit (PMIC) that is configured to separately supply electric power, which is provided from the external host, to the controller 2002 and the semiconductor package 2003.

The controller 2002 may be configured to control a writing or reading operation on the semiconductor package 2003 and to improve an operation speed of the electronic system 2000.

The DRAM 2004 may be a buffer memory, which relieves technical difficulties caused by a difference in speed between the semiconductor package 2003, which serves as a data storage device, and an external host. In some example embodiments, the DRAM 2004 in the electronic system 2000 may serve as a cache memory and may provide a storage space to temporarily store data during a control operation on the semiconductor package 2003. In the case where the electronic system 2000 includes the DRAM 2004, the controller 2002 may further include a DRAM controller to control the DRAM 2004, in addition to a NAND controller to control the semiconductor package 2003.

The semiconductor package 2003 may include first and second semiconductor packages 2003a and 2003b, which are spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, the semiconductor chips 2200 on the package substrate 2100, adhesive layers 2300 respectively disposed on bottom surfaces of the semiconductor chips 2200, a connection structure 2400 electrically connecting the semiconductor chips 2200 to the package substrate 2100, and a molding layer 2500 disposed on the package substrate 2100 on (e.g., to cover) the semiconductor chips 2200 and the connection structure 2400.

The package substrate 2100 may be a printed circuit board including package upper pads 2130. Each of the semiconductor chips 2200 may include an input/output pad 2210. The input/output pad 2210 may correspond to the input/output pad 1101 of FIG. 1A. Each of the semiconductor chips 2200 may include gate stacks 3210 and vertical structures 3220. Each of the semiconductor chips 2200 may include a semiconductor device, which will be described below, according to some example embodiments of the present disclosure.

In some example embodiments, the connection structure 2400 may be a bonding wire electrically connecting the input/output pad 2210 to the package upper pads 2130. In each of the first and second semiconductor packages 2003a and 2003b, the semiconductor chips 2200 may be electrically connected to each other in a bonding wire manner and may be electrically connected to the package upper pads 2130 of the package substrate 2100. In some example embodiments, the semiconductor chips 2200 in each of the first and second semiconductor packages 2003a and 2003b may be electrically connected to each other by a connection structure including through silicon vias (TSVs), not by the connection structure 2400 provided in the form of bonding wires.

In some example embodiments, the controller 2002 and the semiconductor chips 2200 may be included in a single package. In some example embodiments, the controller 2002 and the semiconductor chips 2200 may be mounted on a separate interposer substrate, which is prepared independently of the main substrate 2001, and may be connected to each other through interconnection lines, which are provided in the interposer substrate.

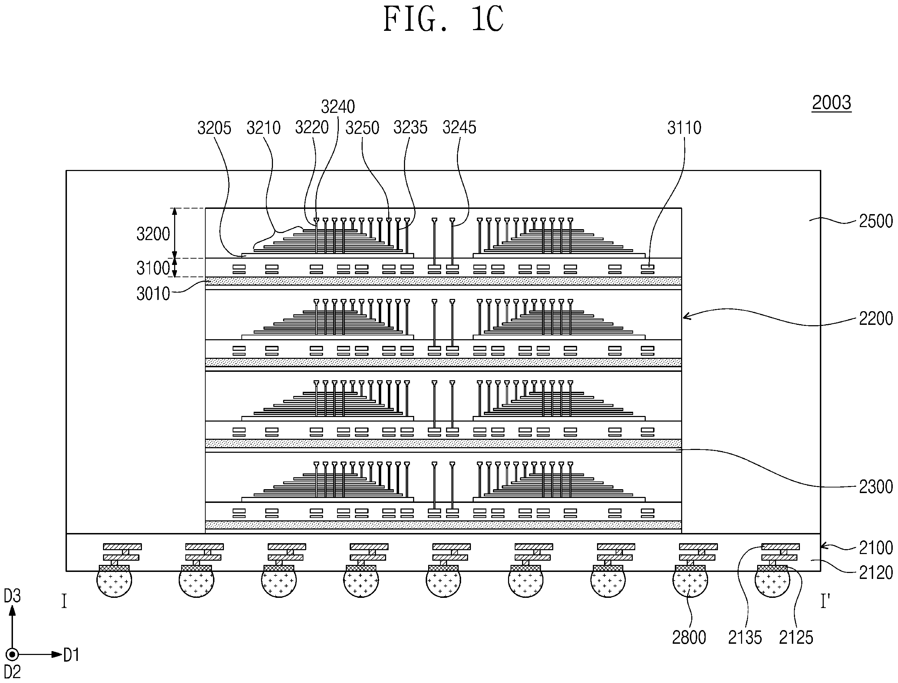

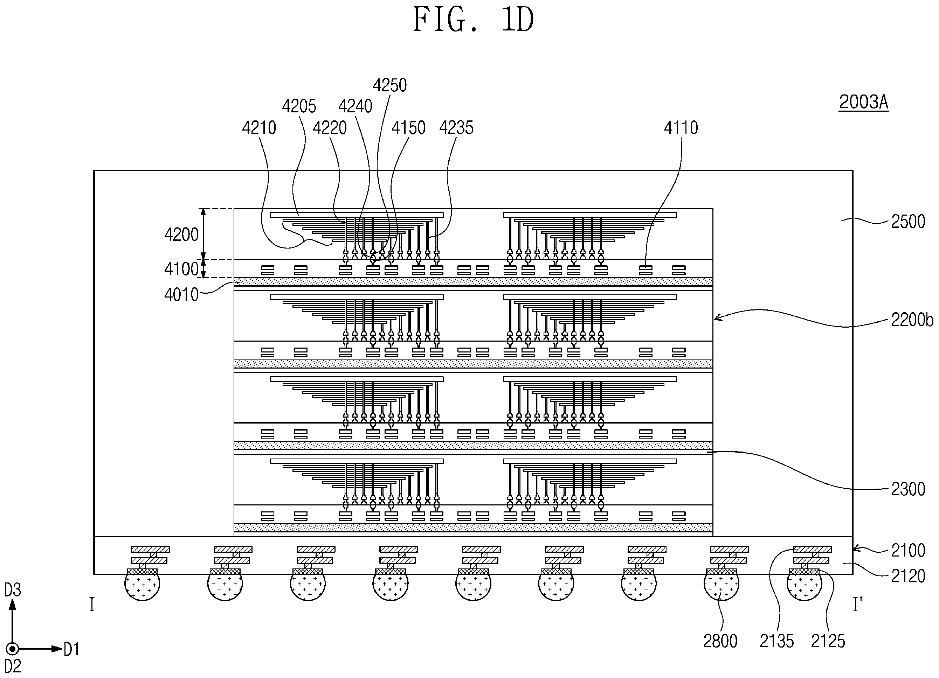

FIGS. 1C and 1D are schematic cross-sectional views of semiconductor packages according to some example embodiments of the present disclosure. FIGS. 1C and 1D conceptually illustrate two different examples of the semiconductor package of FIG. 1B and are, for example, sectional views taken along a line I-I' of FIG. 1B.

Referring to FIG. 1C in the semiconductor package 2003, the package substrate 2100 may be a printed circuit board. The package substrate 2100 may include a package substrate body portion 2120, the package upper pads 2130 (e.g., of FIG. 1B) disposed on a top surface of the package substrate body portion 2120, lower pads 2125, which are disposed on or exposed through a bottom surface of the package substrate body portion 2120, and internal lines 2135, which are provided in the package substrate body portion 2120 to electrically connect the package upper pads 2130 to the lower pads 2125. The upper pads 2130 may be electrically connected to the connection structures 2400. The lower pads 2125 may be connected to the interconnection patterns 2005 of the main substrate 2001 of the electronic system 2000 through conductive connecting portions 2800, as shown in FIG. 1B.

Each of the semiconductor chips 2200 may include a semiconductor substrate 3010 and first and second structures 3100 and 3200, which are sequentially stacked on the semiconductor substrate 3010. The first structure 3100 may include a peripheral circuit region, in which peripheral lines 3110 are provided. The second structure 3200 may include a source structure 3205, the stack 3210 on the source structure 3205, the vertical structures 3220 penetrating the stack 3210, bit lines 3240 electrically connected to the vertical structures 3220, and cell contact plugs 3235 electrically connected to the word lines WL (e.g., see FIG. 1A) of the stack 3210. The first structure 3100/second structure 3200/semiconductor chips 2200 may further include separation structures, which will be described in more detail below.

Each of the semiconductor chips 2200 may include through wirings 3245, which are electrically connected to the peripheral lines 3110 of the first structure 3100 and are extended into the second structure 3200. The through wiring 3245 may be disposed outside the stack 3210 or may be disposed to penetrate the stack 3210. Each of the semiconductor chips 2200 may further include the input/output pads 2210 (e.g., of FIG. 1B), which are electrically connected to the peripheral lines 3110 of the first structure 3100.

Referring to FIG. 1D, in the semiconductor package 2003A, each of the semiconductor chips 2200b may include a semiconductor substrate 4010, a first structure 4100 on the semiconductor substrate 4010, and a second structure 4200, which is provided on the first structure 4100 and is bonded with the first structure 4100 in a wafer bonding manner.

The first structure 4100 may include a peripheral circuit region, in which a peripheral line 4110 and first junction structures 4150 are provided. The second structure 4200 may include a source structure 4205, a stack 4210 between the source structure 4205 and the first structure 4100, vertical structures 4220 penetrating the stack 4210, and second junction structures 4240 electrically connected to the vertical structures 4220 and the word lines WL (e.g., see FIG. 1A) of the stack 4210. For example, the second junction structures 4240 may be electrically connected to the vertical structures 4220 and the word lines WL (e.g., see FIG. 1A) respectively through bit lines 4250, which are electrically connected to the vertical structures 4220, and cell contact plugs 4235, which are electrically connected to the word lines WL (e.g., see FIG. 1A). The first junction structures 4150 of the first structure 4100 and the second junction structures 4240 of the second structure 4200 may be in contact with each other and may be bonded to each other. Portions of the first and second junction structures 4150 and 4240, which are bonded to each other, may be formed of, for example, copper (Cu).

Each of the first structure 4100/ the second structure 4200/ the semiconductor chips 2200b may further include a source structure according to some example embodiments described below. Each of the semiconductor chips 2200b may further include an input/output pad (2210 in FIG. 1B) electrically connected to the peripheral lines 4110 of the first structure 4100.

The semiconductor chips 2200 of FIG. 1C and the semiconductor chips 2200b of FIG. 1D may be connected to each other by the connection structures 2400, which are provided in the form of bonding wires. However, in some example embodiments, semiconductor chips, which are provided in the same semiconductor package, may be electrically connected to each other by a connection structure including a through silicon via (TSV).

The first structure 3100 of FIG. 1C and the first structure 4100 of FIG. 1D may correspond to a peripheral circuit structure in some example embodiments to be described below, and the second structure 3200 of FIG. 1C and the second structure 4200 of FIG. 1D may correspond to a cell array structure in some example embodiments to be described below.

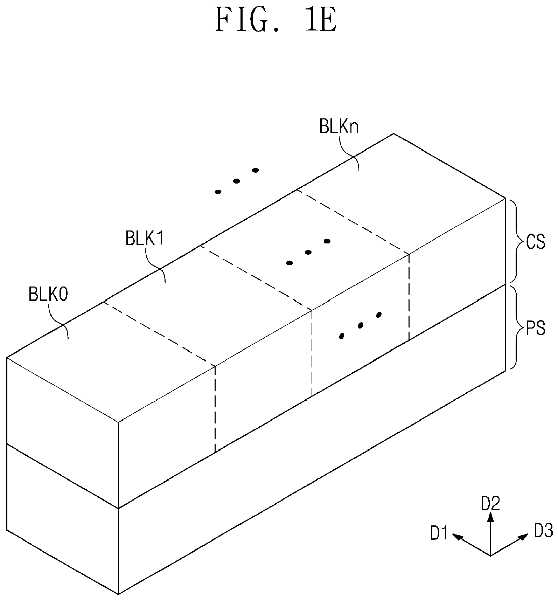

FIG. 1E is a block diagram of a three-dimensional semiconductor memory device according to some example embodiments of the present disclosure.

Referring to FIG. 1E, a three-dimensional semiconductor memory device according to some example embodiments may include a peripheral logic structure PS, a cell array structure CS on the peripheral logic structure PS, and a wiring structure connecting the cell array structure CS and the peripheral logic structure PS. The three-dimensional semiconductor memory device of FIG. 1E may correspond to the semiconductor device 1100 of FIG. 1A. The peripheral logic structure PS may correspond to the first structure 1100F of FIG. 1A and include row and column decoder circuits, a page buffer circuit, and control circuits. The cell array structure CS may correspond to the second structure 1100S of FIG. 1A and include a plurality of memory blocks BLK0, BLK1...BLKn that are a data erasing unit. The memory blocks BLK0, BLK1...BLKn may be arranged in a row in a third direction D3.

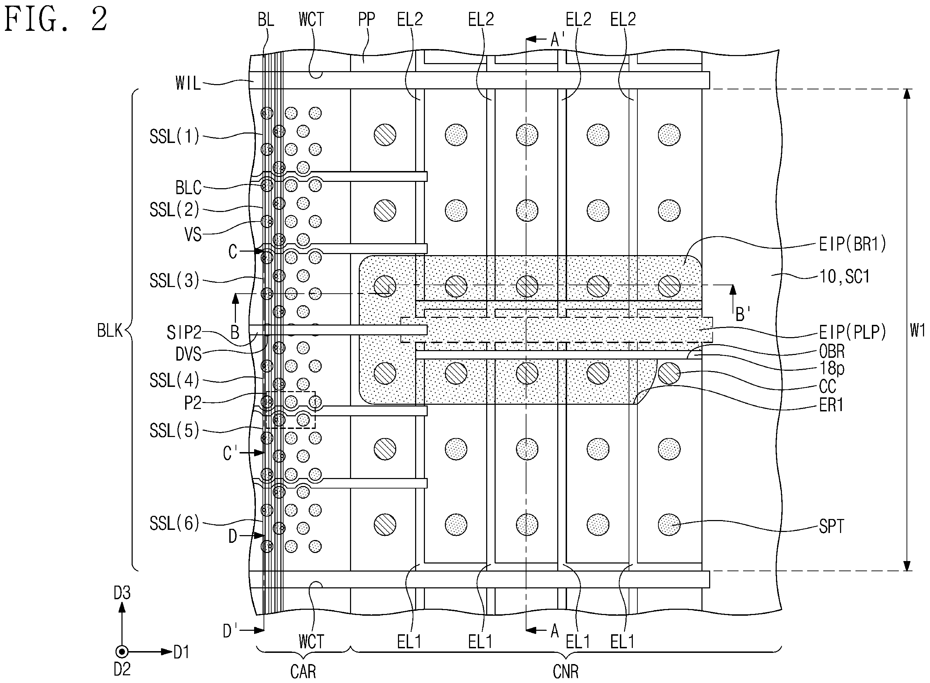

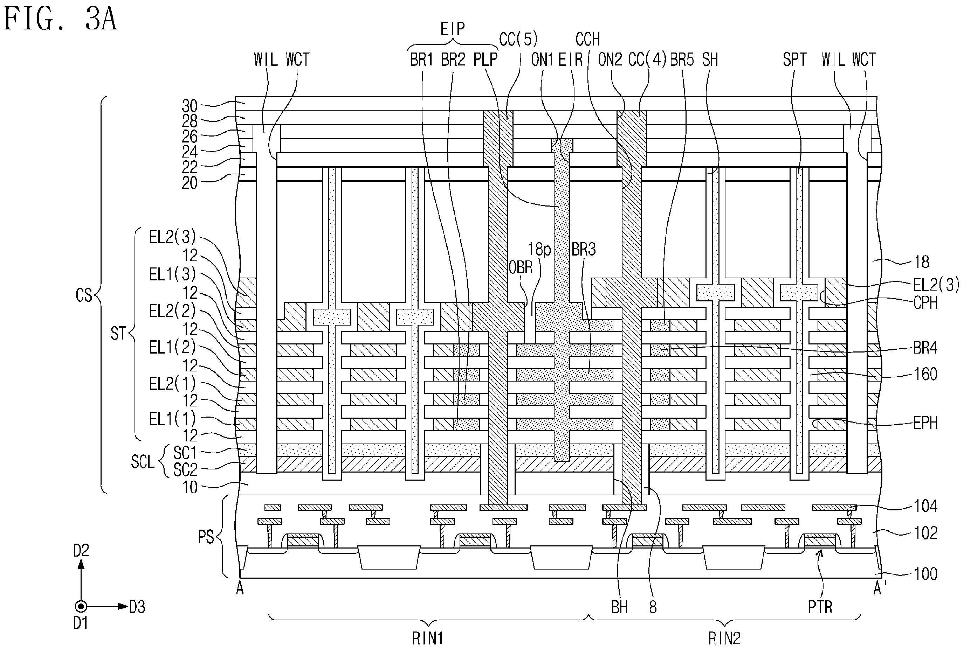

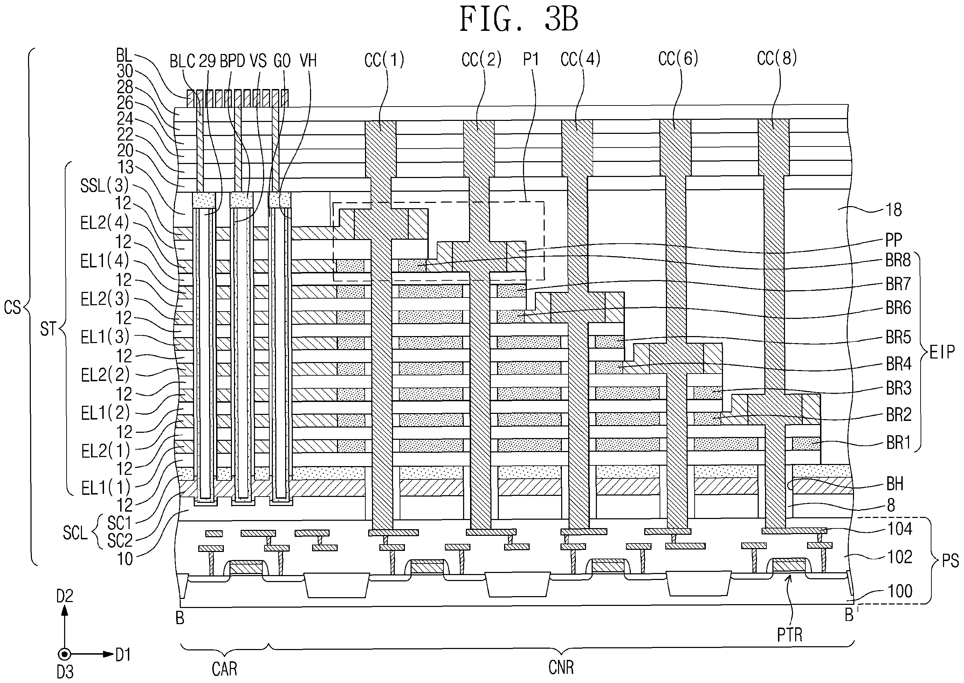

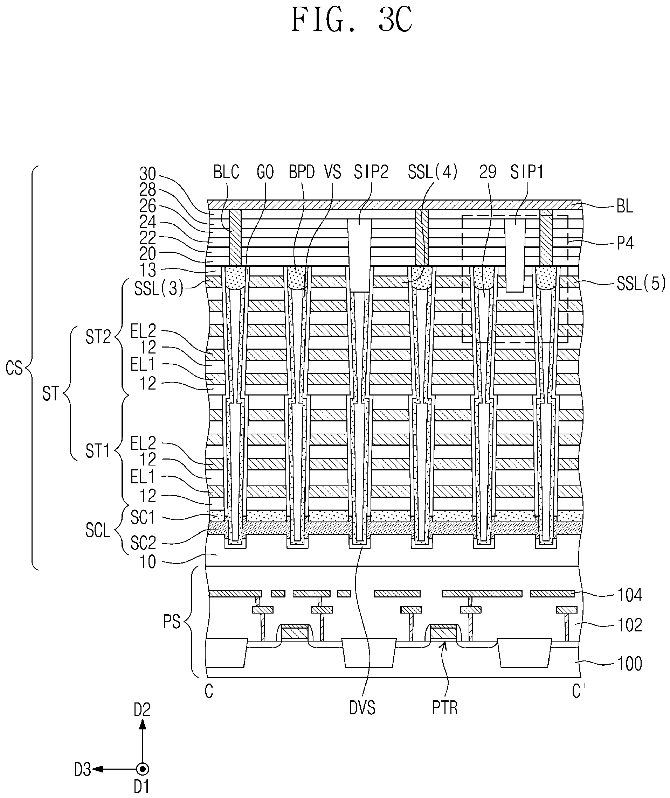

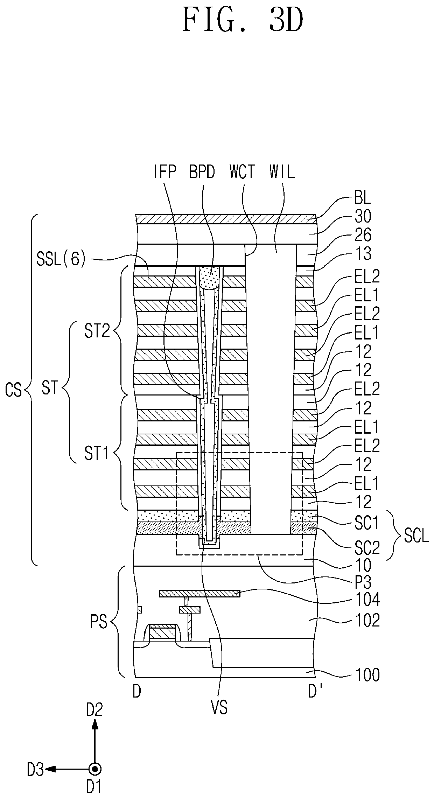

FIG. 2 is a plan view of a three-dimensional semiconductor memory device according to some example embodiments of the present disclosure. FIG. 3A is a cross-sectional view of FIG. 2 taken along line A-A' according to some example embodiments of the present disclosure. FIG. 3B is a cross-sectional view of FIG. 2 taken along line B-B' according to some example embodiments of the present disclosure. FIG. 3C is a cross-sectional view of FIG. 2 taken along line C-C' according to some example embodiments of the present disclosure. FIG. 3D is a cross-sectional view of FIG. 2 taken along line D-D' according to some example embodiments of the present disclosure.

Referring to FIGS. 2 and 3A to 3C, a three-dimensional semiconductor memory device of the present disclosure may be a vertical NAND flash memory device. A cell array structure CS is disposed on the peripheral circuit structure PS. The peripheral circuit structure PS includes the first substrate 100. The first substrate 100 may be a silicon single crystal substrate or a silicon on insulator (SOI) substrate. A device isolation layer may be disposed on the first substrate 100 to define active regions. Peripheral transistors PTR may be disposed on the active regions. Each of the peripheral transistors PTR may include a peripheral gate electrode, a peripheral gate insulating layer, and peripheral source/drain regions disposed in the first substrate 100 adjacent to both sides of the peripheral gate electrode. The peripheral transistors PTR may be covered with a peripheral interlayer insulating layer 102. The peripheral interlayer insulating layer 102 may have a single layer or multilayer structure of at least one of a silicon oxide layer, a silicon nitride layer, a silicon oxynitride layer, and a porous insulating layer. Peripheral wirings 104 may be disposed in the peripheral interlayer insulating layer 102. The peripheral wirings 104 may include a conductive layer.

Some of the peripheral wirings 104 may be electrically connected to the peripheral transistors PTR. The peripheral wirings 104 and the peripheral transistors PTR may configure the page buffer circuit 1120 and the decoder circuit 1110 of FIG. 1A.

The cell array structure CS includes a second substrate 10. The second substrate 10 may be, for example, a silicon single crystal layer, a silicon epitaxial layer, or an SOI substrate. The second substrate 10 may be doped with impurities of the first conductivity type, for example. The impurities of the first conductivity type may be, for example, P-type boron. Alternatively, the impurities of the first conductivity type may be N-type arsenic or phosphorus. The second substrate 10 may include a cell array region CAR and a connection region CNR that are arranged side by side in a first direction D1. The first direction D1 is parallel to an upper surface of the second substrate 10.

A source structure SCL is disposed on the second substrate 10. The source structure SCL may include a first source pattern SC1 interposed between an inter-electrode insulating layer 12 positioned at a lowermost layer and the second substrate 10, and a second source pattern SC2 interposed between the first source pattern SC1 and the second substrate 10. The first source pattern SC1 may include a semiconductor pattern doped with impurities, for example, polysilicon doped with impurities of the first conductivity type. The second source pattern SC2 may include a semiconductor pattern doped with impurities, for example, polysilicon doped with impurities. The second source pattern SC2 may further include a semiconductor material different from that of the first source pattern SC1. A conductivity type of impurities doped in the second source pattern SC2 may be the same as that of an impurity doped in the first source pattern SC1. A concentration of impurities doped in the second source pattern SC2 may be the same as or different from a concentration of impurities doped in the first source pattern SC1. The source structure SCL may correspond to the common source line CSL of FIG. 1A. In addition, the second substrate 10 may also function as the common source line CSL of FIG. 1A.

In the connection region CNR, substrate insulating patterns 8 may pass through the source structure SCL, the second substrate 10, and a portion of the peripheral interlayer insulating layer 102 to be in contact with some of the peripheral wirings 104. The substrate insulating pattern 8 may include, for example, a single layer or multilayer structure of at least one of silicon oxide, silicon nitride, and silicon oxynitride.

A stack structure ST is disposed on the source structure SCL. The stack structure ST includes electrode layers EL1 and EL2 alternately stacked along a second direction D2, inter-electrode insulating layers 12, upper conductive lines SSL, and uppermost inter-electrode insulating layer 13. The second direction D2 is perpendicular to the upper surface of the second substrate 10. The second direction D2 may be considered a vertical direction. As discussed herein, the terms "higher", "lower", "upper", "lower", etc. may be considered relative terms relating to relative position along the second direction D2. A higher position may be further along the second direction D2 (e.g. further from the upper surface of the second substrate 10) than a lower position. These terms relate to relative position within the semiconductor memory device and need not infer any particular orientation of the semiconductor memory device in use. The inter-electrode insulating layers 12 and an uppermost inter-electrode insulating layer 13 may include, for example, a silicon oxide layer as an insulating material. The electrode layers EL1 and EL2 and the upper conductive lines SSL may include a metal such as tungsten. The word line separation pattern WIL may pass through the stack structure ST and the source structure SCL to divide the stack structure ST into a plurality of memory blocks BLK units. One memory block BLK has a first width W1 in the third direction D3. The third direction D3 is parallel to the upper surface of the second substrate 10 and crosses the first direction D1.

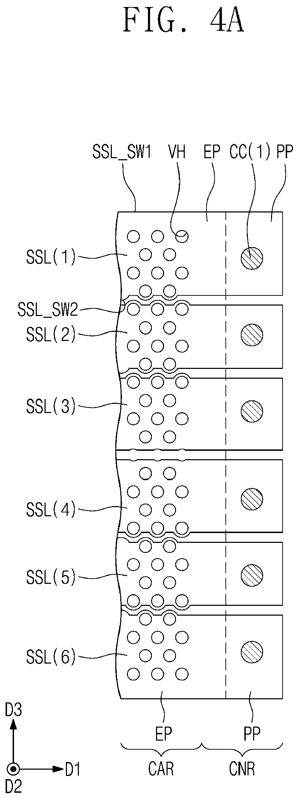

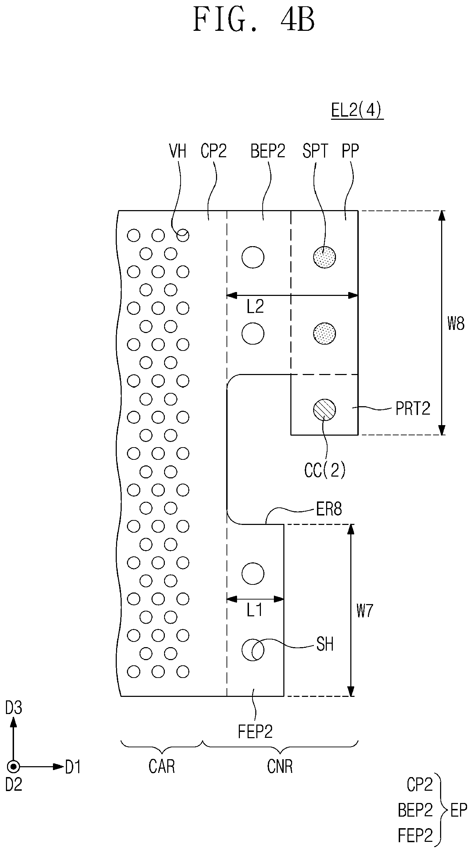

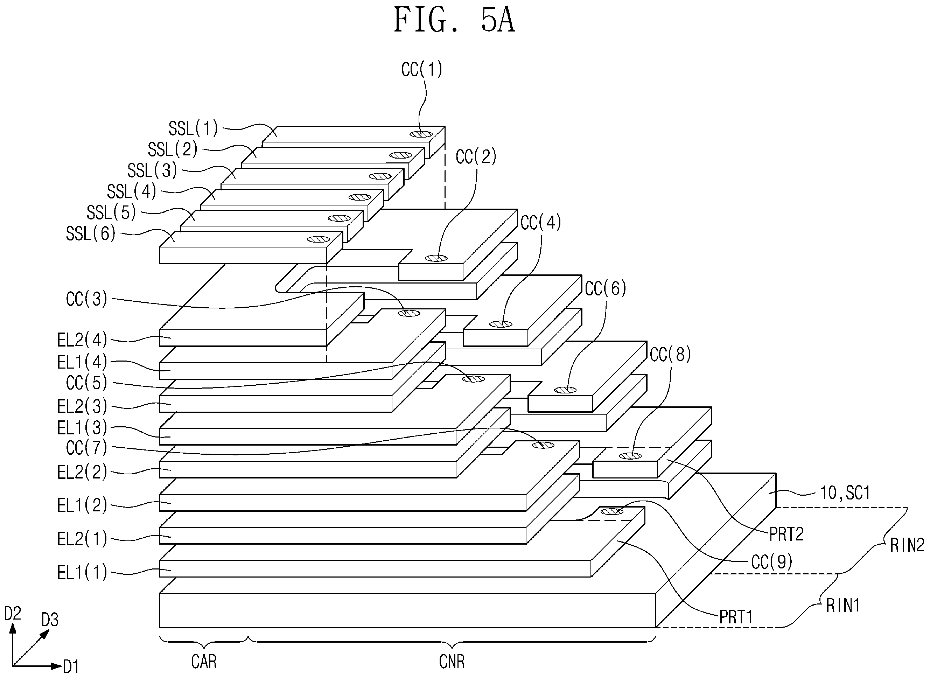

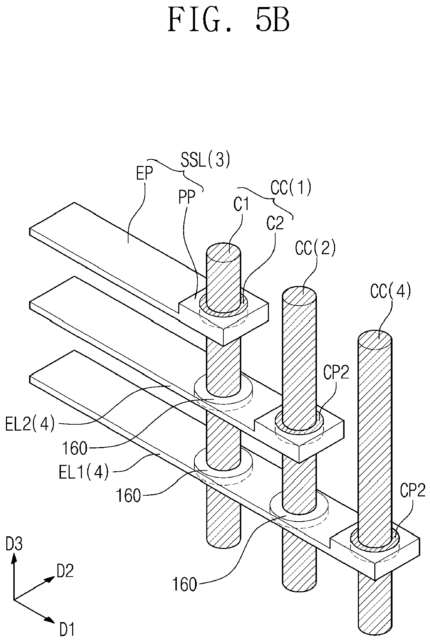

FIG. 4A illustrates a plan view of upper conductive lines according to some example embodiments of the present disclosure. FIGS. 4B to 4G illustrate plan views of the electrode layers, respectively. FIG. 5A is a partial perspective view of a three-dimensional semiconductor memory device having the plane of FIG. 2 according to some example embodiments of the present disclosure. FIG. 5B is a partial perspective view of a three-dimensional semiconductor memory device according to some example embodiments of the present disclosure.

Referring to FIGS. 2, 3B, 5A, and 5B, ends of the upper conductive lines SSL and the electrode layers EL in the connection region CNR may have a step form with each other. The electrode layers EL may include first electrode layers EL1 and second electrode layers EL2 alternately stacked. The first electrode layers EL1 may include (1-1)th to (1-4)th electrode layers EL1(1) to EL1(4) (otherwise known as first to fourth first electrode layers) sequentially stacked from bottom to top. The second electrode layers EL2 may include the (2-1)th to (2-4)th electrode layers EL2(1) to EL2(4) (otherwise known as first to fourth second electrode layers) sequentially stacked from bottom to top. Upper conductive lines SSL may be disposed on the (2-4)th electrode layer EL2(4) disposed on the uppermost layer. The upper conductive lines SSL may include first to sixth upper conductive lines SSL(1) to SSL(6). In the present disclosure, the numbering (n-m)th is used, wherein n and m are integers. This is used to represent items having multiple numerical labels. For instance, the (1-1)th electrode layer EL1(1) is the first first electrode layer (the first of the first electrode layers), the (1-2)th electrode layer EL1(2) is the second first electrode layer (the second of the first electrode layers), etc. Similarly, the (2-1)th electrode layer EL2(1) is the first second electrode layer (the first of the second electrode layers), the (2-2)th electrode layer EL2(2) is the second second electrode layer (the second of the second electrode layers), etc.

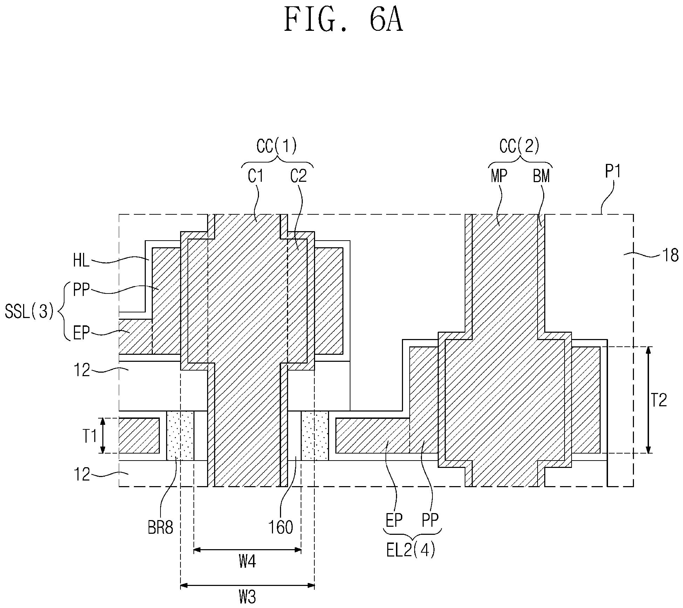

FIG. 6A is an enlarged view of portion 'P1' of FIG. 3B.

Referring to FIGS. 2, 3B, 4A, 5A, 5B, and 6A, each of the upper conductive lines SSL may have an electrode portion EP and a pad portion PP. Some of the upper conductive lines SSL may correspond to the first and second gate upper lines UL1 and UL2 of FIG. 1A. The electrode portion EP may overlap a portion of the cell array region CAR and the connection region CNR and may extend in the first direction D1. The electrode portion EP may have a first thickness T1 (e.g. in the second direction D2). The pad portion PP may correspond to ends of the upper conductive lines SSL, respectively. The pad portion PP may have a second thickness T2 (e.g. in the second direction D2) greater than the first thickness T1. In the cell array region CAR, vertical holes VH into which vertical patterns VS are inserted are formed in the upper conductive lines SSL. The pad portions PP of the upper conductive lines SSL may be in contact with the first cell contacts CC(1), respectively. Each of the upper conductive lines SSL may have a first side surface SSL_SW1 and a second side surface SSL_SW2 opposite to each other. The first side surfaces SSL_SW1 and the second side surfaces SSL_SW2 may extend in the first direction D1. The first side surface SSL_SW1 of the first upper conductive lines SSL(1) and the second side surface SSL_SW2 of the sixth upper conductive lines SSL(6) may have a straight line shape when viewed in a plan view. Side surfaces of the other upper conductive lines SSL may have a concavo-convex structure.

Among the electrode layers EL1 and EL2, lowermost ones EL1(1) and EL2(1) may correspond to the gate lower lines LL1 and LL2 of FIG. 1A. The remaining electrode layers EL1 and EL2 may correspond to word lines WL.

Referring to FIGS. 2, 3B, 4B to 4G, 5A, 5B, and 6A, each of the first electrode layers EL1 and the second electrode layers EL2 may include an electrode portion EP and a pad portion PP. The electrode portion EP may have a first thickness T1 (e.g. in the second direction D2). The pad portion PP may correspond to ends of the first electrode layers EL1 and the second electrode layers EL2, respectively. The pad portion PP may have a second thickness T2 (e.g. in the second direction D2) greater than the first thickness T1.

Each of the first electrode layers EL1 may have a first connection portion CP1, a first front end FEP1, a first back end BEP1, and a first protrusion portion PRT1. The first connection portion CP1 is disposed in the cell array region CAR and connects the first front end FEP1 and the first back end BEP1. The first front end FEP1 and the first back end BEP1 are separated from each other along the third direction D3. The first connection portion CP1 extends between the first front and FEP1 and the first back end BEP1. The first connection portion CP1, the first front end FEP1, the first back end BEP1, and the first protrusion portion PRT1 are positioned at the same level as each other (e.g. the same level along the second direction D2). Vertical holes VH into which the vertical patterns VS are inserted are formed in the first connection portion CP1. In some example embodiments, 25 vertical holes VH may be arranged in a row in a zigzag pattern in the first connection portion CP1 of one memory block BLK in the third direction D3.

The first connection portion CP1, a portion of the first front end FEP1, and the first back end BEP1 may have the first thickness T1 of FIG. 6A, and may correspond to the electrode portion EP of the first electrode layer EL1. An outermost portion (e.g. a portion furthest from the first connection portion CP1) of the first front end FEP1 may correspond to the pad portion PP. The outermost portion of the first front end FEP1 includes a first protrusion portion PRT1 protruding toward the first back end BEP1 (e.g. protruding parallel to the third direction D3). The first protrusion PRT1 may be a portion of the pad portion PP, and the first protrusion PRT1 may have the same thickness as the thickness of the pad portion PP (T2 in FIG. 6A). The first connection portion CP1 has a second width W2 in the third direction D3. The second width W2 is equal to the first width W1 in the third direction D3 of one memory block BLK.

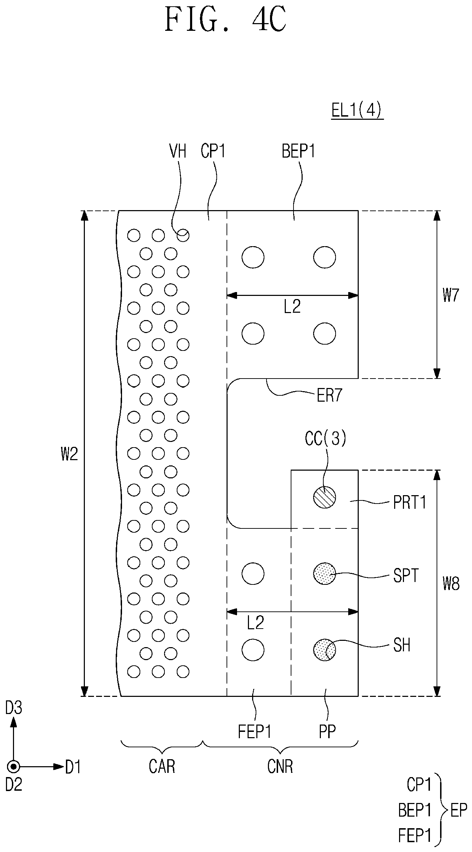

The second electrode layers EL2 may each have a second connection portion CP2, a second front end FEP2 and a second back end BEP2, and a second protrusion portion PRT2. The second connection portion CP2 is disposed in the cell array region CAR and connects the second front end FEP2 and the second back end BEP2. The second front end FEP2 and the second back end BEP2 are separated from each other along the third direction D3. The second connection portion CP2 extends between the second front and FEP2 and the second back end BEP2. The second connection portion CP2, the second front end FEP2, the second back end BEP2, and the second protrusion portion PRT2 are positioned on the same level as each other (e.g. the same level along the second direction D2). Vertical holes VH into which the vertical patterns VS are inserted are formed in the second connection portion CP2. The second connection portion CP2, the second front end FEP2, and a portion of the second back end BEP2 may have the first thickness T1 of FIG. 6A, and may correspond to the electrode portion EP of the second electrode layer EL2. An outermost portion of the second back end BEP2 (e.g. a portion furthest from the second connection portion CP2) may correspond to the pad portion PP. The outermost portion of the second back end BEP2 includes a second protrusion portion PRT2 protruding toward the second front end FEP2. The second protrusion PRT2 may be a portion of the pad portion PP, and the second protrusion PRT2 has the same thickness as the thickness of the pad portion PP (T2 in FIG. 6A). The second connection portion CP2 has the second width W2 of FIG. 4C in the third direction D3. The second width W2 is equal to the first width W1 in the third direction D3 of one memory block BLK.

Referring to FIGS. 4B and 4C, each of the outermost portion of the first front end FEP1 and the outermost portion of the second back end BEP2 may have an eighth width W8 in the third direction D3. Each of the outermost portion of the first back end BEP1 and the outermost portion of the second front end FEP2 may have a seventh width W7 in the third direction D3. The seventh width W7 is smaller than the eighth width W8.

The connection region CNR includes a first region RIN1 and a second region RIN2. The first region RIN1 and the second region RIN2 are positioned at different positions along the third direction D3. The first region RIN1 may be a stepped region having a level lower than that of the second region RIN2. The first protrusions PRT1 are disposed in the first region RIN1. The second protrusions PRT2 are disposed in the second region RIN2.

As the connection region CNR is closer to the second substrate 10, the first electrode layers EL1 and the second electrode layers EL2 may have longer lengths in the first direction D1. That is, the lengths of the first electrode layers EL1 and the second electrode layers EL2 may increase down the stack structure ST, approaching the second substrate 10. The first electrode layers EL1 and the second electrode layers EL2 towards the bottom of the stack structure ST (closer to the second substrate 10) are longer than the first electrode layers EL1 and the second electrode layers EL2 towards the top of the stack structure ST (further away from the second substrate 10). Within any given first electrode layer EL1 the lengths of the first front end FEP1 and the first back end BEP1 in the first direction D1 are equal to each other. Within any given second electrode layer EL2, the length of the second back end BEP2 in the first direction D1 is longer than the length of the second front end FEP2 in the first direction D1.

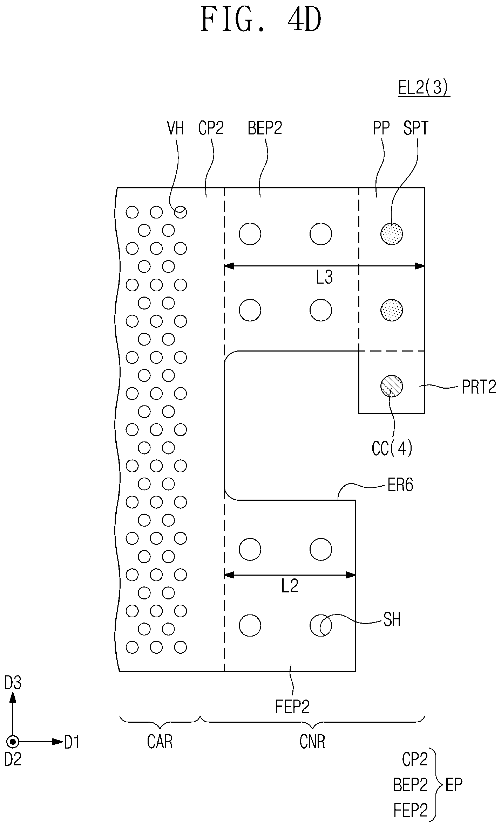

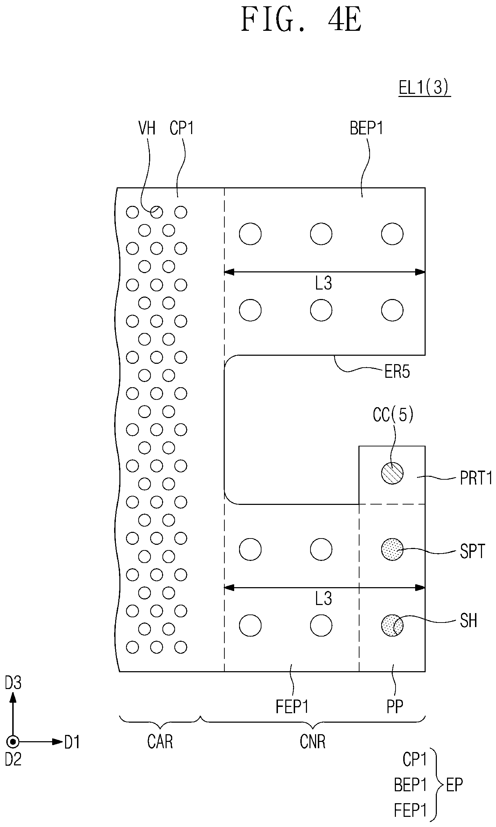

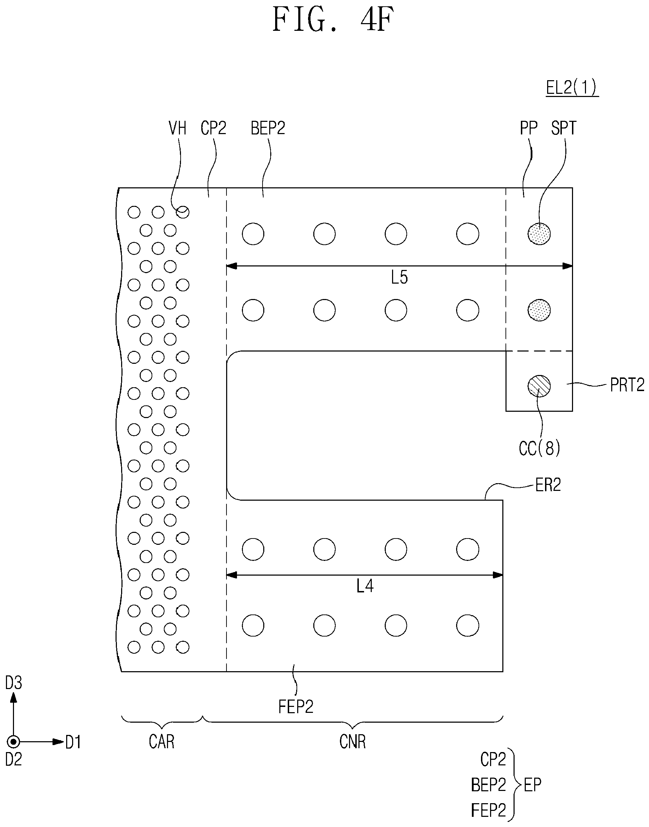

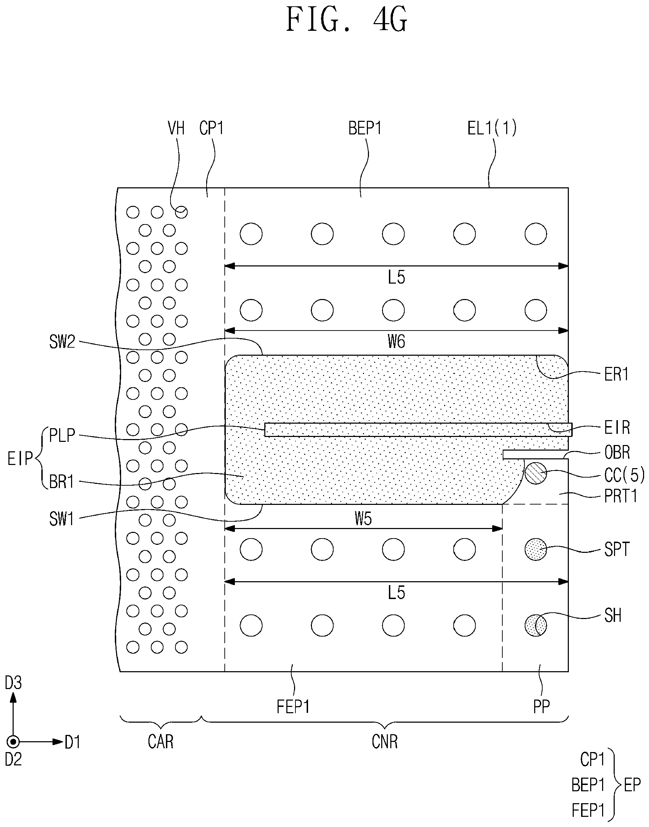

For example, in FIG. 4B, the second front end FEP2 of the (2-4)th electrode layer EL2(4) has a first length L1 in the first direction D1, and the second back end BEP2 has a second length L2 longer than the first length L1. In FIG. 4C, the first front end FEP1 and the first back end BEP1 of the (1-4)th electrode layer EL1(4) each have a second length L2 in the first direction D1. In FIG. 4D, the second front end FEP2 of the (2-3)th electrode layer EL2(3) has a third length L3 in the first direction D1, and the second back end BEP2 has a third length L3 longer than the second length L2. In FIG. 4E, the first front end FEP1 and the first back end BEP1 of the (1-3)th electrode layer EL1(3) each have a third length L3 in the first direction D1. In FIG. 4F, the second front end FEP2 of the (2-1)th electrode layer EL2(1) has a fourth length L4 in the first direction D1, and the second back end BEP2 has a fifth length L5 longer than the fourth length L4. In FIG. 4G, the first front end FEP1 and the first back end BEP1 of the (1-1)th electrode layer EL1(1) each have a fifth length L5 in the first direction D1.

In the (1-2)th to (1-4)th electrode layers EL1(2) to EL1(4), the sidewall of the first protrusion PRT1 meeting an inner wall of the first front end FEP1 may be perpendicular to the inner wall of the first front end FEP1 (e.g., as shown in FIG. 4E) when viewed in a plan view. In the (1-1)th electrode layer EL1(1), a sidewall of the first protrusion PRT1 meeting the inner wall of the first front end FEP1 may be rounded (as shown in FIG. 4G) when viewed in a plan view. In another example, the sidewall of the first protrusion PRT1 meeting the inner wall of the first front end FEP1 in the (1-2)th to (1-4)th electrode layers EL1(2) to EL1(4) may be rounded (as shown in FIG. 4G) when viewed in a plan view.

In the (2-1)th to (2-4)th electrode layers EL2(1) to EL2(4), a sidewall of the second protrusion PRT2 meeting an inner wall of the second back end BEP2 may be perpendicular to the inner wall of the second back end BEP2 (e.g., as shown in FIG. 4F) when viewed in a plan view. In another example, in the (2-1)th to (2-4)th electrode layers EL2(1) to EL2(4), the sidewall of the second protrusion PRT2 meeting the inner wall of the second back end BEP2 may be rounded when viewed in a plan view.

A length of at least one of the first protrusions PRT1 in the first direction D1 may be different from a length of at least one of the second protrusions PRT2 in the first direction D1. For example, the length of the first protrusion PRT1 of the (1-1)th electrode layer EL1(1) in the first direction D1 may be smaller than the length of the second protrusions PRT2 in the first direction D1.

Upper surfaces of the first front ends FEP1 are exposed without being covered by the second front ends FEP2. Upper surfaces of the second back ends BEP2 are exposed without being covered by the first back ends BEP1.

Support holes SH may be disposed in the first front end FEP1, the first back end BEP1, the second front end FEP2, and the second back end BEP2, respectively. The pad portion PP of the first front end FEP1 and the pad portion PP of the second back end BEP2 may be in contact with the support pattern SPT.

The first protrusion PRT1 of the first front end FEP1 and the second protrusion PRT2 of the second back end BEP2 may be in contact with the cell contact. For example, referring to FIGS. 4B to 5A, the second cell contact CC(2) is in contact with the second protrusion PRT2 of the (2-4)th electrode layer EL2(4). The third cell contact CC(3) is in contact with the first protrusion PRT1 of the (1-4)th electrode layer EL1(4). The fourth cell contact CC(4) is in contact with the second protrusion PRT2 of the (2-3)th electrode layer EL2(3). The fifth cell contact CC(5) is in contact with the first protrusion PRT1 of the (1-3)th electrode layer EL1(3). The sixth cell contact CC(6) is in contact with the second protrusion PRT2 of the (2-2)th electrode layer EL2(2). The seventh cell contact CC(7) is in contact with the first protrusion PRT1 of the (1-2)th electrode layer EL1(2). The eighth cell contact CC(8) is in contact with the second protrusion PRT2 of the (2-1)th electrode layer EL2(1). The ninth cell contact CC(9) is in contact with the first protrusion PRT1 of the (1-1)th electrode layer EL1(1). The second, fourth, sixth, and eighth cell contacts CC(2), CC(4), CC(6), and CC(8) may be arranged in a row in the first direction D1. The third, fifth, seventh, and ninth cell contacts CC(3), CC(5), CC(7), and CC(9) may be arranged in a row in the first direction D1. The second, fourth, sixth, and eighth cell contacts CC(2), CC(4), CC(6), and CC(8) are spaced apart from the third, fifth, seventh, and ninth cell contacts CC(3), CC(5), CC(7), and CC(9) in the third direction D3.

Each of the cell contacts CC may correspond to a portion of the first connection wirings 1115 of FIG. 1A. The cell contacts CC may connect the electrode layers EL to the decoder circuit (1110 of FIG. 1A) of the peripheral circuit structure PS.

As shown in FIG. 6A, in cross-section, the cell contacts CC may include a main contact portion MP and a diffusion barrier layer BM covering a surface thereof. The main contact portion MP may include, for example, a metal such as tungsten, copper, and/or aluminum. The diffusion barrier layer BM may include at least one of a titanium layer, a titanium nitride layer, a tantalum layer, and a tantalum nitride layer.

Referring to FIG. 5B, the cell contacts CC may include a contact pillar portion C1 extending from the upper surface of the second substrate 10 in a vertical direction (second direction D2) and a contact disk portion C2 protruding laterally from a side surface of the contact pillar portion C 1. The contact pillar portion C 1 may have a circular shape when viewed in a plan view. The contact disk portion C2 may have a donut (or toroidal) shape when viewed in a plan view. Each of the contact disk portions C2 of the cell contacts CC may have a third width W3.

The contact pillar portions C1 of the cell contacts CC may pass through the electrode portions EP of the other electrode layers EL1 and EL2 disposed under the pad portions PP, but may be insulated from the other electrode layers EL1 and EL2 by the contact insulation pattern 160 and branch portions BR1 to BR8 of the end insulation pattern EIP.

In some example embodiments, for example, referring to FIG. 6A, the contact disk portion C2 of the first cell contact CC(1) may be in contact with the pad portion PP of the third upper conductive line SSL(3). The contact disk portion C2 of the second cell contact CC(2) may be in contact with the pad portion PP (the second protrusion portion PRT2) of the (2-4)th electrode layer EL2(4). The contact pillar portion C1 of the first cell contact CC(1) may pass through the electrode portion EP of the (2-4)th electrode layer EL2(4) under the third upper conductive line SSL(3). The contact insulating pattern 160 and the eighth branch BR8 of the end insulating pattern EIP may be interposed between the contact pillar portion C1 of the third cell contact CC(3) and the electrode portion EP of the second electrode layer EL(2).

The pillar portions C1 of the cell contacts CC may be connected to peripheral circuit wirings 104 by penetrating portions of the inter-electrode insulating layers 12, the substrate insulating pattern 8, and the peripheral interlayer insulating layer 102. Each of the contact insulating patterns 160 and the end insulating pattern EIP may independently have a single-layer or multi-layer structure of at least one of silicon oxide, silicon nitride, and silicon oxynitride, for example. When viewed in a plan view, each of the contact insulating patterns 160 may have a donut shape (e.g. a toroidal shape). Each of the contact insulation patterns 160 may have a fourth width W4 different from the third width W3. The fourth width W4 may be smaller or greater than the third width W3. A lower end of the end insulating pattern EIP may be higher than a lower end of the word line separation pattern WIL. The word line separation pattern WIL may pass through the source structure SCL.

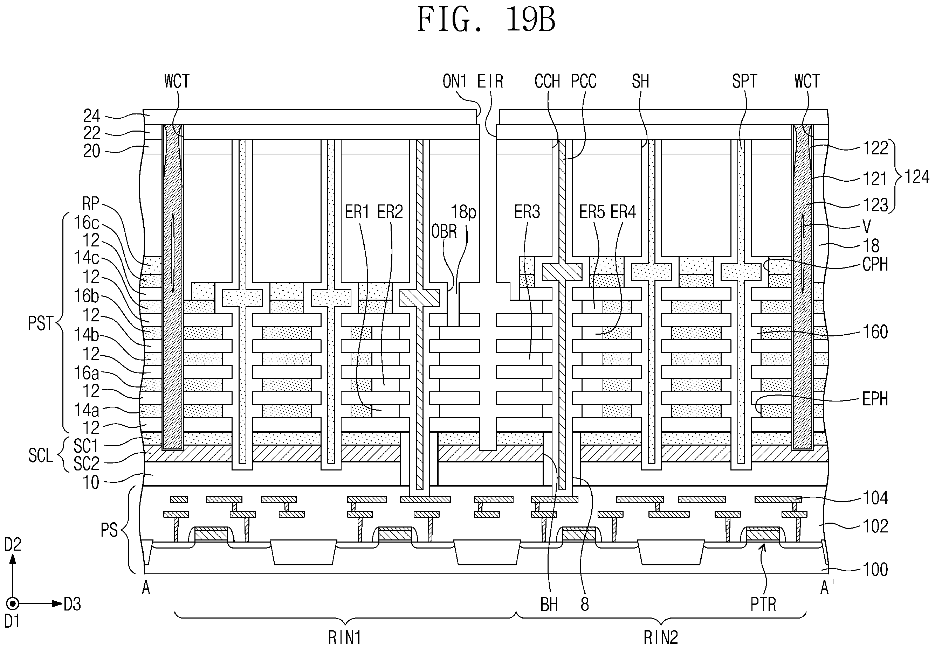

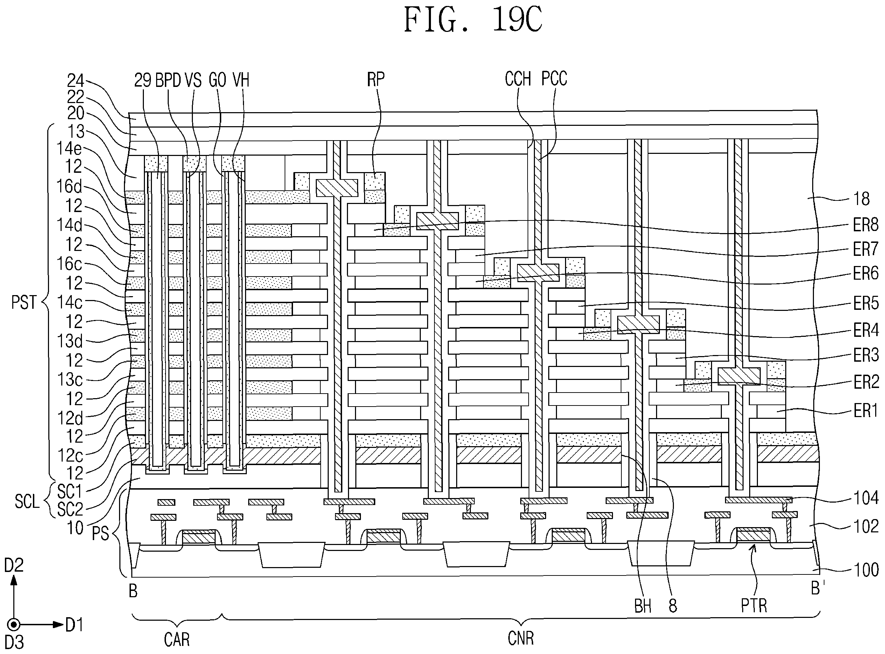

Referring to FIGS. 2, 3A, 3B, and 4B to 4G, the end insulating pattern EIP includes a pillar portion PLP extending in a second direction D2 perpendicular to the upper surface of the second substrate 10 and branch portions BR1 to BR8 extending laterally from the side thereof. The branch portions BR1 to BR8 may include first to eighth branch portions BR1 to BR8 sequentially disposed from bottom to top. The first, third, fifth, and seventh branch portions BR1, BR3, BR5, and BR7 may be interposed in spaces (ER1, ER3, ER5, and ER7 in FIG. 19C) between the first front ends FEP1 and the first back ends BEP1 of the first electrode layers EL1, respectively. The second, fourth, sixth, and eighth branch portions BR2, BR4, BR6, and BR8 may be interposed in spaces (ER2, ER4, ER6, and ER8 in FIG. 19C) between the second front ends FEP2 and the second back ends BEP2 of the second electrode layers EL2, respectively. The widths of the branch portions BR1 to BR8 in the first direction D1 may increase as they are closer to the second substrate 10 (e.g. increase down the stack structure ST). Referring to FIG. 4G, the first branch BR1 includes a first sidewall SW1 in contact with the first front end FEP1 of the (1-1)th electrode layer EL1(1) and a second sidewall SW2 in contact with the first back end BEP1 of the (1-1)the electrode layer EL1(1). The first sidewall SW1 has a fifth width W5 in the first direction D1. The second sidewall SW2 has a sixth width W6 greater than the fifth width W5 in the first direction D1.

An end of the stack structure ST may be covered with a flat insulating layer 18. The flat insulating layer 18 may include, for example, silicon oxide as an insulating material. First to sixth upper insulating layers 20, 22, 24, 26, 28, and 30 may be sequentially stacked on the flat insulating layer 18 and the uppermost inter-electrode insulating layer 13. Each of the first to sixth upper insulating layers 20, 22, 24, 26, 28, and 30 may include an insulating material. Each of the first to sixth upper insulating layers 20, 22, 24, 26, 28, and 30 may have a single layer or multilayer structure of, for example, at least one of silicon oxide, silicon nitride, and silicon oxynitride.

Referring to FIGS. 3A to 3D, a plurality of cell vertical patterns VS penetrates the stack structure ST and the source structure SCL in the cell array region CAR. Dummy vertical patterns DVS may be disposed between the cell vertical patterns VS at a center of the memory block BLK. The dummy vertical patterns DVS may be arranged in a line in the first direction D1.

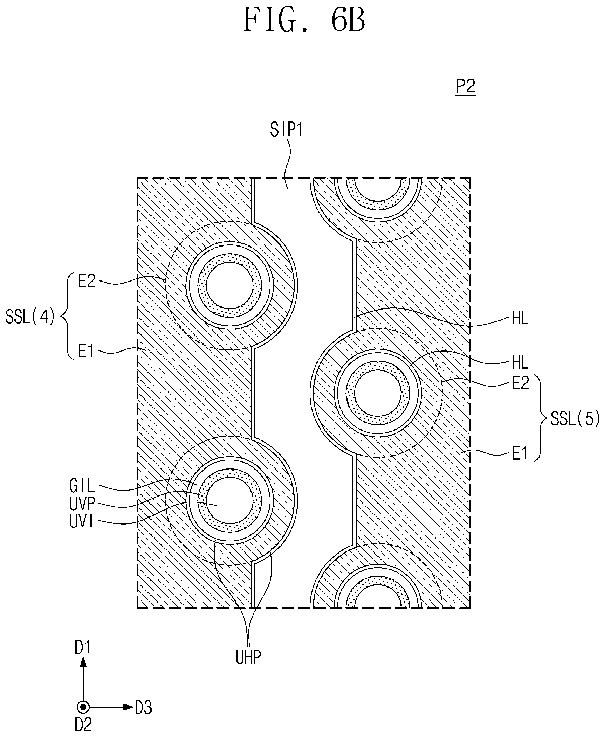

FIG. 6B is an enlarged view of portion 'P2' of FIG. 2.

Referring to FIGS. 2, 3C, 4A, and 6B, upper separation patterns SIP1 and SIP2 are disposed between the upper conductive lines SSL. The upper separation patterns SIP1 and SIP2 include first and second upper separation patterns SIP1 and SIP2. The first upper separation pattern SIP1 is interposed between the first to third upper conductive lines SSL1, SSL2, and SSL3 and between the fourth to sixth upper conductive lines SSL4, SSL5, and SSL6. As shown in FIG. 6B, the first upper separation pattern SIP may be disposed between the cell vertical patterns VS and may have a zigzag shape in a plan view. The second upper separation pattern SIP2 may be interposed between the third and fourth upper conductive lines SSL3 and SSL4. The second upper separation pattern SIP2 may have a straight line shape when viewed in a plan view. The second upper separation pattern SIP2 may pass through upper portions of the dummy vertical patterns DVS. The second upper separation pattern SIP2 does not pass through the stack structure ST and the source structure SCL.

The upper separation patterns SIP1 and SIP2 may further penetrate at least one of the first to sixth upper insulating layers 20, 22, 24, 26, 28, and 30. The word line separation pattern WIL may additionally penetrate at least one of the first to sixth upper insulating layers 20, 22, 24, 26, 28, and 30.

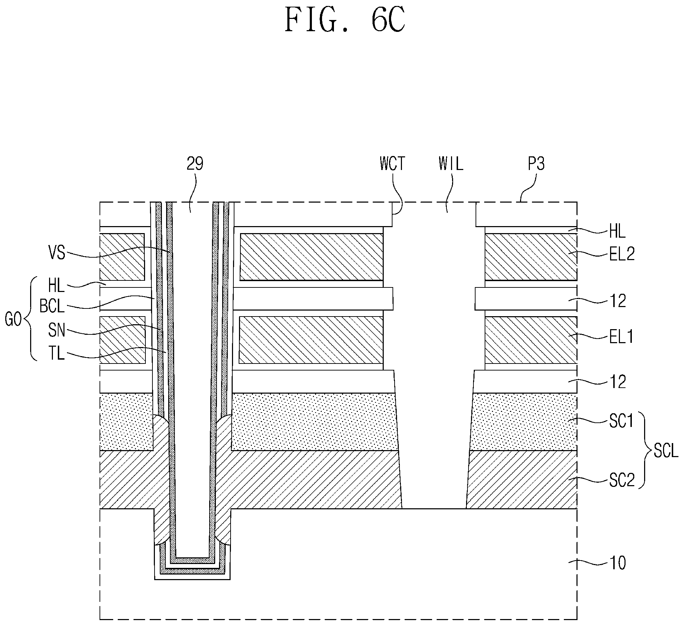

FIG. 6C is an enlarged view of portion 'P3' of FIG. 3D.

Referring to FIGS. 3C, 3D, and 6C, the vertical patterns VS and DVS may include a silicon single crystal layer doped or undoped with impurities, or a polysilicon layer (or polysilicon layer or the like). Each of the vertical patterns VS and DVS may have a hollow shell shape. An inside of the vertical patterns VS and DVS may be filled with a buried insulating pattern 29. The buried insulating pattern 29 may have, for example, a single layer structure or a multilayer structure of at least one of a silicon oxide layer, a silicon nitride layer, and a silicon oxynitride layer. A bit line pad BPD may be disposed on each of the vertical patterns VS and DVS. The bit line pad BPD may include polysilicon doped with impurities or a metal such as tungsten, aluminum, copper, or the like.

The gate insulating layer GO may be interposed between the vertical patterns VS and DVS and the stack structure ST. The second source pattern SC2 may pass through the gate insulating layer GO and be in contact with lower side surfaces of the vertical patterns VS and DVS, respectively.

Referring to FIG. 6C, the gate insulating layer GO may include a tunnel insulating layer TL, a charge storage layer SN, and a blocking insulating layer BCL. The charge storage layer SN may be a trap insulating layer, a floating gate electrode, or an insulating layer including conductive nano dots. For example, the charge storage layer SN may include at least one of a silicon nitride layer, a silicon oxynitride layer, a silicon-rich nitride layer, nanocrystalline Si, and a laminated trap layer. The tunnel insulating layer TL may be one of materials having a larger band gap than the charge storage layer SN, and the blocking insulating layer BCL may be a high dielectric layer such as an aluminum oxide layer or a hafnium oxide layer.

The gate insulating layer GO may further include a high dielectric layer HL. The high dielectric layer HL may be interposed between the blocking insulating layer BCL and the electrode layers EL. The high dielectric layer HL may be interposed between the electrode layers EL and the inter-electrode insulating layers 12. The high dielectric layer HL is a layer having a higher dielectric constant than that of a silicon oxide layer and may include, for example, a metal oxide layer such as a hafnium oxide layer or an aluminum oxide layer. The gate insulating layer GO may be separated into two portions by the second source pattern SC2. A portion of the word line separation pattern WIL may protrude toward the electrode layers EL1 and EL2 in the third direction D3 and may be interposed between adjacent inter-electrode insulating layers 12. A side surface of the word line separation pattern WIL may have a concavo-convex structure. The high dielectric layer HL may cover side surfaces of the contact insulating patterns 160. The high dielectric layer HL may be in contact with the diffusion barrier layer BM in the contact disk portions C2 of the cell contacts CC.

The bit line contact BLC may pass through the first to sixth upper insulating layers 20, 22, 24, 26, 28, and 30 and be in contact with the bit line pad BPD. Bit lines BL extending in the third direction D3 and parallel to each other are disposed on the sixth upper insulating layer 30. Each of the bit lines BL may be in contact with corresponding bit line contacts BLC.

In some example embodiments, referring to FIGS. 3C and 3D, the stack structure ST may include a first sub-stack structure ST1 and a second sub-stack structure ST2 sequentially stacked. The first sub-stack structure ST1 and the second sub-stack structure ST2 may each include first and second electrode layers EL1 and EL2 that are alternately stacked. The second sub-stack structure ST2 may include upper conductive lines SSL disposed on an uppermost portion. The vertical patterns VS and DVS may have an inflection point IFP adjacent to an interface between the first sub-stack structure ST1 and the second sub-stack structure ST2.

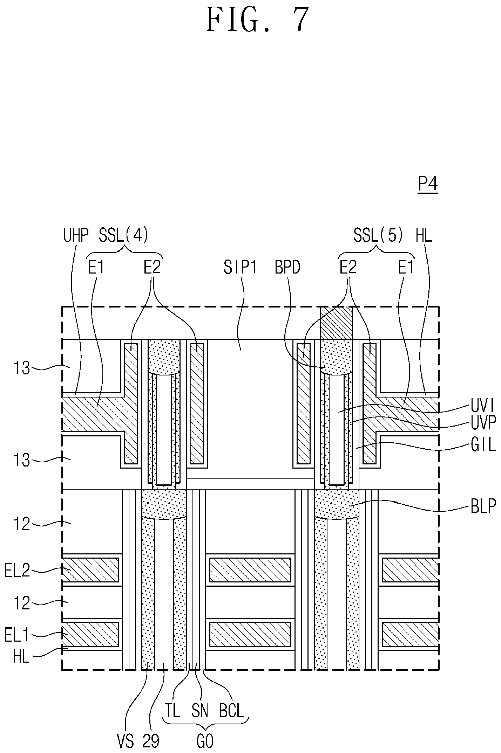

FIG. 7 is an enlarged view of portion 'P4' of FIG. 3C according to some example embodiments of the present disclosure. An upper plan view of FIG. 7 may correspond to FIG. 6B.

Referring to FIGS. 6B and 7, a preliminary pad BLP and an upper vertical pattern UVP may be disposed between the cell vertical patterns VS and the bit line pad BPD. The preliminary pad BLP and the upper vertical pattern UVP may each include a semiconductor material doped or undoped with impurities. The preliminary pad BLP and the upper vertical pattern UVP are in contact with each other. The upper vertical pattern UVP may have a hollow cup shape. The upper vertical pattern UVP may be filled with the upper buried insulating pattern UVI. An upper gate insulating layer GIL may be interposed between the upper vertical pattern UVP and the upper conductive lines SSL. The upper gate insulating layer GIL may have a structure of at least one single layer or multilayer selected from silicon oxide and silicon nitride.

As shown in FIGS. 6B and 7, each of the upper conductive lines SSL may include a line portion E1 extending in the first direction D1 and an electrode portion E2 connected to the line portion E1 and surrounding sidewalls of the upper vertical pattern UVP. The high dielectric layer HL may surround a side surface of the upper gate insulating layer GIL. The high dielectric layer HL may be in contact with a side surface of the first upper separation pattern SIP.

In the three-dimensional semiconductor memory device according to some example embodiments of the present disclosure, the electrode layers EL1 and EL2 in the connection region CNR form a stepped shape, respectively, have protrusions PRT1 and PRT2 that are alternately arranged back and forth, and are in contact with the contact disk portions C2 of the cell contacts CC. In addition, the pillar portions C1 of the cell contacts CC may be insulated from the other electrode layers EL1 and EL2 positioned under the protruding portions PRT1 and PRT2 through the contact insulation pattern 160 and the end insulation pattern EIP. Accordingly, a short circuit between the cell contacts CC and the electrode layers EL1 and EL2 may be prevented or the chance thereof reduced, signal interference between the electrode layers EL1 and EL2 may be minimized or reduced, and breakdown voltage drop may be prevented or the chance thereof reduced. Therefore, operation errors of the three-dimensional semiconductor memory device may be prevented or reduced, and reliability thereof may be improved.

In addition, in the present disclosure, one memory block BLK has six upper conductive lines SSL, and thus memory storage capacity may be increased. Also, the first upper separation pattern SIP2 has a zigzag shape and does not penetrate the dummy vertical pattern DVS. Accordingly, the number of dummy vertical patterns DVS arranged in one memory block BLK may be reduced, and thus the size of the memory block BLK may be reduced. Therefore, a highly integrated three-dimensional semiconductor memory device may be provided.

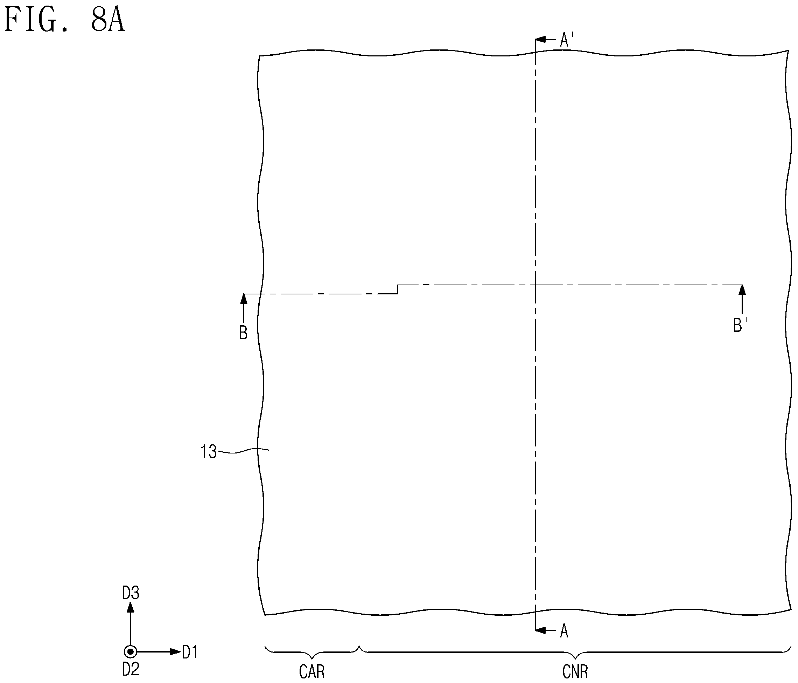

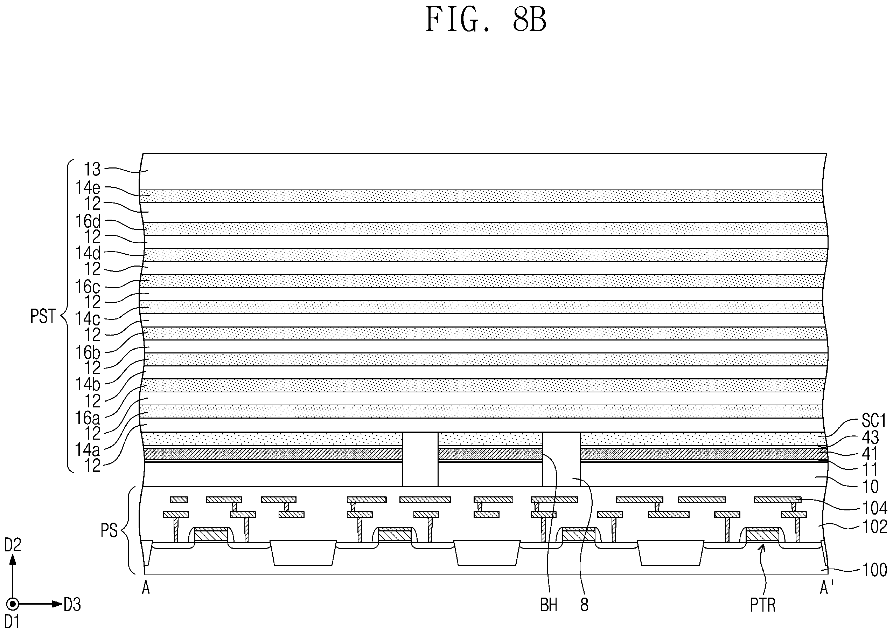

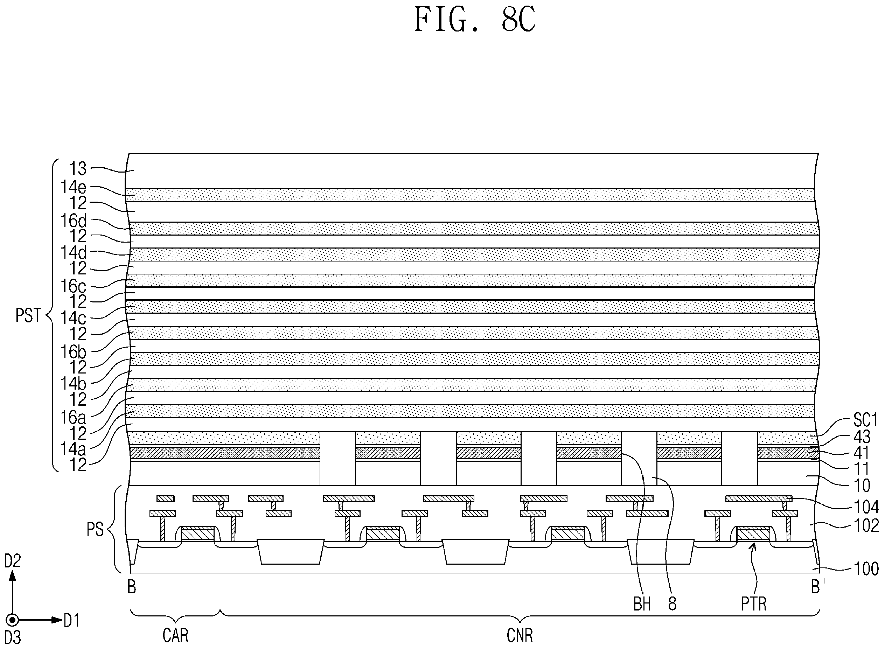

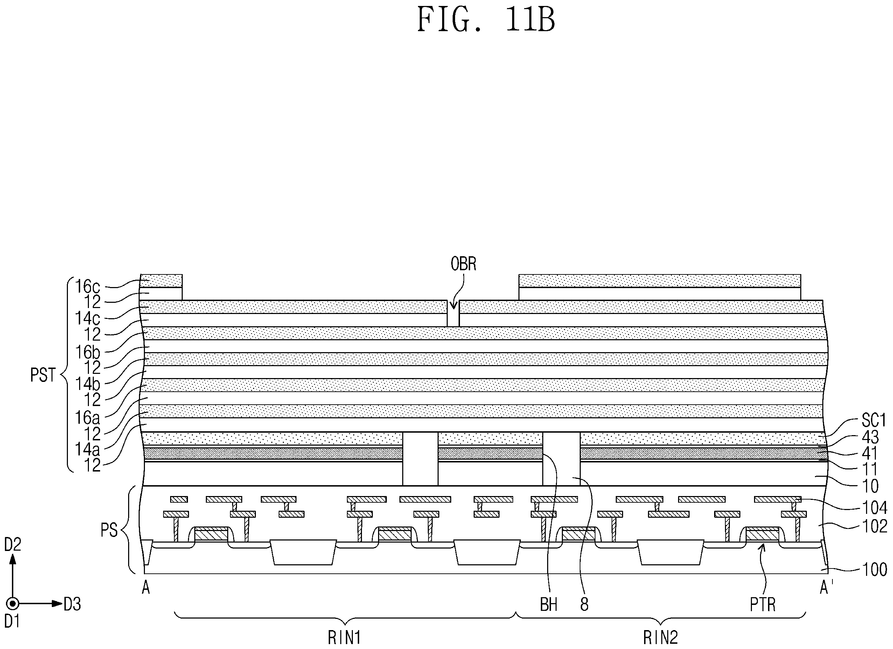

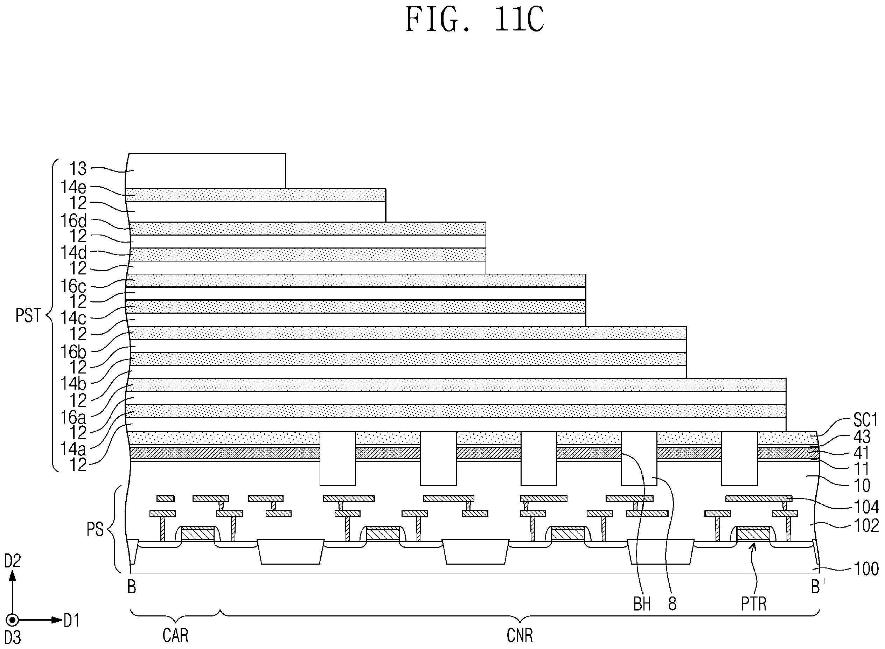

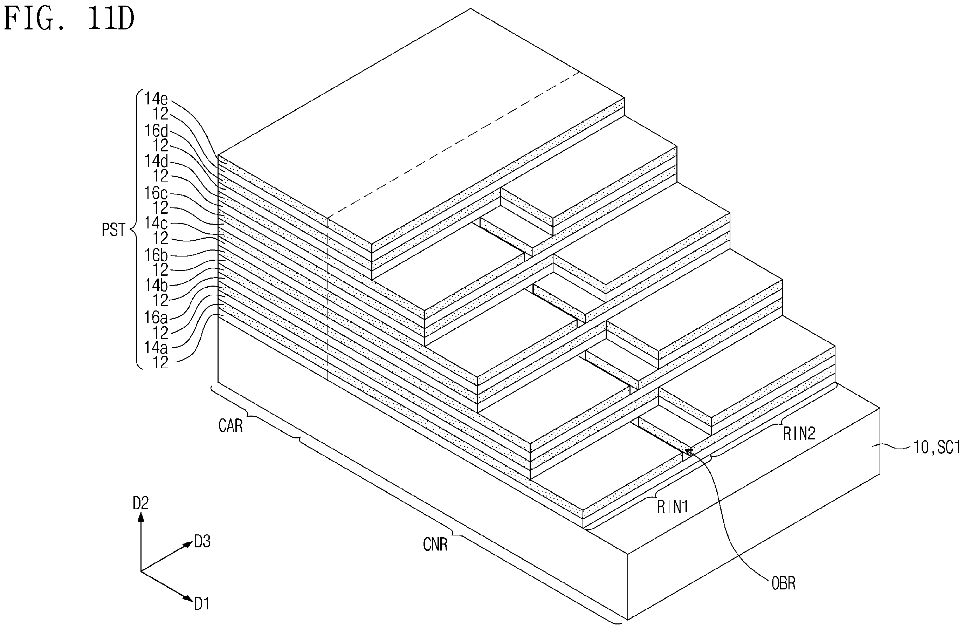

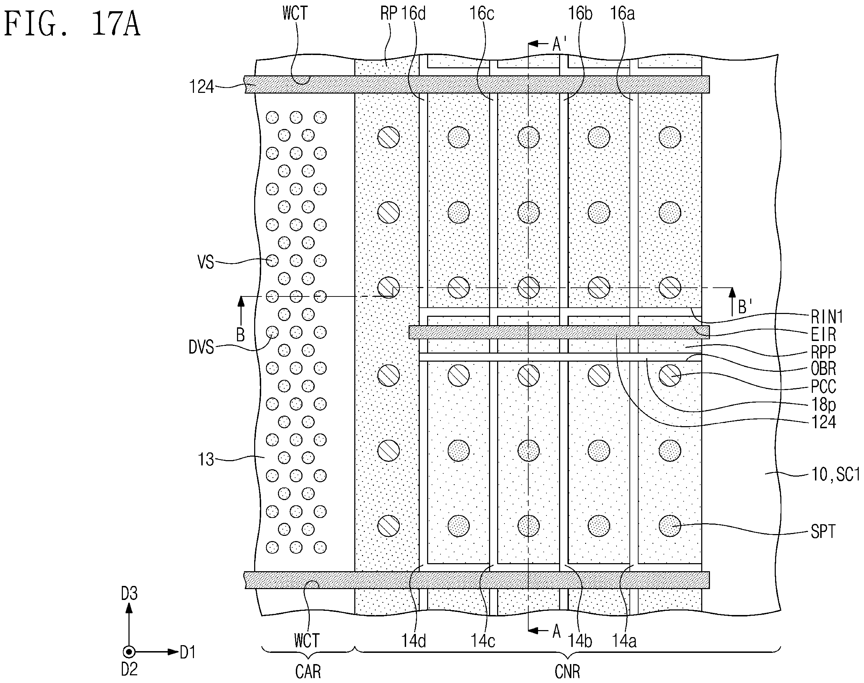

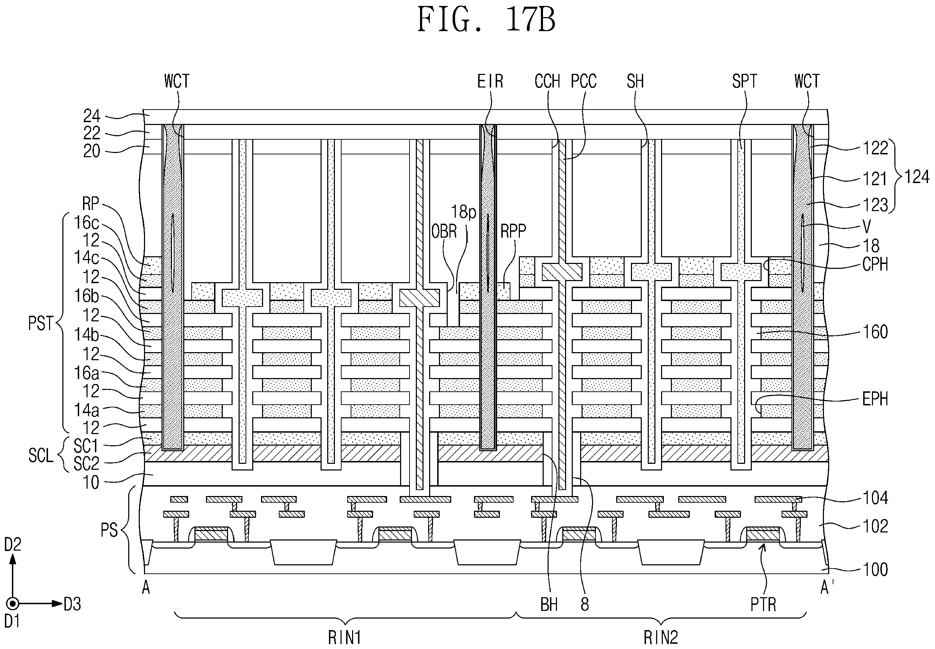

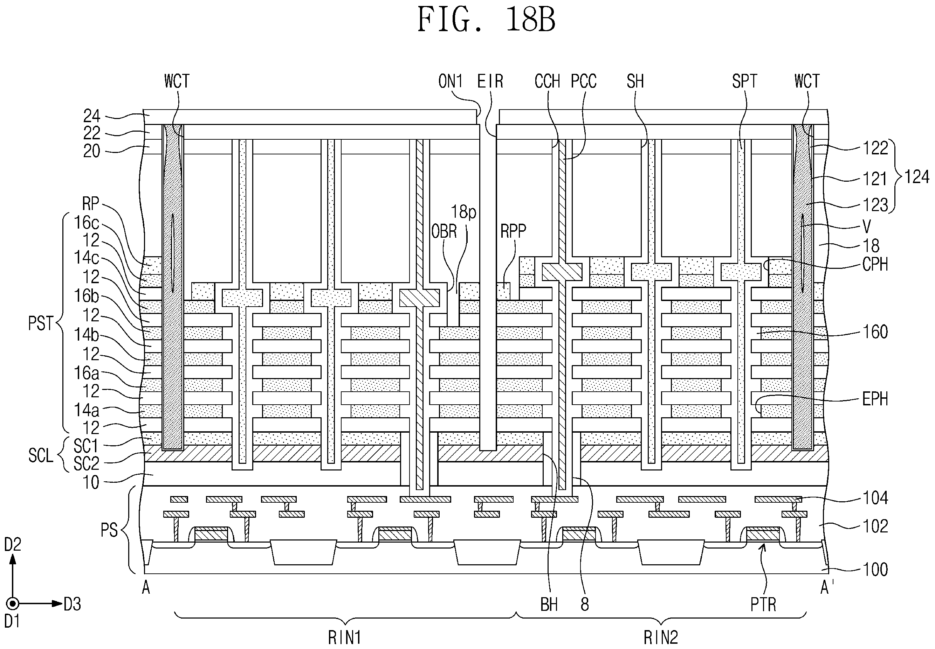

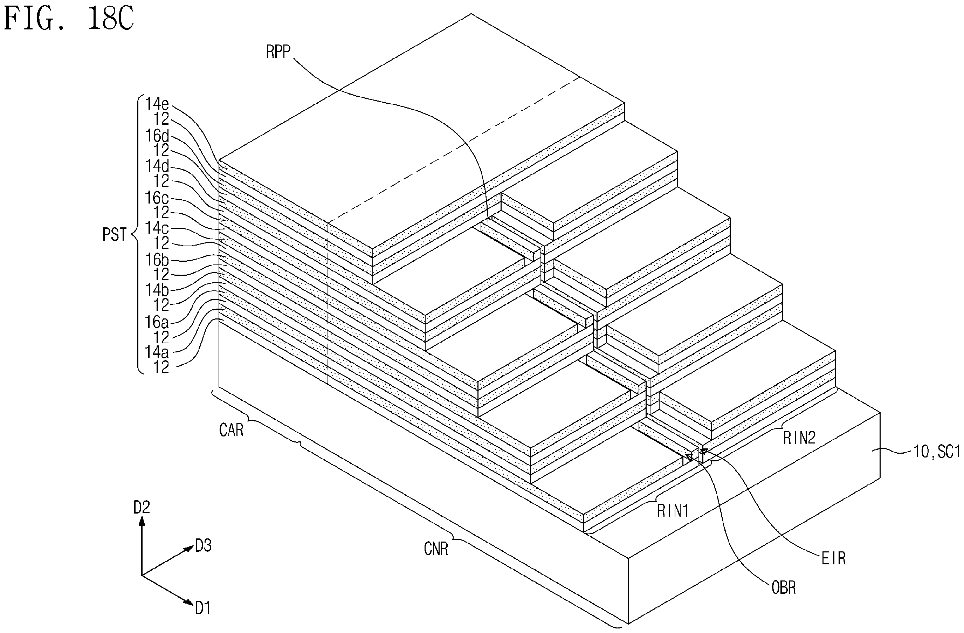

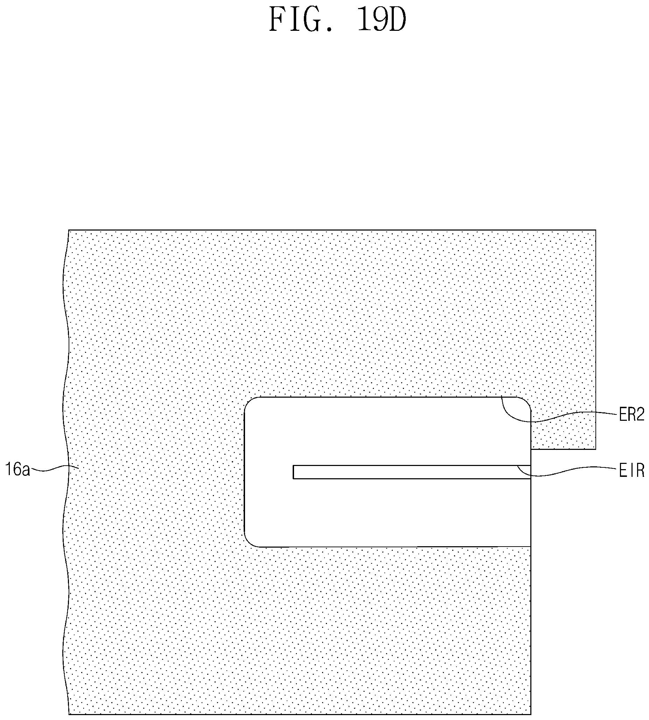

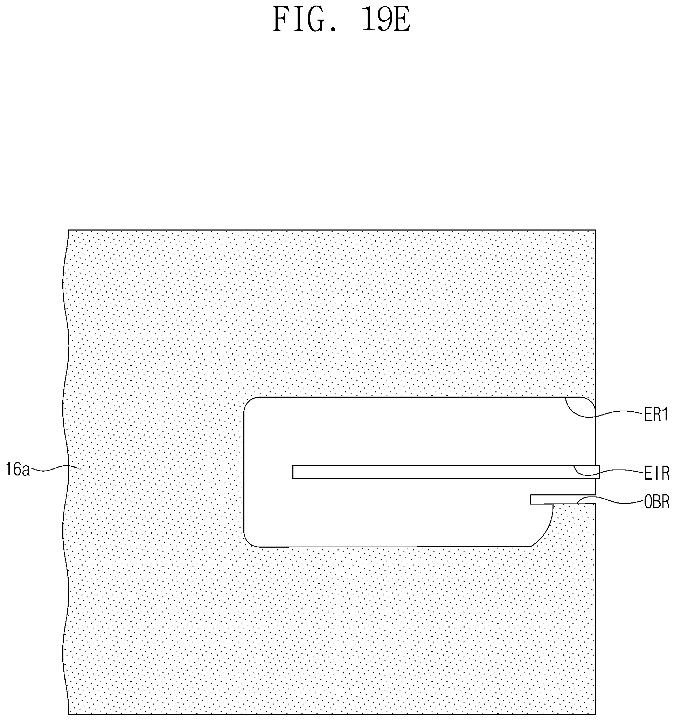

FIGS. 8A to 23A are plan views sequentially illustrating a manufacturing process of a three-dimensional semiconductor memory device having the plane of FIG. 2 according to some example embodiments of the present disclosure. FIGS. 8B to 23B are cross-sectional views of FIGS. 8A to 23A taken along line A-A'. FIGS. 8C, 9C, 11C to 16C, and 19C to 23C are cross-sectional views sequentially illustrating a process of manufacturing the three-dimensional semiconductor memory device of FIG. 3B. FIGS. 11D and 18C are perspective views illustrating a process of manufacturing the three-dimensional semiconductor memory device of FIG. 5A. FIGS. 19D and 19E are plan views illustrating a manufacturing process of the three-dimensional semiconductor memory device having the plane of FIG. 2.

Referring to FIGS. 8A to 8C, a peripheral circuit structure PS is manufactured. To this end, a device isolation layer is formed on the first substrate 100 to define the active regions. Transistors PTR may be formed in the active regions. A multi-layer peripheral interlayer insulating layer 102 covering the transistors PTR and peripheral circuit wirings 104 are formed in the peripheral interlayer insulating layer 102. A second substrate 10 is formed on the peripheral interlayer insulating layer 102. The second substrate 10 has a cell array region CA and a connection region CNR disposed side by side in the first direction D1.

A buffer insulating layer 11, a lower sacrificial layer 41, and an auxiliary buffer insulating layer 43 are sequentially stacked on the second substrate 10. The buffer insulating layer 11 may be formed of, for example, silicon oxide. The lower sacrificial layer 41 may include, for example, silicon germanium and/or polysilicon. The auxiliary buffer insulating layer 43 may include, for example, silicon oxide. A first source pattern SC1 is formed on the auxiliary buffer insulating layer 43. The first source pattern SC1 may include, for example, a semiconductor layer doped with impurities. In the connection region CNR, the first source pattern SC1, the auxiliary buffer insulating layer 43, the lower sacrificial layer 41, the buffer insulating layer 11, and the second substrate 10 are sequentially etched to form lower holes BH exposing an upper surface of the peripheral interlayer insulating layer 102. Substrate insulating patterns 8 are formed to fill the lower holes BH, respectively.

Inter-electrode insulating layers 12 and first and second mold sacrificial layers 14a to 14e and 16a to 16d are alternately stacked on the first source pattern SC1. The inter-electrode insulating layers 12 may include, for example, silicon oxide. The first and second mold sacrificial layers 14a to 14e and 16a to 16d include first mold sacrificial layers 14a to 14e and second mold sacrificial layers 16a to 16d that are alternately stacked. The first and second mold sacrificial layers 14a to 14e and 16a to 16d may be formed of a material having etch selectivity with the inter-electrode insulating layers 12 and may include, for example, silicon nitride. The first mold sacrificial layers 14a to 14e may include (1-1)th to (1-5)th mold sacrificial layers 14a to 14e (otherwise known as first to fifth first mold scarified layers). The second mold sacrificial layers 16a to 16d may include (2-1)th to (2-4)th mold sacrificial layers 16a to 16d (otherwise known as first to fifth second mold scarified layers). An uppermost inter-electrode insulating layer 13 is formed on the (1-5)th mold sacrificial layer 14e to form a preliminary stack structure PST.

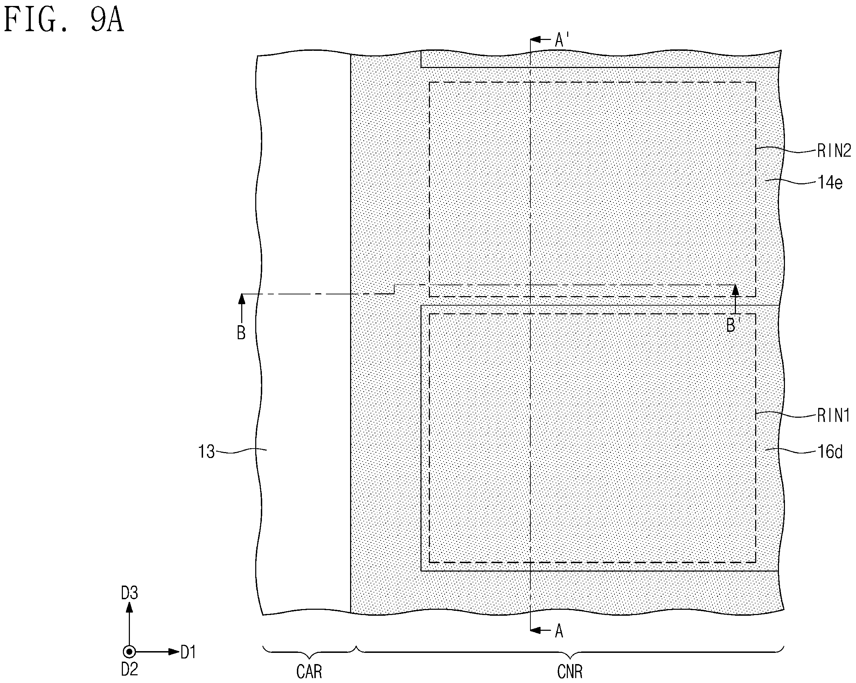

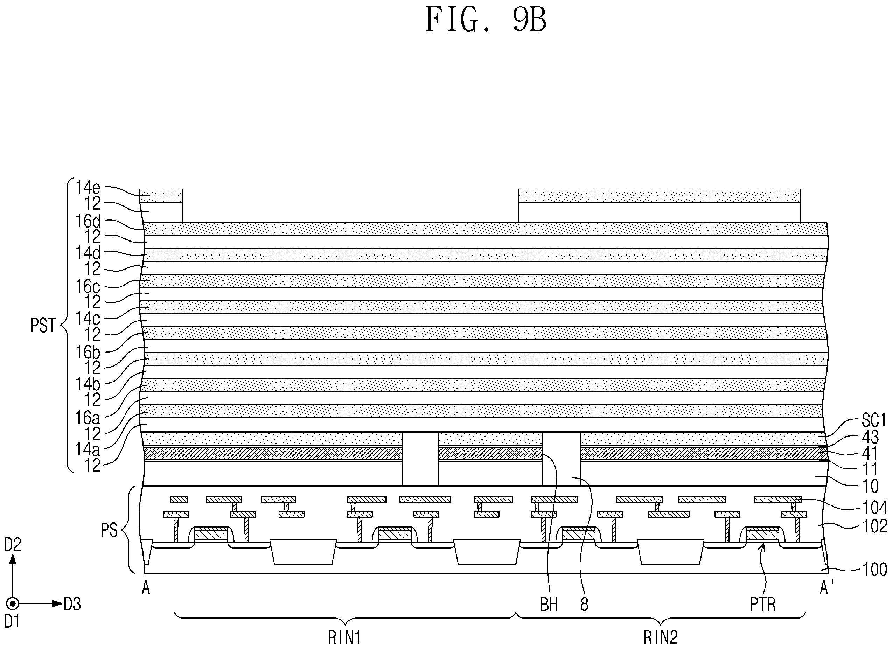

Referring to FIGS. 9A to 9C, the uppermost inter-electrode insulating layer 13 is removed from the connection region CNR to expose the (1-5)th mold sacrificial layers 14e. The connection region CNR may have a first region RIN1 and a second region RIN2. The first region RIN1 may be a region more stepped than the second region RIN2. The first region RIN1 may have a level lower than that of the second region RIN2 adjacent thereto in the third direction D3. The (1-5)th mold sacrificial layers 14e on the first region RIN1 of the connection region CNR and the inter-electrode insulating layer 12 thereunder are removed to expose an upper surface of the (2-4)th mold sacrificial layer 16d.

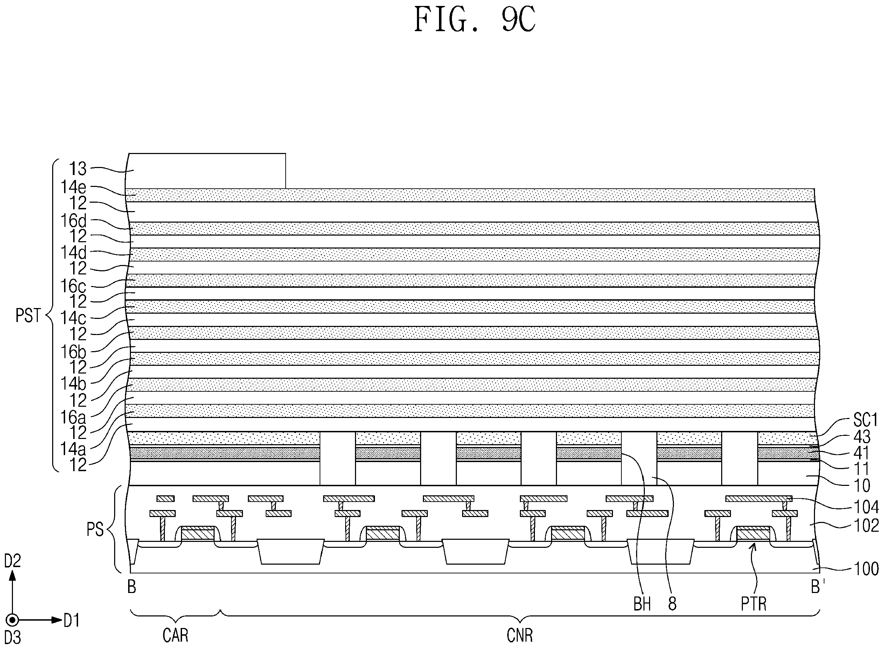

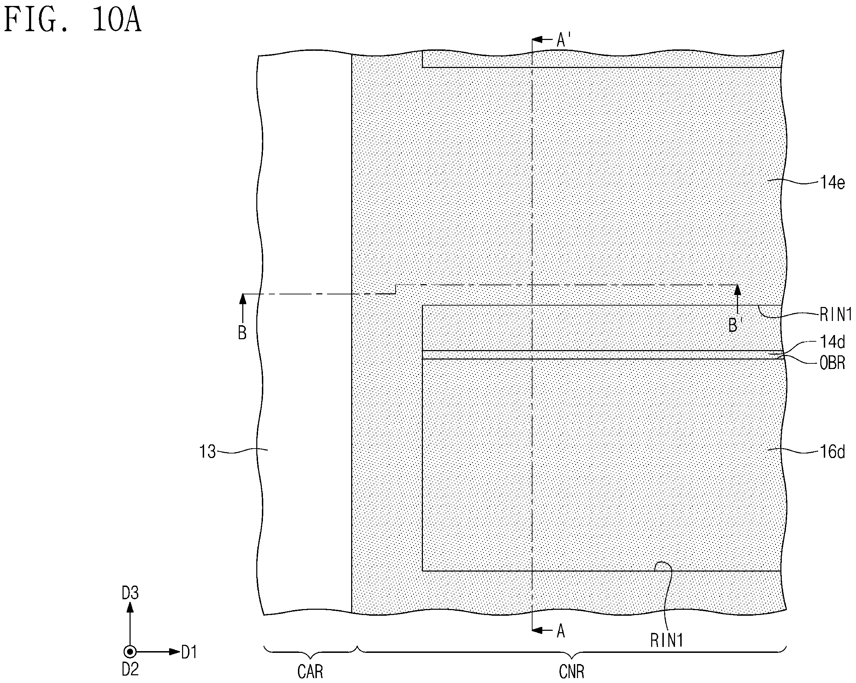

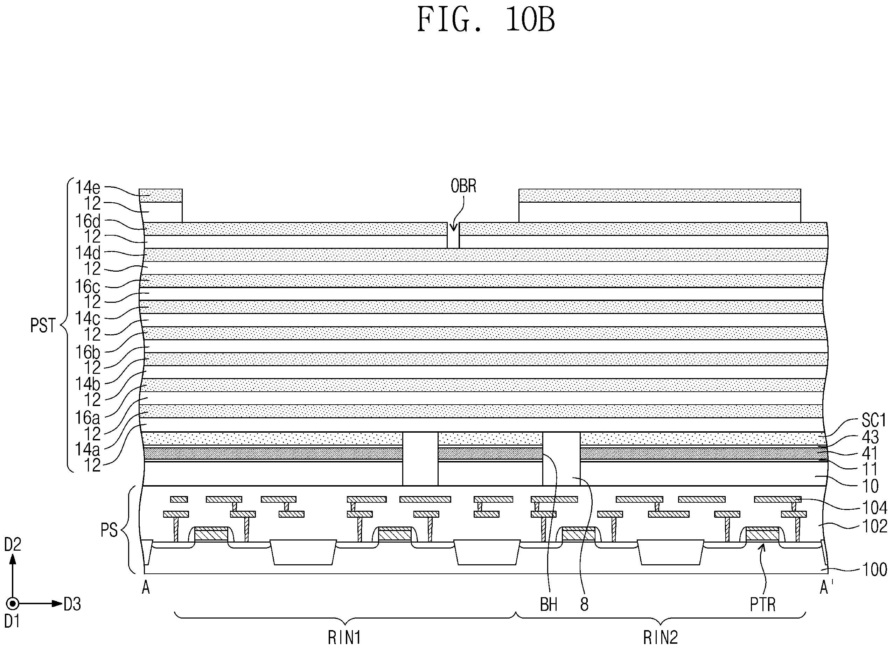

Referring to FIGS. 10A and 10B, the (2-4)th mold sacrificial layer 16d on the first region RIN1and the inter-electrode insulating layer 12 thereunder are removed to form a removal-protection region OBR which exposes (1-4)th mold sacrificial layers 14d. When viewed in a plan view, the removal-protection region OBR may have a straight groove shape extending in the first direction D1. A cross section of FIG. 10A taken along line B-B' may be the same as that of FIG. 9C.

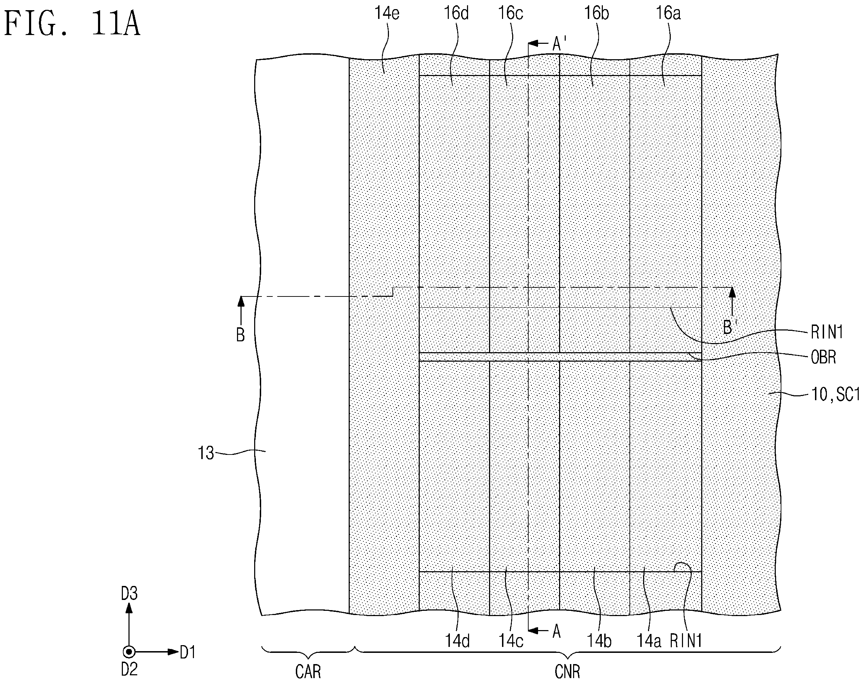

Referring to FIGS. 11A to 11D, ends of the inter-electrode insulating layers 12 and the first and second mold sacrificial layers 14a to 14e and 16a to 16d form a staircase shape in the connection region CNR by repeatedly performing a trimming process and an etching process. In this case, in the first region RIN1, upper surfaces of the first and second mold sacrificial layers 14a to 14e and 16a to 16d are formed to have a lower level than adjacent ones in the third direction D3 by the process of FIGS. 9A to 9C.

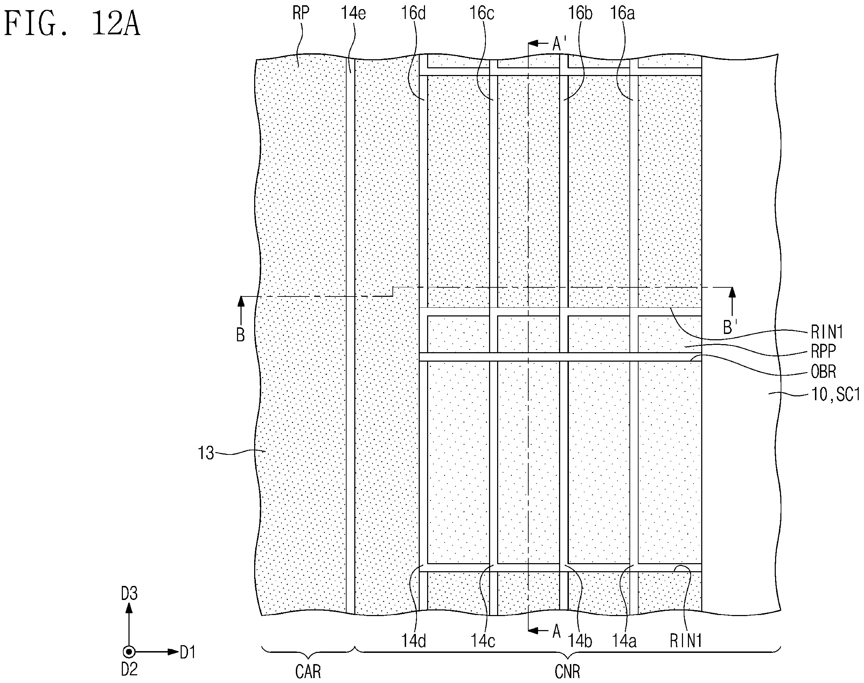

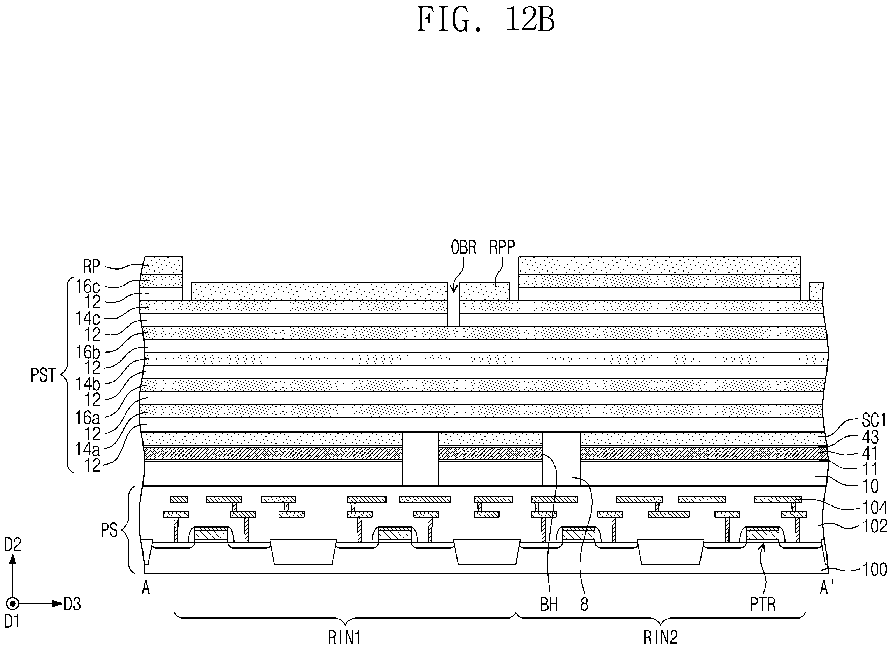

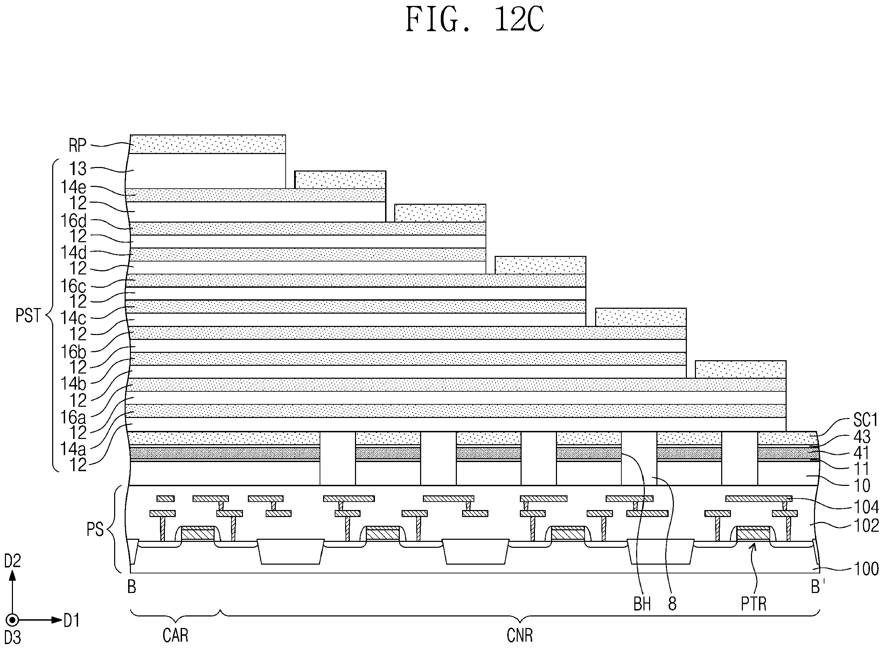

Referring to FIGS. 12A to 12C, a preliminary pad layer RP is formed on ends of the first and second mold sacrificial layers 14a to 14e and 16a to 16d. The preliminary pad layer RP may include a material capable of being etched with a first etchant to etch the first and second mold sacrificial layers 14a to 14e and 16a to 16d, and include a material having a faster etching rate than the first and second mold sacrificial layers 14a to 14e and 16a to 16d. The preliminary pad layer RP may include, for example, silicon nitride. The preliminary pad layer RP may be formed by a deposition process having low step coverage characteristics, such as physical vapor deposition (PVD). A density of the preliminary pad layer RP may be lower than that of the first and second mold sacrificial layers 14a to 14e and 16a to 16d. The preliminary pad layer RP may also be formed on an uppermost inter-electrode insulating layer 13. A remaining preliminary pad layer RPP may be formed on the (1-1)th to (1-4)th mold sacrificial layers 14a to 14d between the removal-protection region OBR and the second region RIN2. The remaining preliminary pad layer RPP may be formed to be spaced apart from adjacent preliminary pad layers RP.

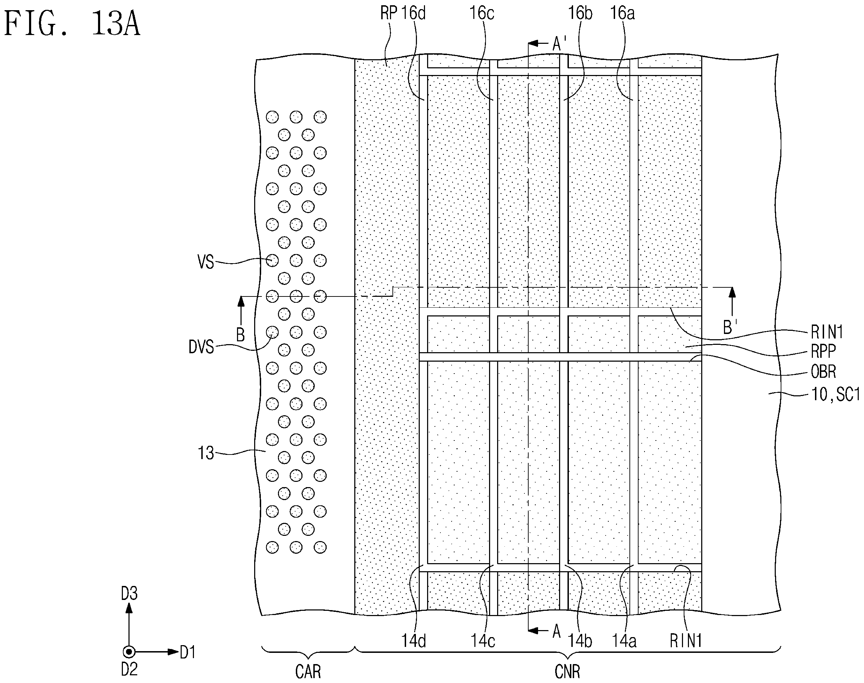

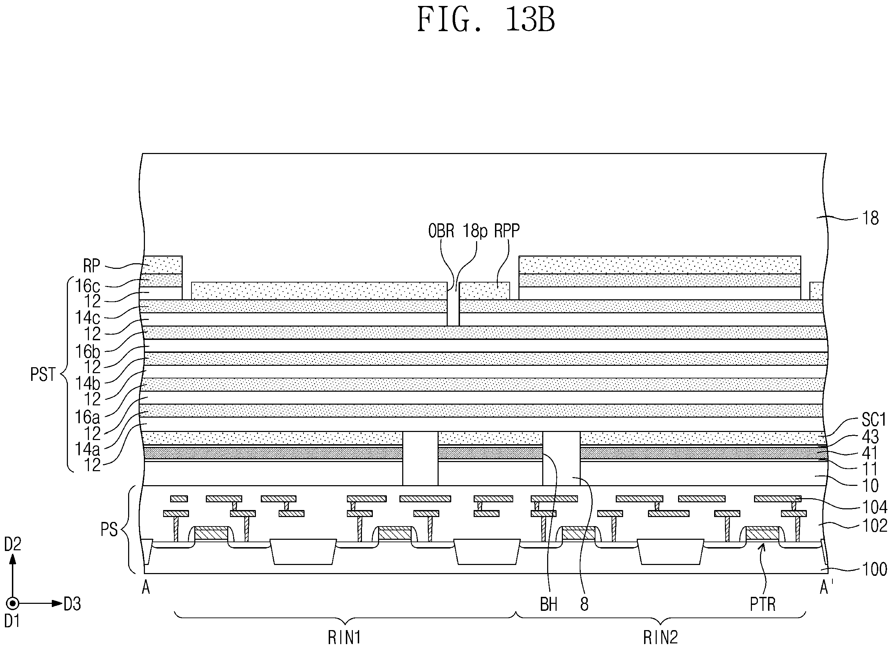

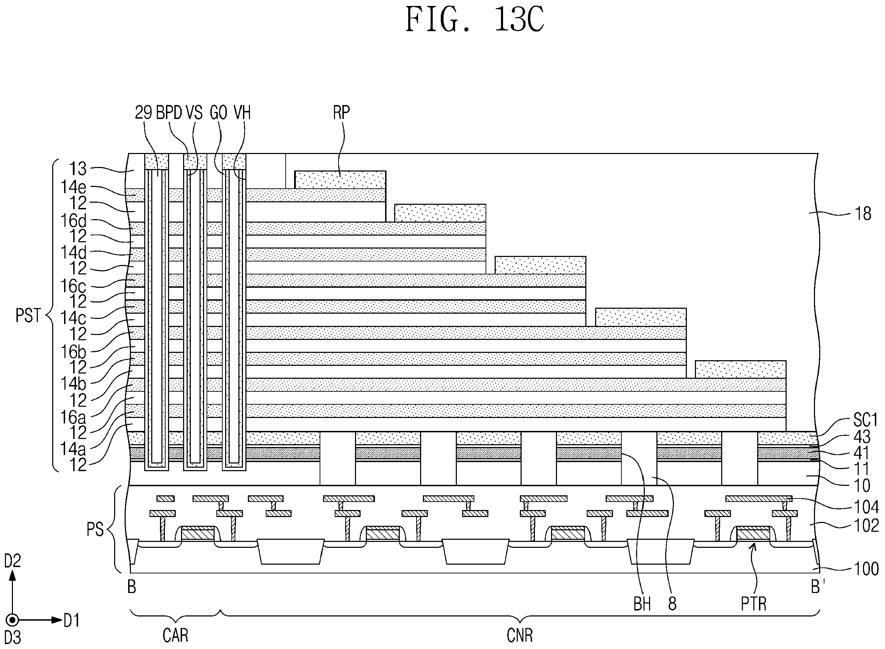

Referring to FIGS. 13A to 13C, a flat insulating layer 18 may be deposited on the preliminary stack structure PST, a chemical mechanical polishing (CMP) process may be performed to form the flat insulating layer 18 covering ends of the preliminary stack structure PST to expose an upper surface of the uppermost inter-electrode insulating layer 13. The preliminary pad layer RP on the uppermost inter-electrode insulating layer 13 may be removed by the CMP process. A portion 18p of the flat insulating layer 18 may be inserted into the removal-protection region OBR to fill therein.

In the cell array region CAR, the uppermost inter-electrode insulating layer 13, the preliminary stack structure PST, the first source pattern SC1, the auxiliary buffer insulating layer 43, the lower sacrificial layer 41, the buffer insulating layer 11, and the substrate 10 are partially etched to form vertical holes VH. A gate insulating layer GO and vertical patterns VS and DVS are formed to conformally cover inner walls of the vertical holes VH in sequence. In addition, buried insulating patterns 29 may be formed to fill the vertical holes VH. The buried insulating patterns 29, the vertical patterns VS and DVS, and the gate insulating layer GO may be partially etched and fill a conductive layer therein to form bit line pads BPD.

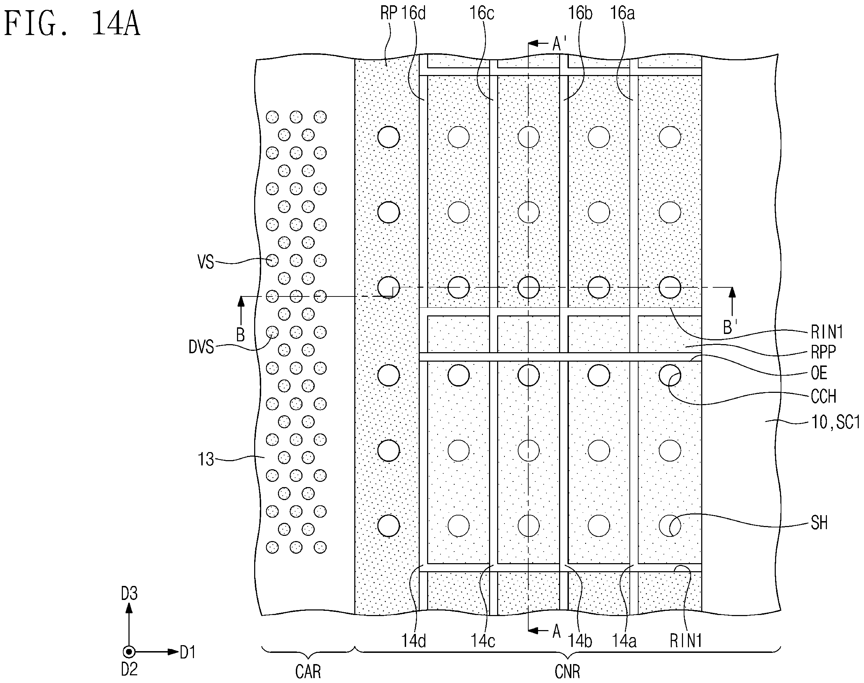

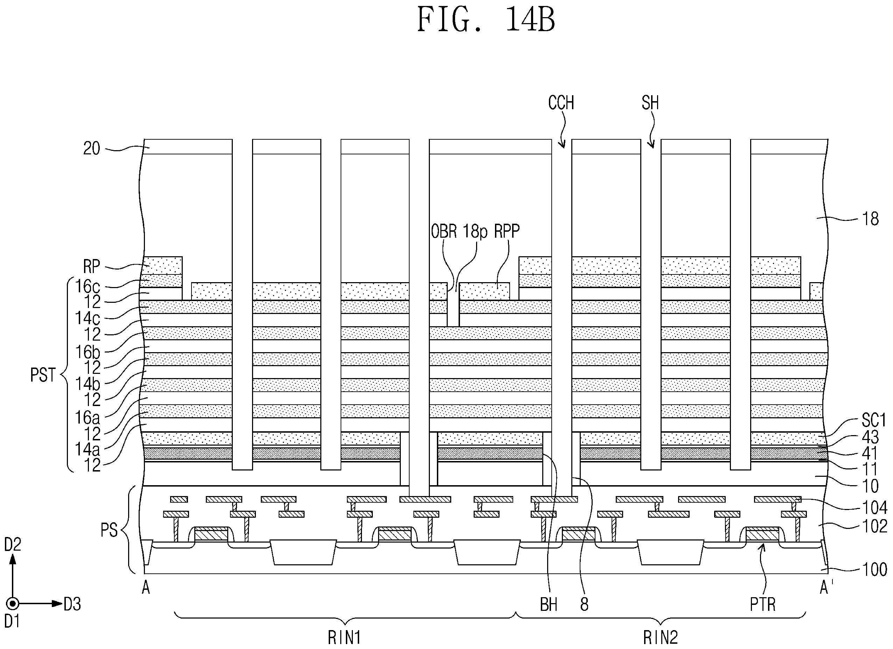

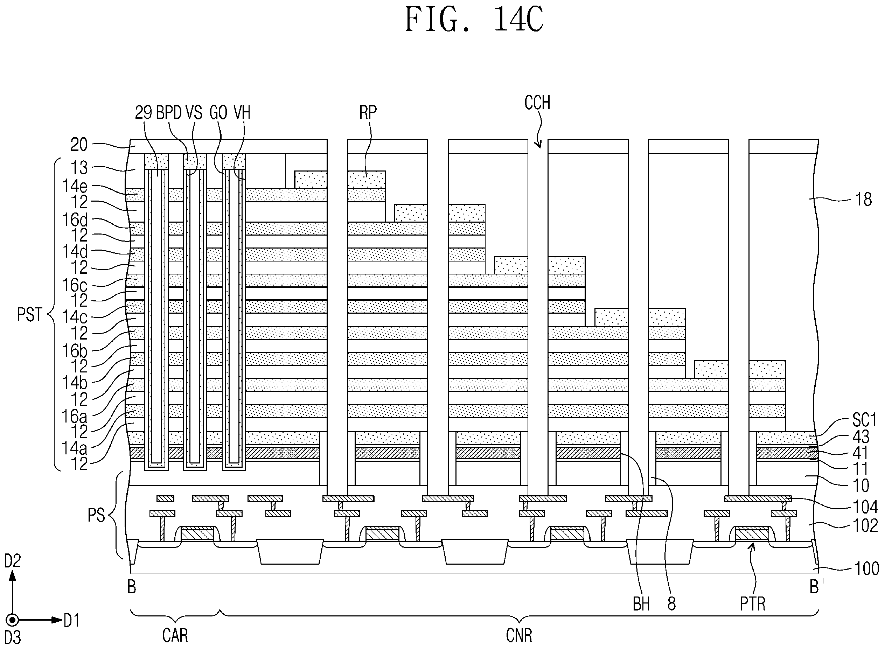

Referring to FIGS. 14A to 14C, a first upper insulating layer 20 is formed on the uppermost inter-electrode insulating layer 13, the preliminary stack structure PST, and the flat insulating layer 18. The first upper insulating layer 20, the flat insulating layer 18, the preliminary stack structure PST, the substrate insulating pattern 8, and the peripheral interlayer insulating layer 102 in the connection region CNR are partially removed to form cell contact holes CCH exposing the peripheral circuit wirings 104. In this case, the first upper insulating layer 20, the flat insulating layer 18, and the preliminary stack structure PST may be etched in the connection region CNR to form a support hole SH. Side surfaces of the preliminary pad layer RP, the inter-electrode insulating layers 12 thereunder, and the first and second mold sacrificial layers 14a to 14e and 16a to 16d may be exposed by the cell contact holes CCH. The support hole SH and the cell contact holes CCH may be formed to be spaced apart from the removal protection region OBR.

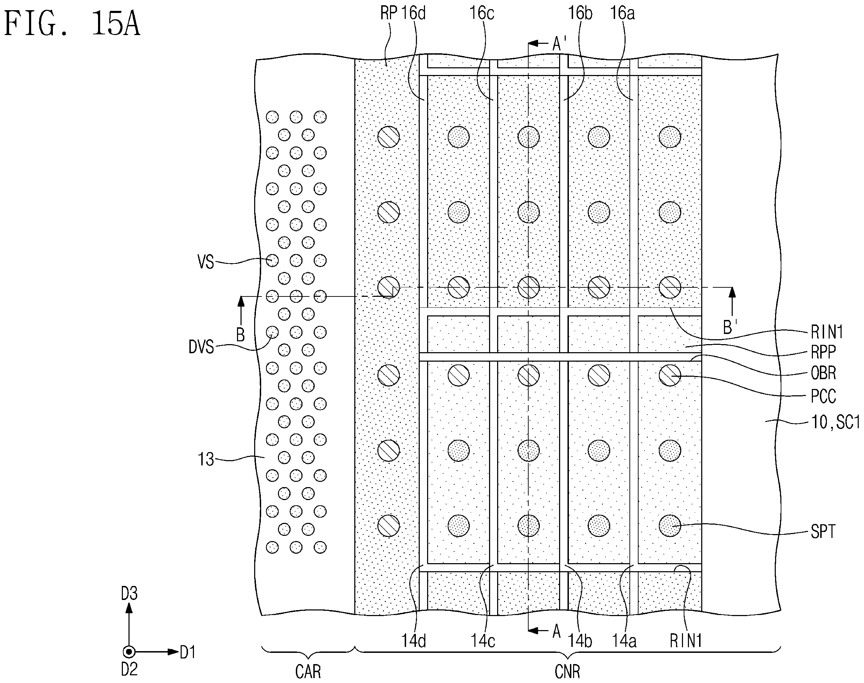

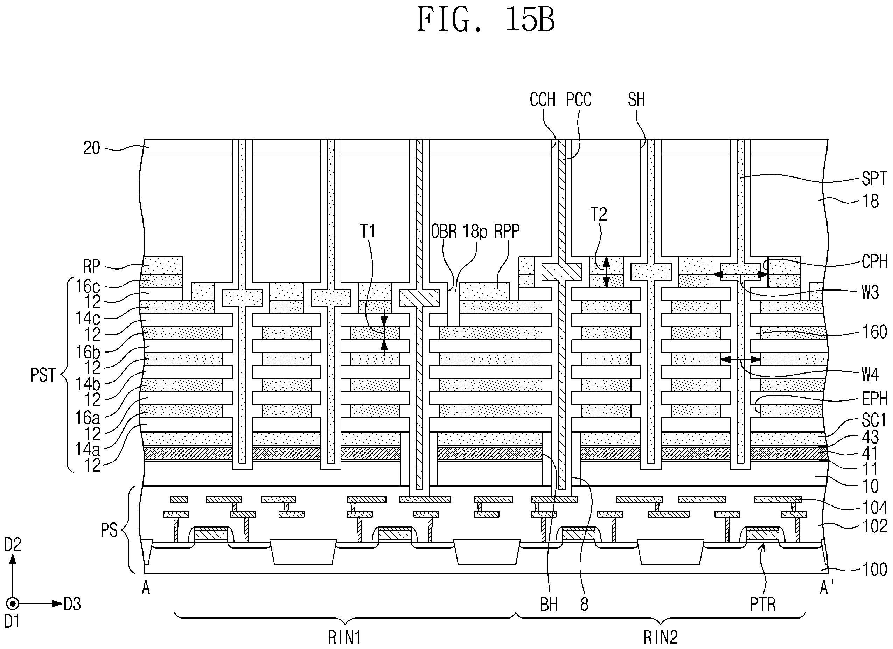

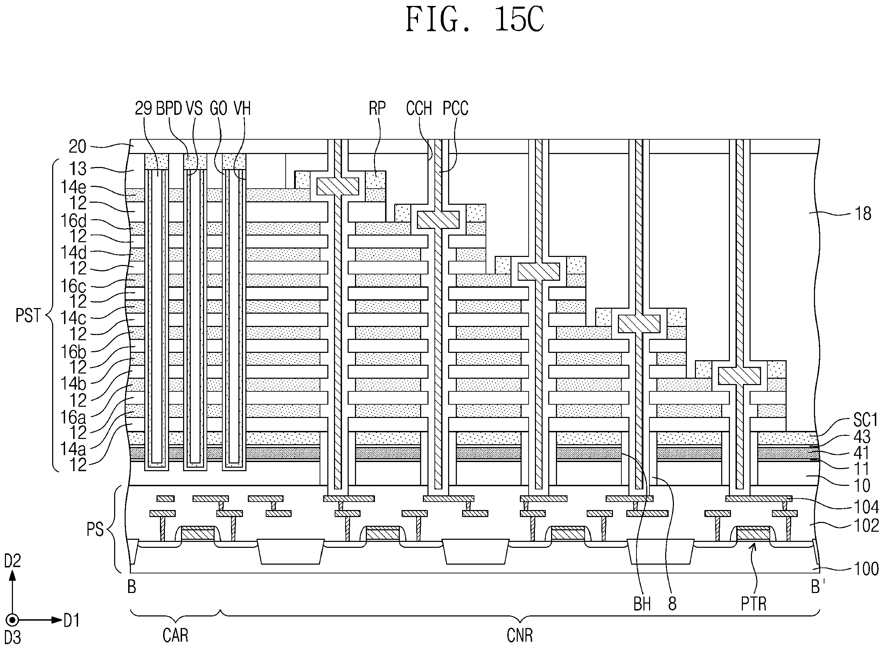

Referring to FIGS. 15A to 15C, an isotropic etching process is performed through the support hole SH and the cell contact holes CCH to partially etch the preliminary pad layer RP and the first and second mold sacrificial layers 14a to 14e, and 16a to 16d. Accordingly, a first inner space CPH and a second inner space EPH may be formed. The preliminary pad layer RP is etched by the same etchant as the first and second mold sacrificial layers 14a to 14e and 16a to 16d and has an etching rate faster than that of the first and second mold sacrificial layers 14a to 14e and 16a to 16d. As a result, the etching rate of ends of the first and second mold sacrificial layers 14a to 14e and 16a to 16d that are in contact with the preliminary pad layer RP and have a stepped shape may increase. Therefore, the second inner space EPH may be formed to have a first height (same as the first thickness T1) and a fourth width W4, and the first inner space CPH may be formed to have a third width W3 and a second height (same as the second thickness T2). The second thickness T2 is greater than the first thickness T1. The third width W3 is greater than the fourth width W4.

Subsequently, a contact insulating layer may be conformally formed on the first upper insulating layer 20. In this case, a thickness of the contact insulating layer may be about 1/2 of the first thickness T1. When the second thickness T2 is greater than the first thickness T1, the contact insulating layer may conformally cover the inner wall of the first inner space CPH while completely filling the second inner space EPH. However, the first inner space CPH is not completely filled.

A protective pattern PCC is formed in the cell contact holes CCH. A support pattern SPT is formed in the support hole SH. The protective pattern PCC may include, for example, polysilicon or silicon germanium. The support pattern SPT may have, for example, a single layer or multilayer structure of at least one of silicon oxide, silicon nitride, and silicon oxynitride. A CMP process or an etch-back process is performed to remove the contact insulating layer on the first upper insulating layer 20 and to form the contact insulating pattern 160 in the support hole SH and the cell contact holes CCH.

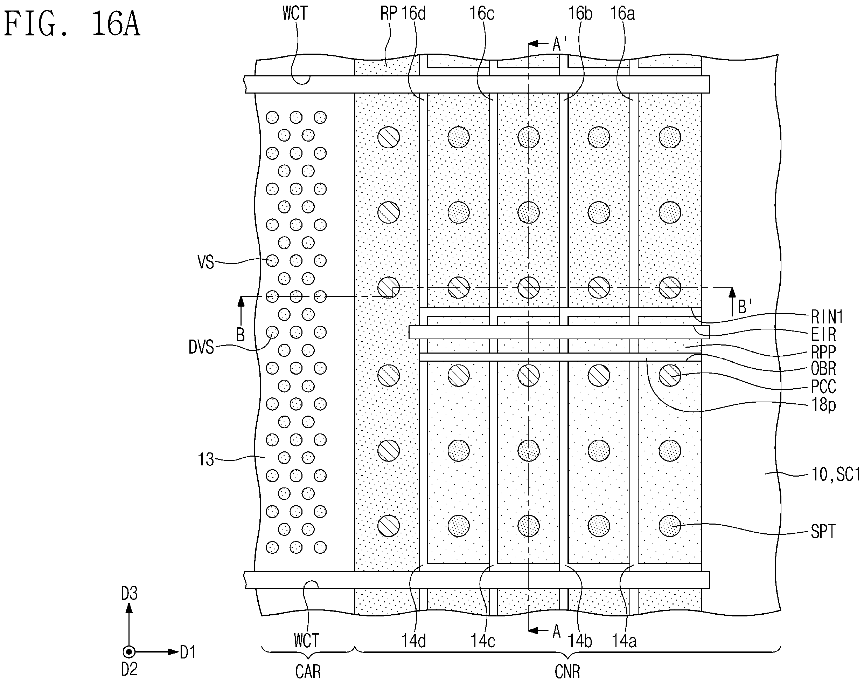

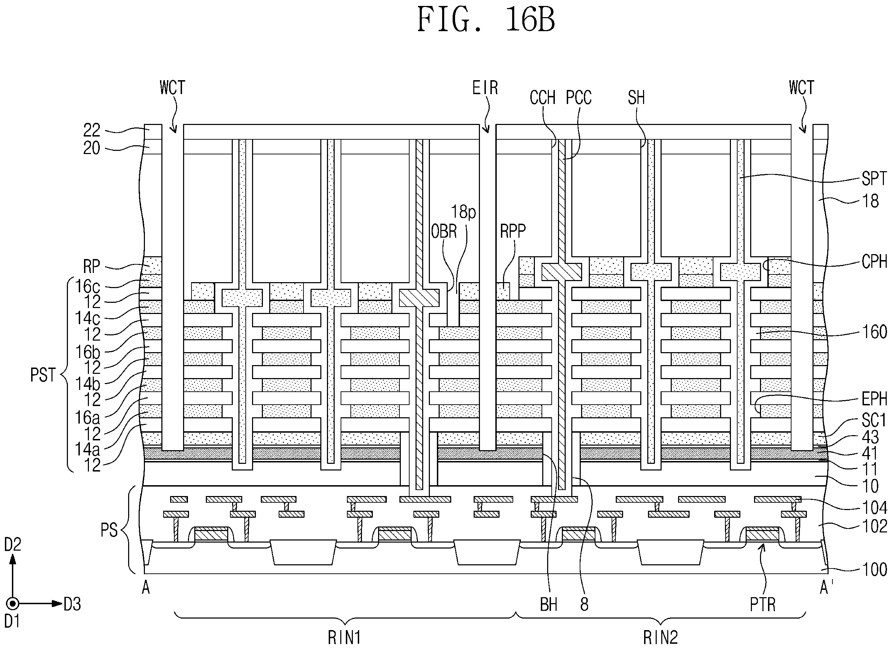

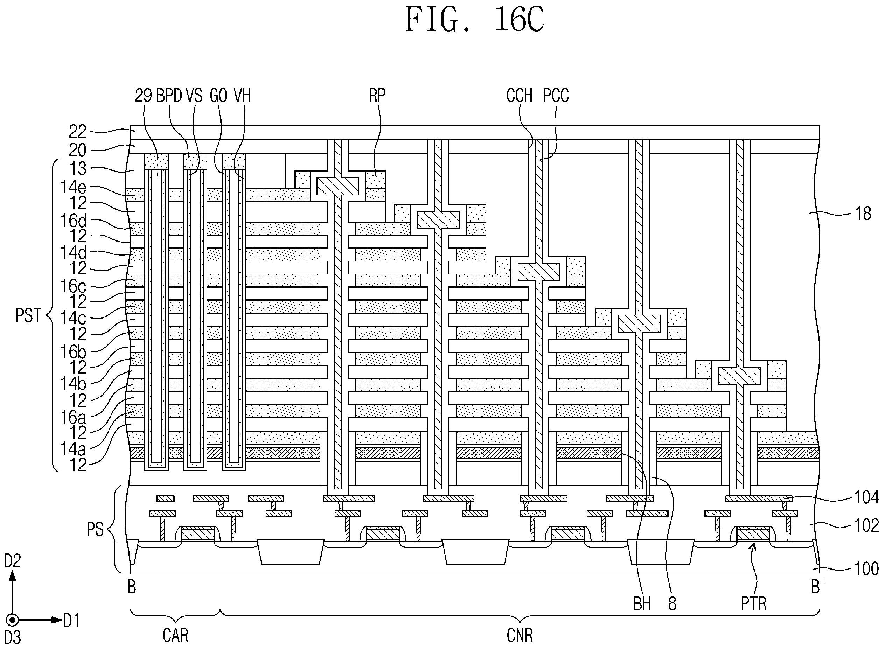

Referring to FIGS. 16A to 16C, a second upper insulating layer 22 is formed on the first upper insulating layer 20. The second upper insulating layer 22, the first upper insulating layer 20, the flat insulating layer 18, the preliminary stack structure PST, the first source pattern SC1, and the auxiliary buffer insulating layer 43 are partially removed to form a word line cut region (WCT). At this time, a separation groove (EIR) may be formed. The separation groove EIR may be formed on the first region RIN1 and adjacent to the second region RIN2. The separation groove EIR may be positioned between the removal preventing region OBR and the second region RIN2. The separation groove EIR may be formed through the remaining preliminary pad layer RPP. The separation groove EIR may have the same/similar depth as the word line cut region WCT.

Referring to FIGS. 3C, 3D, 16C, 17A, and 17B, the lower sacrificial layer 41, the auxiliary buffer insulating layer 43, and a portion of the buffer insulating layer 11, and a portion of the gate insulating layer GO may be removed through a word line cut region WCT and a separation groove EIR to expose a lower side of the cell vertical patterns VS, an upper surface of the second substrate 10, and a lower surface of the first source pattern SC1. After forming a conductive layer to fill the space between the word line cut region WCT and the separation groove EIR and between the first source pattern SC1 and the second substrate 10, the conductive layer in the word line cut region WCT and the separation groove EIR is removed to form a second source pattern SC2 in the space between the first source pattern SC1 and the second substrate 10. Accordingly, a source structure SCL including the first source pattern SC1 and the second source pattern SC2 may be formed.

Subsequently, a protective structure 124 may be formed in the word line cut region WCT and the separation groove EIR, respectively. The protective structure 124 may include a sidewall protective layer 121 conformally covering inner walls of the word line cut region WCT and the separation groove EIR, an upper protective layer 122 narrowing a width of an entrance portion of the word line cut region WCT and the separation groove EIR, and a buried protective layer 123 filling the word line cut region WCT and the separation groove EIR. A void V may be formed inside the buried protective layer 123. The sidewall protective layer 121, the upper protective layer 122, and the buried protective layer 123 may be formed of a material having an etch selectivity to each other. For example, the sidewall protective layer 121 may include silicon oxide. The upper protective layer 122 may include silicon oxide or silicon nitride. The sidewall protective layer 121 may include silicon nitride, polysilicon, or an amorphous carbon layer (ACL). A third upper insulating layer 24 is formed on the second upper insulating layer 22 and the protective structure 124.

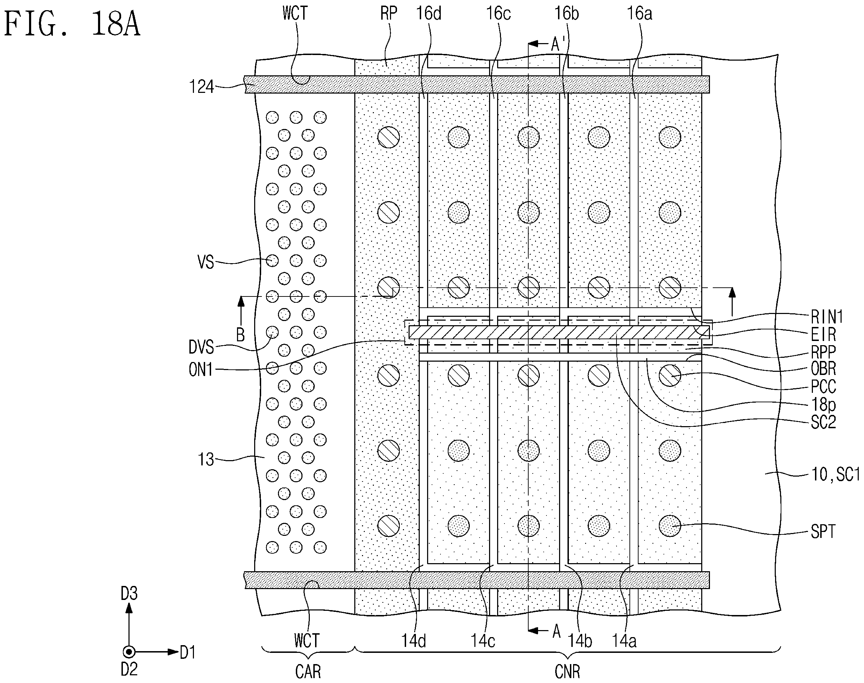

Referring to FIGS. 18A to 18C, the third upper insulating layer 24 is etched to form a first opening ON1 exposing the protective structure 124 in the separation groove EIR. The protective structure 124 in the separation groove EIR is removed through the first opening ON1. As a result, the source structure SCL, the remaining preliminary pad layer RPP, and the first and second mold sacrificial layers 14a to 14e and 16a to 16d may be exposed through the separation groove EIR.

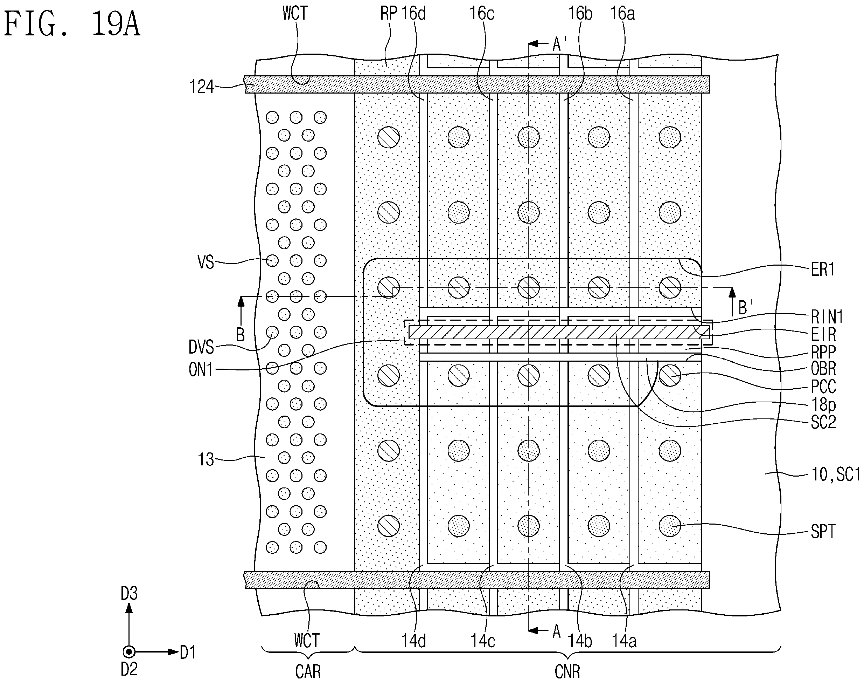

Referring to FIGS. 19A to 19E, an isotropic etching process may be performed using a second etchant to etch the remaining preliminary pad layer RPP and the first and second mold sacrificial layers 14a to 14e and 16a to 16d to partially remove the remaining preliminary pad layer RPP and the first and second mold sacrificial layers 14a to 14e and 16a to 16d through the separation groove EIR. As a result, first to eighth empty spaces ER1 to ER8 may be formed. In this case, the second etchant cannot diffuse into the preliminary pad layers RP because the remaining preliminary pad layer RPP is spaced apart from the preliminary pad layers RP and is blocked by a portion 18p of the flat insulating layer 18 in the removal-protection region OBR. As a result, the preliminary pad layers RP and the ends of the first and second mold sacrificial layers 14a to 14e and 16a to 16d positioned below the preliminary pad layers RP are not removed. The removal protection region OBR may serve to prevent or reduce the second etchant from diffusing into the preliminary pad layers RP. A shape of the second empty space ER2 in the (2-1)th mold sacrificial layer 16a may be formed as shown in FIG. 19D. A shape of the second empty space ER2 in the (1-1)th mold sacrificial layer 14a may be formed as shown in FIG. 19E by the removal protection region OBR.

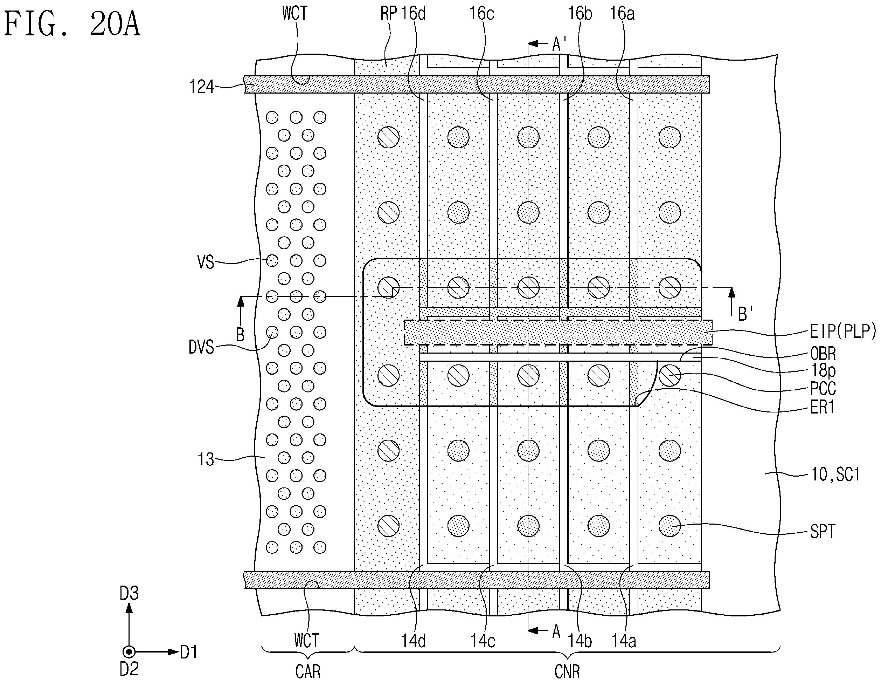

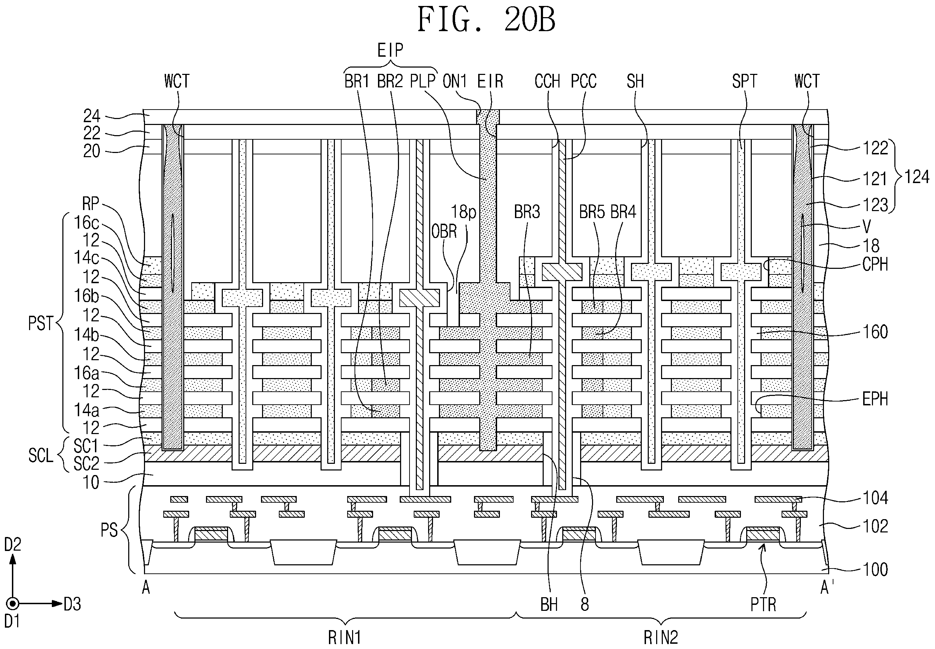

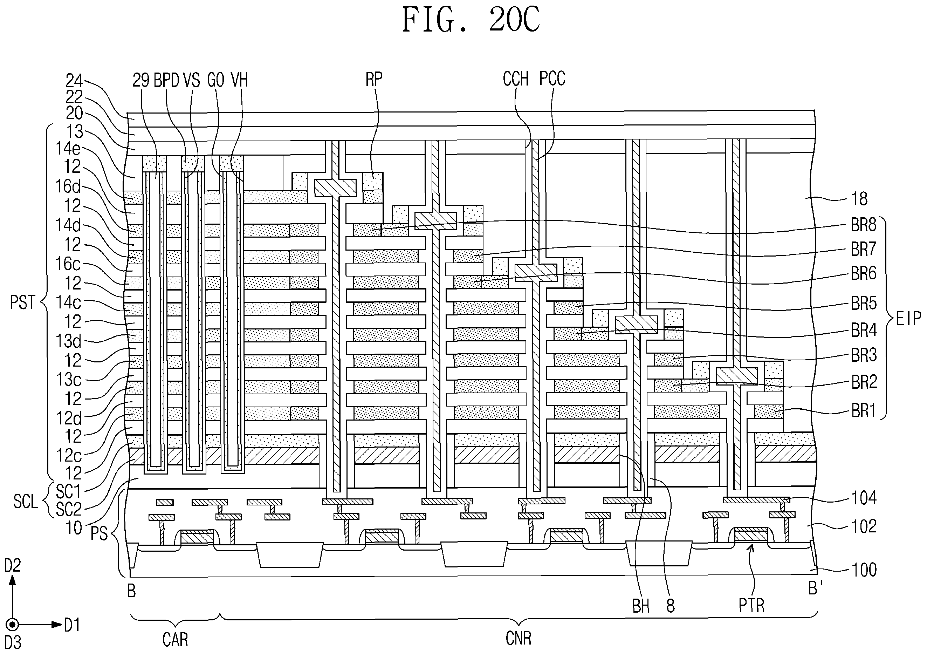

Referring to FIGS. 20A to 20C, the separation groove EIR and empty spaces ER1 to ER8 are filled with an insulating material to form an end insulating pattern EIP. The end insulating pattern EIP includes pillar portion PLP in separation groove EIR and branch portions BR1 to BR8 in the empty spaces ER1 to ER8, respectively. The branch portions BR1 to BR8 may be formed to surround side surfaces of the contact insulation patterns 160 in the cell contact holes CCH.

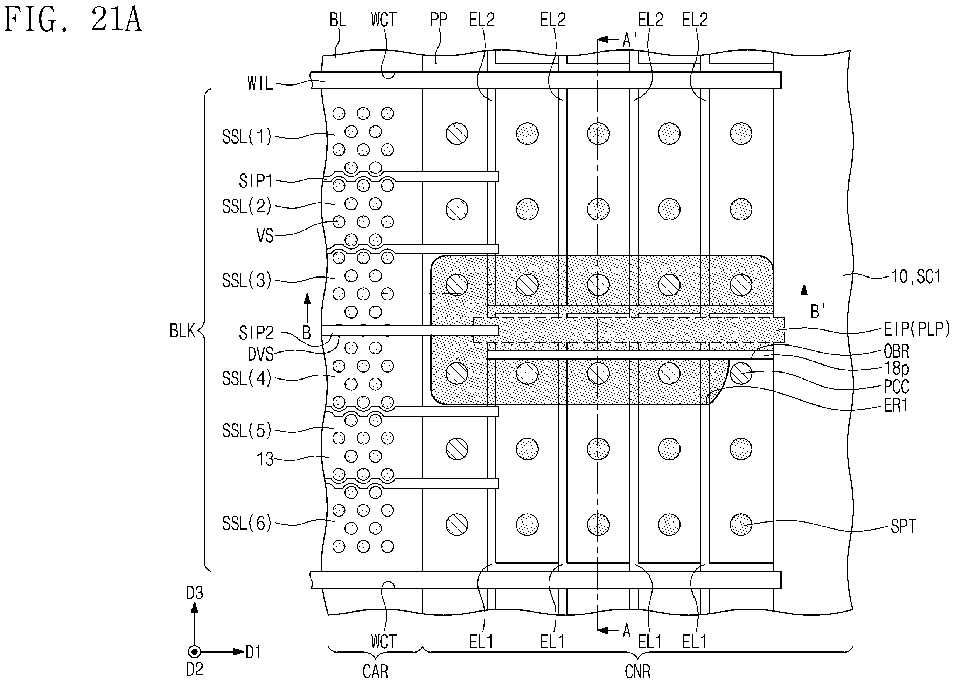

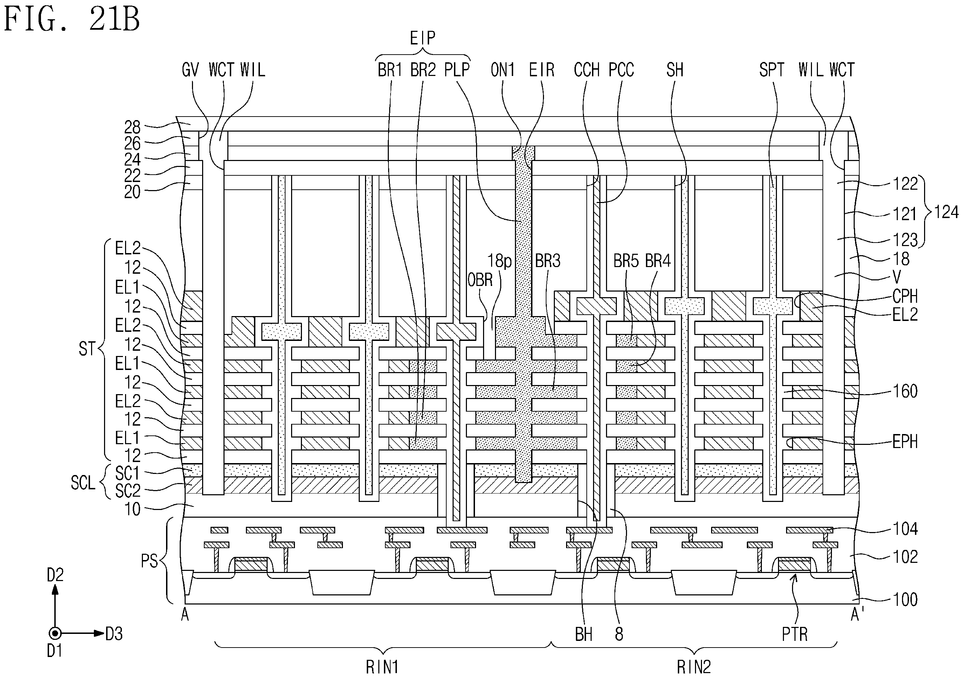

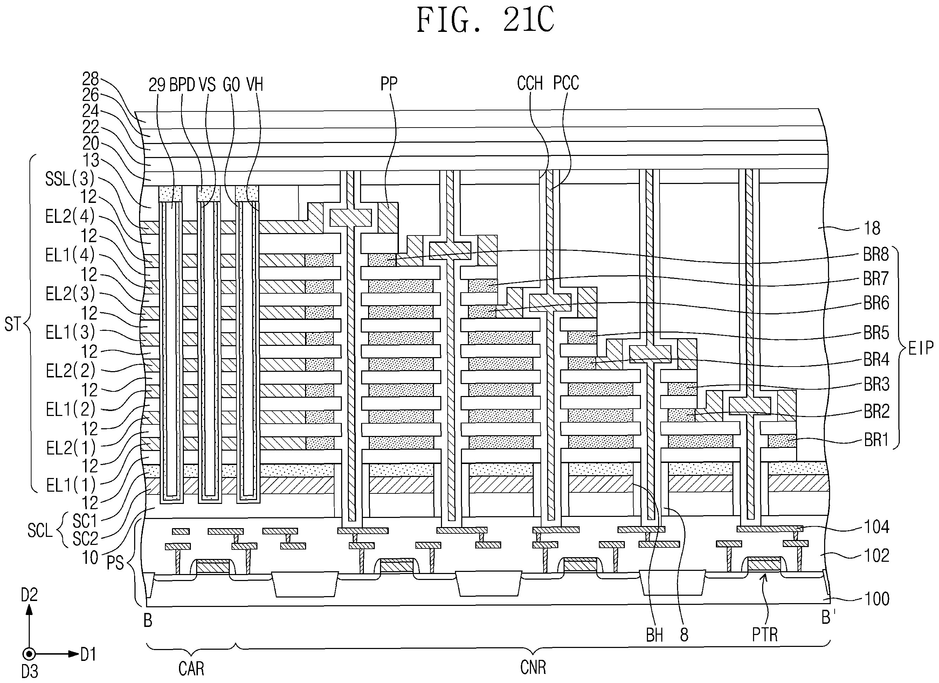

Referring to FIGS. 21A to 21C, a fourth upper insulating layer 26 is formed on the third upper insulating layer 24 and the end insulating pattern EIP. The fourth upper insulating layer 26 and the third upper insulating layer 24 are etched to form a groove GV exposing the protective structure 124 in the word line cut region WCT. The protective structure 124 in the word line cut region WCT is removed through the groove GV to expose the preliminary pad layers RP and the first and second mold sacrificial layers 14a to 14e and 16a to 16d. The preliminary pad layers RP and the first and second mold sacrificial layers 14a to 14e and 16a to 16d are replaced with the electrode layers EL1 and EL2 through the groove GV and the word line cut region WCT. That is, the preliminary pad layers RP and the first and second mold sacrificial layers 14a to 14e and 16a to 16d are removed through the groove GV and word line cut region WCT to form the empty spaces between the inter-electrode insulating layers 12. As a result, the preliminary stack structure PST may be changed into a stack structure ST.

Referring to FIGS. 6C and 21A to 21C, a high dielectric layer HL is conformally formed to cover side surfaces of the inter-electrode insulating layers 12 and the gate insulating layer GO. A conductive layer is formed to fill the empty spaces between the inter-electrode insulating layers 12 and fills the groove GV and the word line cut region WCT. The conductive layer in the groove GV and the word line cut region WCT is removed to form first and second electrode layers EL1 and EL2 between the inter-electrode insulating layers 12. A word line separation pattern WIL is formed by filling the groove GV and the word line cut region WCT with an insulating material. A fifth upper insulating layer 28 is formed on the fourth upper insulating layer 26.

Referring to FIGS. 21A and 3C, the first to fifth upper insulating layers 20, 22, 24, 26, and 28, an uppermost inter-electrode insulating layer 13, and a lower electrode layer (which is disposed on an uppermost one of the first and second electrode layers EL1 and EL2, EL1 or EL2) are etched to form upper conductive lines SSL and a groove therebetween. The groove is filled with an insulating material to form first and second upper separation patterns SIP1 and SIP2.

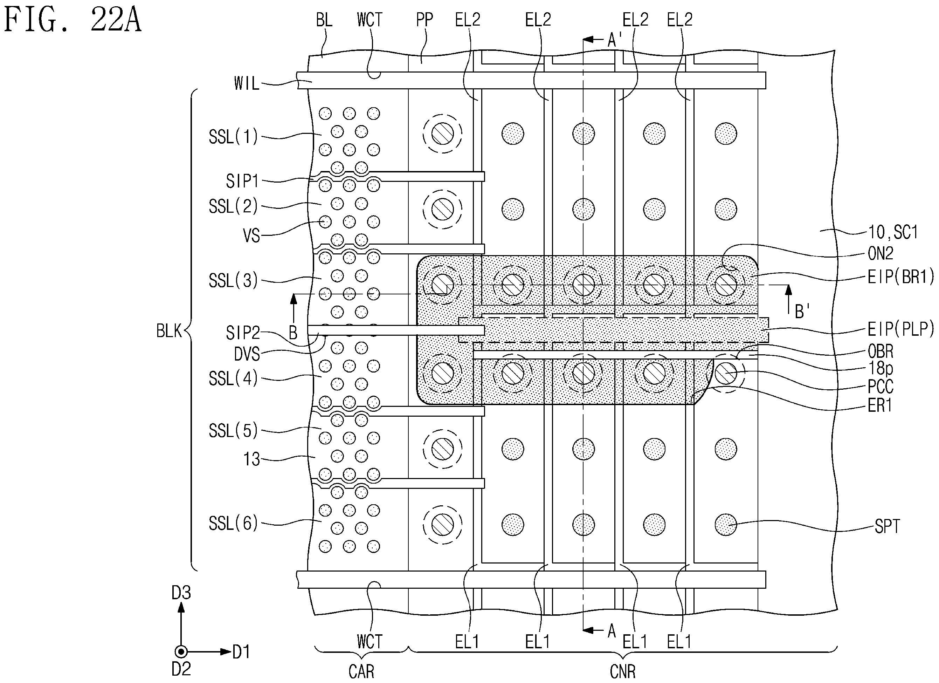

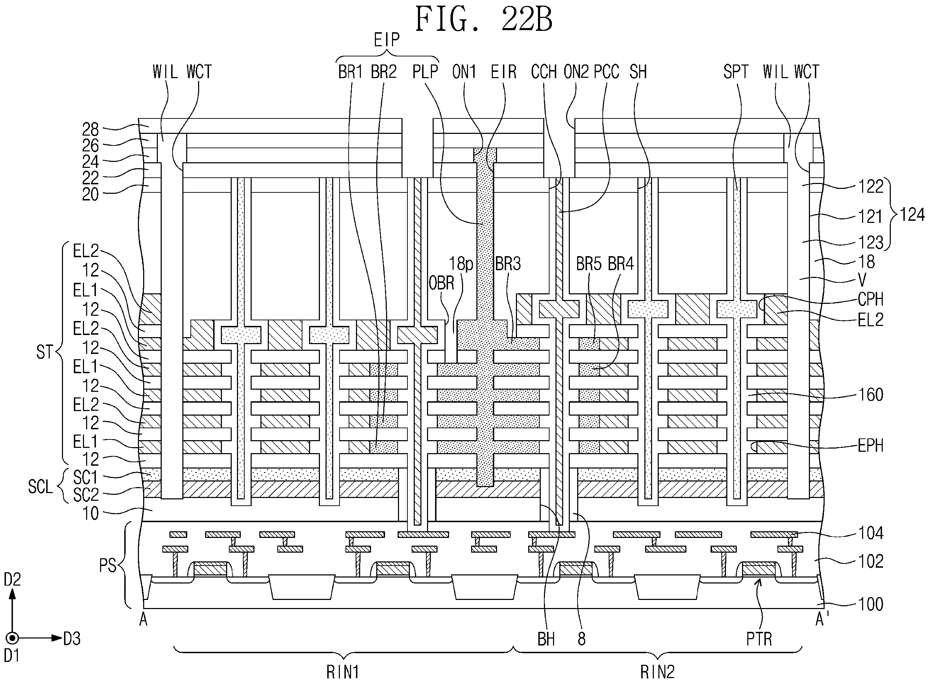

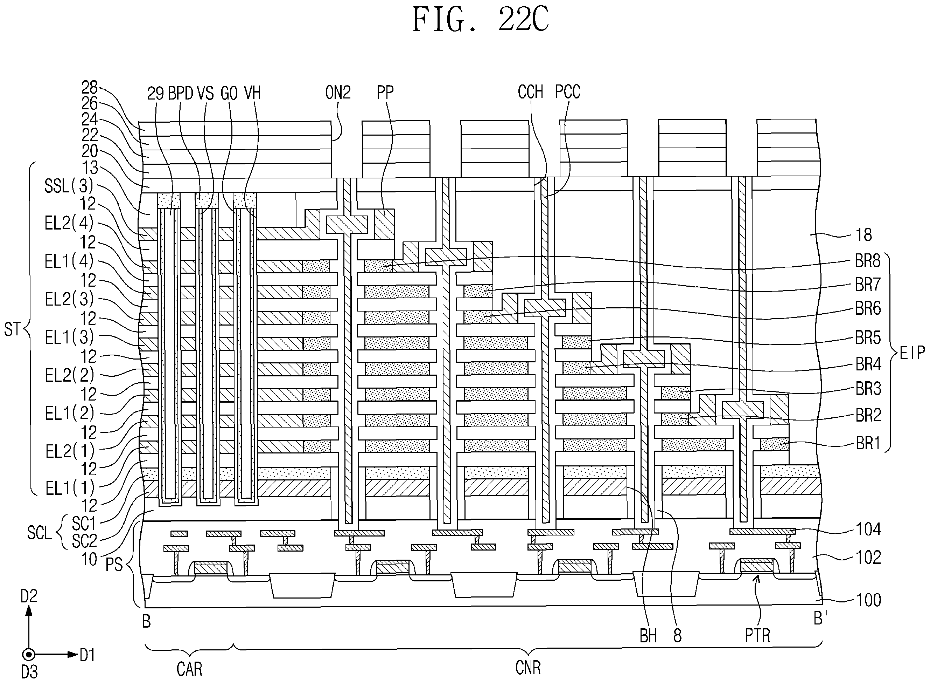

Referring to FIGS. 22A to 22C the second to fifth upper insulating layers 22, 24, 26, and 28 are etched to form second openings ON2 exposing the cell contact holes CCH.

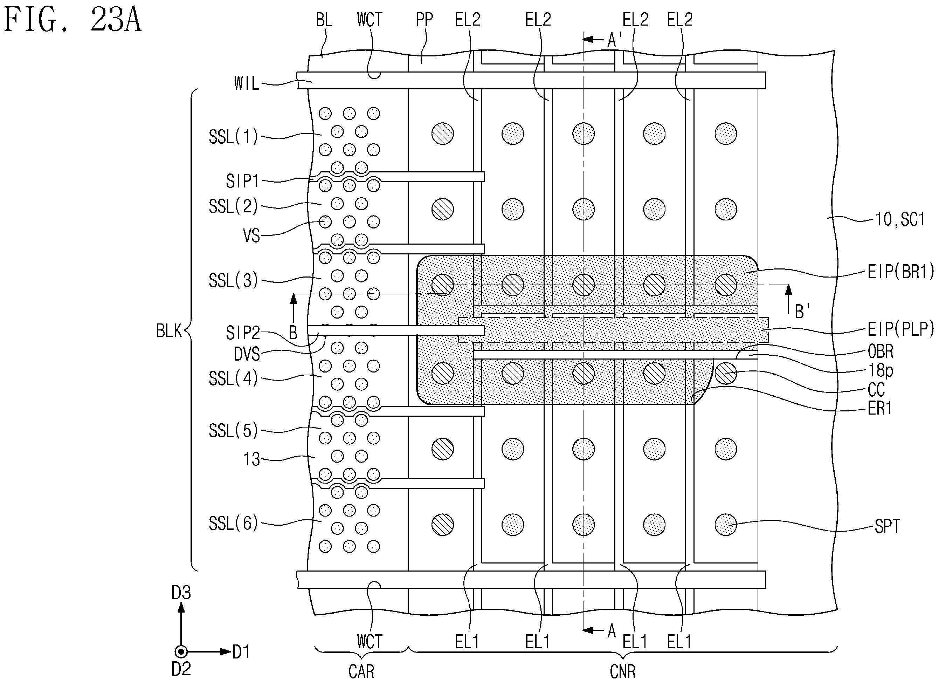

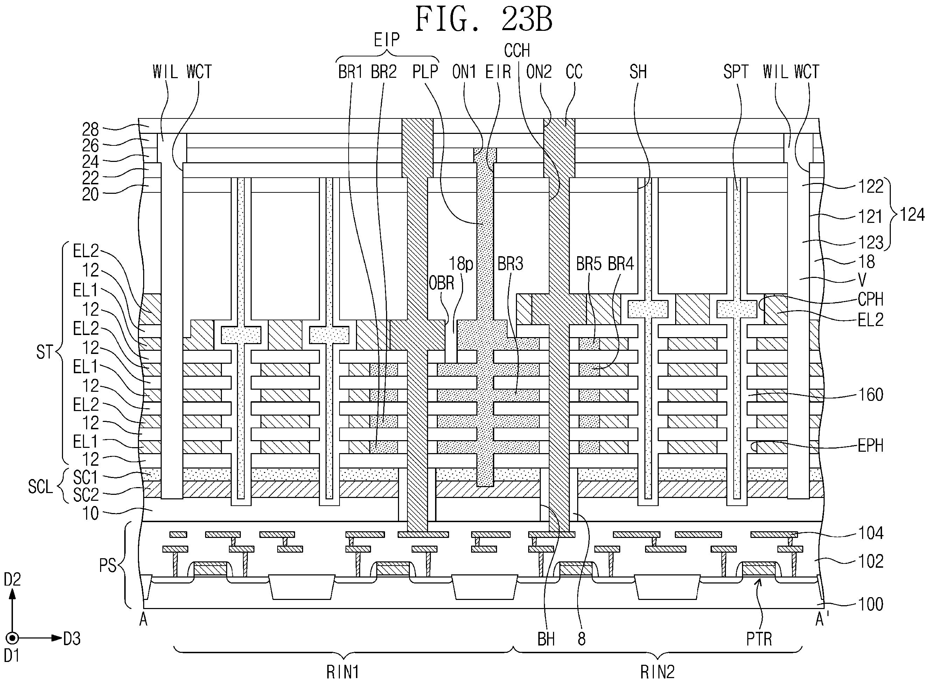

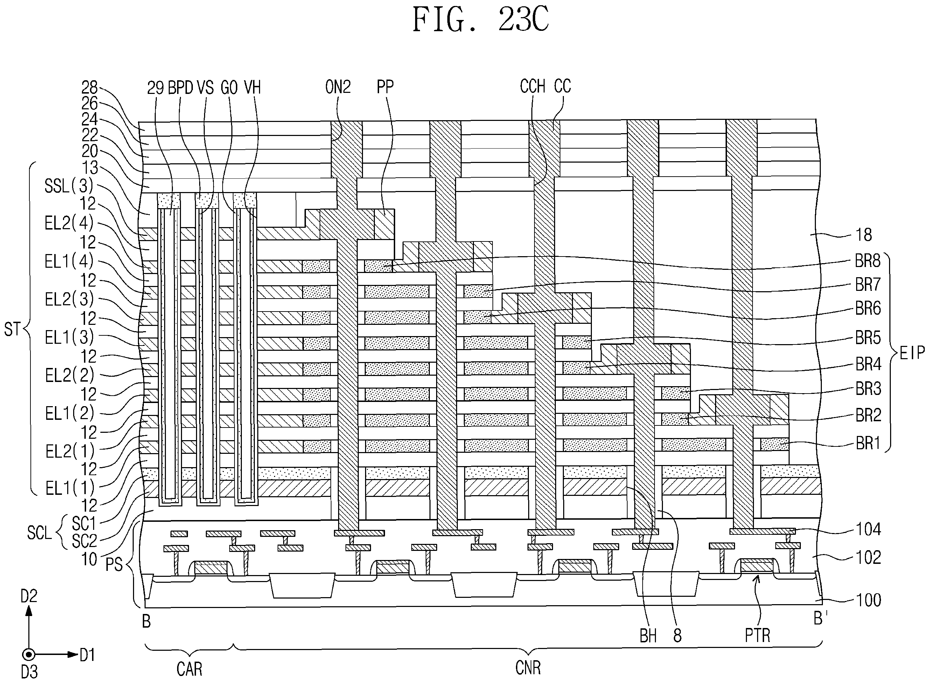

Referring to FIGS. 22A to 22C and 23A to 23C, all of the protective pattern PCC and a portion of the contact insulation pattern 160 are removed through the second openings ON2 to partially expose the peripheral circuit wirings 104. In this case, a portion of the contact insulating pattern 160 contacting the branch portions BR1 to BR8 of the end insulating pattern EIP at the inner wall of the cell contact hole CCH may remain without being removed. The second openings ON2 and the cell contact hole CCH are filled with a conductive material to form cell contacts CC.

Subsequently, referring to FIGS. 2 and 3A to 3D, a sixth upper insulating layer 30 is formed on the fifth upper insulating layer 28. The first to sixth upper insulating layers 20, 22, 24, 26, 28, and 30 are etched to form a contact hole exposing the bit line pad BPD, and the contact hole is filled with a conductive material to form a bit line contact BLC. Bit lines BL are formed on the sixth upper insulating layer 30. Thus, the above three-dimensional semiconductor memory device may be manufactured.

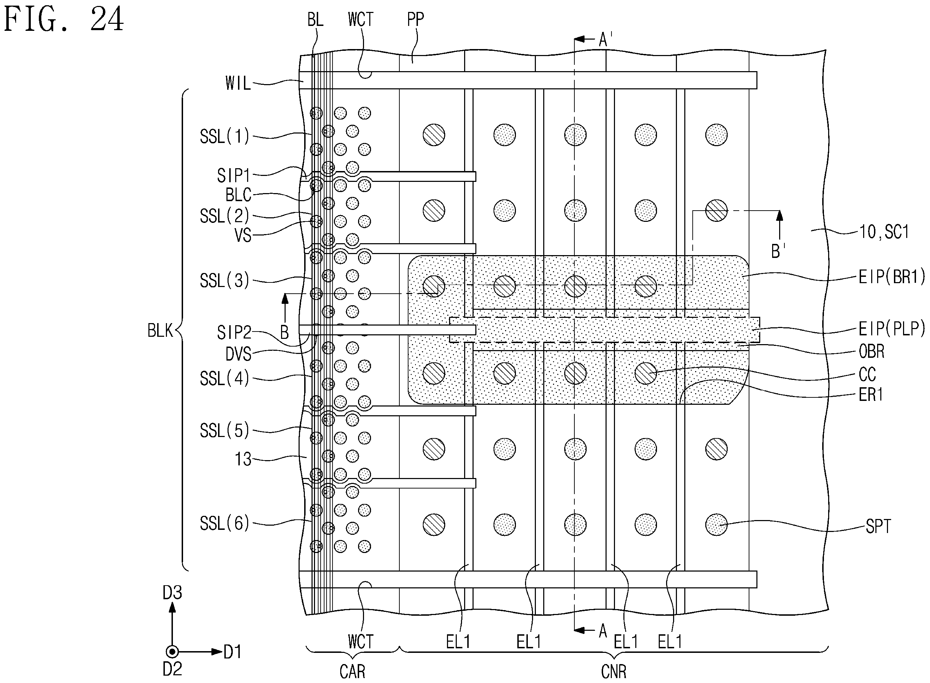

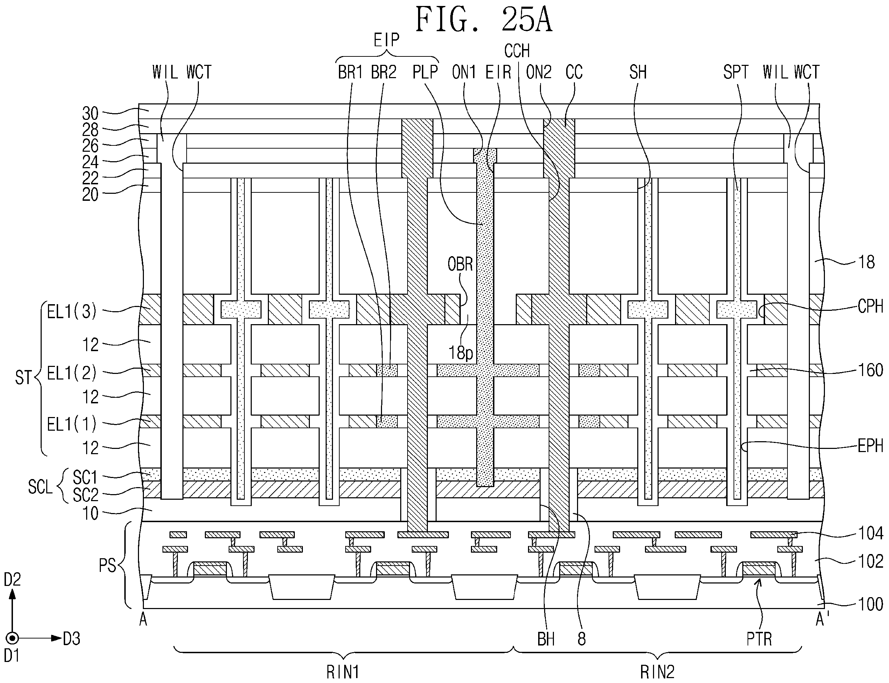

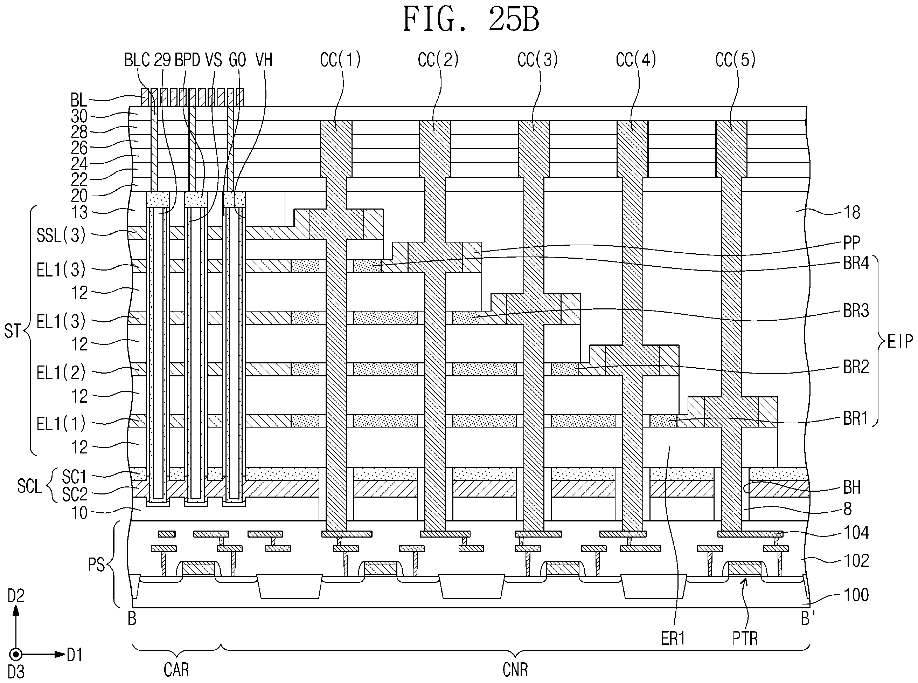

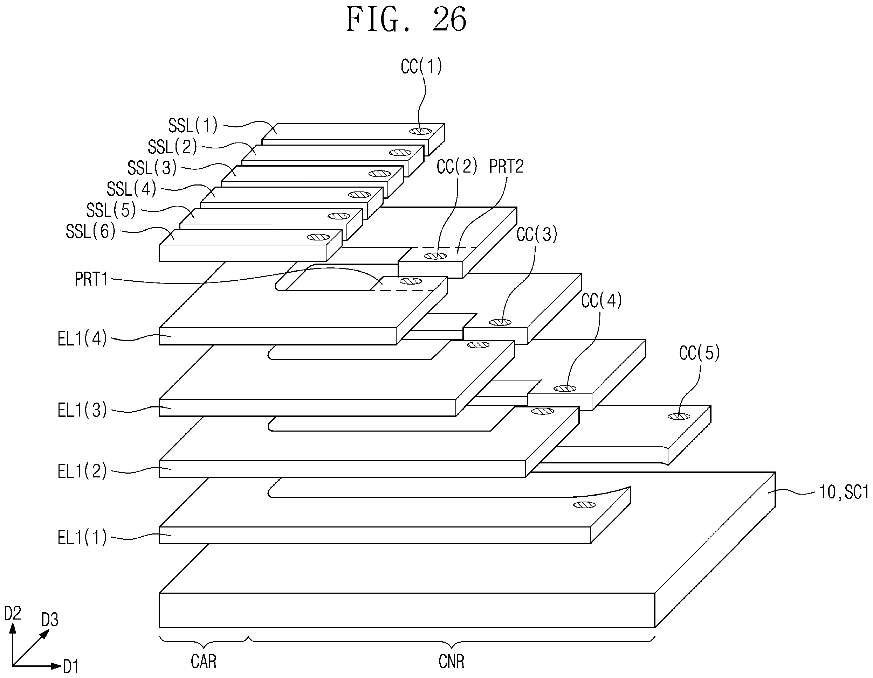

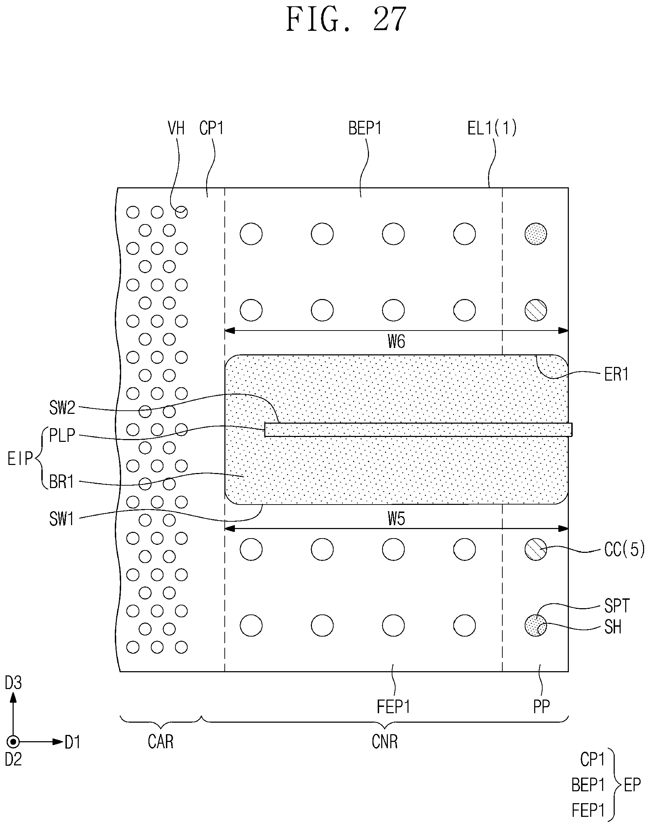

FIG. 24 is a plan view of a three-dimensional semiconductor memory device according to some example embodiments of the present disclosure. FIG. 25A is a cross-sectional view of FIG. 24 taken along line A-A'. FIG. 25B is a cross-sectional view of FIG. 24 taken along line B-B'. FIG. 26 is a partial perspective view of the three-dimensional semiconductor memory device having the plane of FIG. 24. FIG. 27 is a plan view of a first electrode layer positioned at a lowermost level in a three-dimensional semiconductor memory device according to some example embodiments of the present disclosure.

Referring to FIGS. 24, 25A, 25B, 26, and 27, the three-dimensional semiconductor memory device according to some example embodiments does not include the second electrode layers EL2 of FIG. 3B. Each of the first electrode layers EL1 has a first front end FEP1 and a first back end BEP1. Pad portions PP are disposed at outermost ends of the first front end FEP1 and the first back end BEP1. The first front end FEP1 has a first protrusion portion PRT1 protruding toward the first back end BEP1. The first back end BEP1 has a second protrusion portion PRT2 protruding toward the first front end FEP1. The first branch portion BR1 of the end insulating pattern EIP has a first sidewall SW1 in contact with the first front end FEP1 of the (1-1)th electrode layer EL1(1) and a second sidewall SW2 in contact with the first back end BEP1 of the (1-1)th electrode layer EL1(1). The first sidewall SW1 has a fifth width W5 in the first direction D1. The second sidewall SW2 has a sixth width W6 equal to the fifth width W5 in the first direction D1. A pillar portion PLP of the end insulating pattern EIP may be positioned at a center of the removal protection region OBR. Other structures may be the same/similar to those described above.

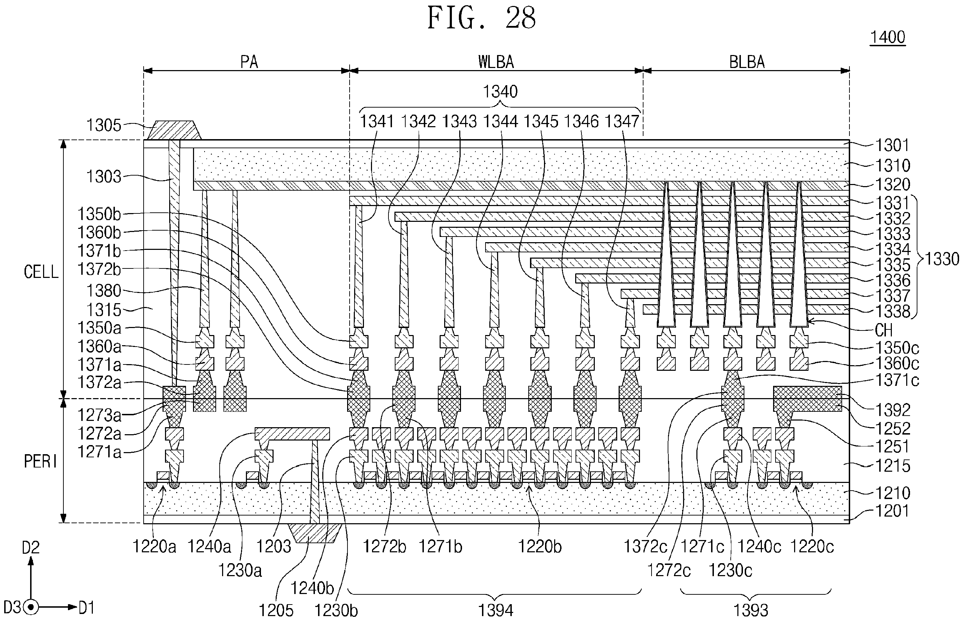

FIG. 28 is a cross-sectional view of a semiconductor device according to some example embodiments of the present disclosure.

Referring to FIG. 28, a memory device 1400 may have a chip to chip (C2C) structure. The C2C structure may mean that an upper chip including a cell array structure CELL on a first wafer is fabricated, a lower chip including a peripheral circuit structure PERI on a second wafer different from the first wafer is fabricated, and the upper chip and the lower chip are connected to each other by a bonding manner. As an example, the bonding manner may refer to a manner of electrically connecting a bonding metal formed on an uppermost metal layer of the upper chip and a bonding metal formed on an uppermost metal layer of the lower chip to each other. For example, when the bonding metal is formed of copper (Cu), the bonding manner may be a Cu-to-Cu bonding manner, and the bonding metal may also be formed of aluminum (Al) or tungsten (W).

Each of the peripheral circuit structure PERI and cell array structure CELL of the memory device 1400 may include an external pad bonding region PA, a word line bonding region WLBA, and a bit line bonding region BLBA.

The peripheral circuit structure PERI may include a first substrate 1210, an interlayer insulating layer 1215, a plurality of circuit elements 1220a, 1220b, and 1220c formed on the first substrate 1210, and first metal layers 1230a, 1230b, and 1230c connected to each of the plurality of circuit elements 1220a, 1220b, and 1220c, and second metal layers 1240a, 1240b, and 1240c formed on the first metal layers 1230a, 1230b, and 1230c. In some example embodiments, the first metal layers 1230a, 1230b, and 1230c may be formed of tungsten having a relatively high electrical resistivity, and the second metal layers 1240a, 1240b, and 1240c may be formed of copper having a relatively low electrical resistivity.

In this specification, the first metal layers 1230a, 1230b, and 1230c and the second metal layers 1240a, 1240b, and 1240c are shown and described, but are not limited thereto, and at least one metal layer may be further formed on the second metal layers 1240a, 1240b, and 1240c. At least some of the one or more metal layers formed on the second metal layers 1240a, 1240b, and 1240c may be formed of aluminum having a lower electrical resistivity than copper forming the second metal layers 1240a, 1240b, and 1240c.

An interlayer insulating layer 1215 may be disposed on the first substrate 1210 to cover the plurality of circuit elements 1220a, 1220b, and 1220c, the first metal layers 1230a, 1230b, and 1230c, and the second metal layers 1240a, 1240b, and 1240c, and include an insulating material such as silicon oxide or silicon nitride.

Lower bonding metals 1271b and 1272b may be formed on the second metal layer 1240b of the word line bonding region WLBA. In the word line bonding region WLBA, the lower bonding metals 1271b and 1272b of the peripheral circuit structure PERI may be electrically connected to the upper bonding metals 1371b and 1372b of the cell array structure CELL by a bonding manner. The lower bonding metals 1271b and 1272b and the upper bonding metals 1371b and 1372b may be formed of aluminum, copper, or tungsten.

The cell array structure CELL may correspond to the cell array structure CS described with reference to FIGS. 2 to 27. The cell array structure CELL may provide at least one memory block. The cell array structure CELL may include a second substrate 1310 and a common source line 1320. A plurality of word lines 1331 to 1338 (1330) may be stacked on the second substrate 1310 along a direction D2 perpendicular to the upper surface of the second substrate 1310. String select lines and a ground select line may be disposed on upper and lower portions of the word lines 1330, and a plurality of word lines 1330 may be disposed between the string select lines and the ground select line.

In the bit line bonding region BLBA, the channel structure 1CH extends in a direction D2 perpendicular to the upper surface of the second substrate 1310 to form word lines 1330, string select lines, and ground select lines. The channel structure CH may include a data storage layer, a channel layer, and a buried insulating layer, and the channel layer may be electrically connected to the first metal layer 1350c and the second metal layer 1360c. For example, the first metal layer 1350c may be a bit line contact, and the second metal layer 1360c may be a bit line. In some example embodiments, the bit line 1360c may extend along the third direction D3 parallel to the upper surface of the second substrate 1310.

In some example embodiments as shown in FIG. 28, a region where the channel structure CH and the bit line 1360c are disposed may be defined as a bit line bonding region BLBA. The bit line 1360c may be electrically connected to the circuit elements 1220c providing the page buffer 1393 in the peripheral circuit structure PERI in the bit line bonding region BLBA. For example, the bit line 1360c is connected to upper bonding metals 1371c and 1372c in the peripheral circuit structure PERI, and the upper bonding metals 1371c and 1372c are connected to circuit elements 1220c of the page buffer 1393. It may be connected to the connected lower bonding metals 1271c and 1272c.

In the word line bonding region WLBA, the word lines 1330 may extend along a first direction D1 perpendicular to the first direction and parallel to the top surface of the second substrate 1310, and may connect a plurality of cell contact plugs 1341 to 1347 (1340). The cell contact plugs 1341 to 1347 (1340) may have the same shape as the cell contacts CC of FIG. 6A.

The word lines 1330 and the cell contact plugs 1340 may be connected to each other through pads provided by extending at least some of the word lines 1330 with different lengths along the second direction. A first metal layer 1350b and a second metal layer 1360b may be sequentially connected to upper portions of the cell contact plugs 1340 connected to the word lines 1330. The cell contact plugs 1340 extend through the upper bonding metals 1371b and 1372b of the cell array region CELL and the lower bonding metals 1271b and 1272b of the peripheral circuit structure PERI in the word line bonding region WLBA. It may be connected to the circuit structure PERI.

The cell contact plugs 1340 may be electrically connected to circuit elements 1220b forming the row decoder 1394 in the peripheral circuit structure PERI. In some example embodiments, the operating voltage of the circuit elements 1220b forming the row decoder 1394 may be different from the operating voltage of the circuit elements 1220c forming the page buffer 1393. For example, the operating voltage of the circuit elements 1220c forming the page buffer 1393 may be higher than the operating voltage of the circuit elements 1220b forming the row decoder 1394.

A common source line contact plug 1380 may be disposed in the external pad bonding region PA. The common source line contact plug 1380 is formed of a conductive material such as metal, metal compound, or polysilicon, and may be electrically connected to the common source line 1320. A first metal layer 1350a and a second metal layer 1360a may be sequentially stacked on the common source line contact plug 1380. For example, a region where the common source line contact plug 1380, the first metal layer 1350a, and the second metal layer 1360a are disposed may be defined as an external pad bonding region PA.

Meanwhile, input/output pads 1205 and 1305 may be disposed in the external pad bonding region PA. Referring to FIG. 28, a lower insulating layer 1201 covering a lower surface of the first substrate 1210 may be formed under the first substrate 1210, and first input/output pads 1205 may be formed on the lower insulating layer 1201. The first input/output pad 1205 is connected to at least one of the plurality of circuit elements 1220a, 220b, and 220c disposed on the peripheral circuit structure PERI through the first input/output contact plug 1203, and the lower insulating layer 1201 may be separated from the first substrate 1210. In addition, a side insulating layer may be disposed between the first input/output contact plug 1203 and the first substrate 1210 to electrically separate the first input/output contact plug 1203 from the first substrate 1210.

Referring to FIG. 28, an upper insulating layer 1301 covering the upper surface of the second substrate 1310 may be formed on the second substrate 1310, and second input/output pads 1305 may be formed on the upper insulating layer 1301. The second input/output pad 1305 may be connected to at least one of the plurality of circuit elements 1220a, 1220b, and 1220c arranged in the peripheral circuit structure PERI through the second input/output contact plug 1303. In some example embodiments, the second input/output pad 1305 may be electrically connected to the circuit element 1220a.

According to some example embodiments, the second substrate 1310 and the common source line 1320 may not be disposed in a region where the second input/output contact plug 1303 is disposed. Also, the second input/output pad 1305 may not overlap the word lines 1380 in the second direction D2. Referring to FIG. 28, the second input/output contact plug 1303 is separated from the second substrate 1310 in a direction parallel to the upper surface of the second substrate 1310, and the interlayer insulating layer 1315 of the cell array structure CELL and may be connected to the second input/output pad 1305.

According to some example embodiments, the first input/output pad 1205 and the second input/output pad 1305 may be selectively formed. For example, the memory device 1400 includes only the first input/output pad 1205 disposed on the first substrate 1210 or the second input/output pad 1305 disposed on the second substrate 1310. Alternatively, the memory device 1400 may include both the first input/output pad 1205 and the second input/output pad 1305.

In each of the external pad bonding region PA and the bit line bonding region BLBA included in the cell array structure CELL and the peripheral circuit region PERI, the metal pattern of the uppermost metal layer exists as a dummy pattern, or the top metal layer may be empty.

In the external pad bonding region PA of the memory device 1400, a lower metal pattern 1273a having the same shape as the upper metal pattern 1372a of the cell array structure CELL may be formed on an uppermost metal layer of the peripheral circuit structure PERI, corresponding to the upper metal pattern 1372a formed on the uppermost metal layer of the cell array structure CELL. The lower metal pattern 1273a formed on the uppermost metal layer of the peripheral circuit structure PERI may not be connected to a separate contact in the peripheral circuit structure PERI. Similarly, an upper metal pattern 1372a having the same shape as the lower metal pattern 1273a of the peripheral circuit structure PERI may be formed on the upper metal layer of the cell array structure CELL, corresponding to the lower metal pattern 1273a formed on the uppermost metal layer of the peripheral circuit structure PERI in the external pad bonding region PA.

Lower bonding metals 1271b and 1272b may be formed on the second metal layer 1240b of the word line bonding region WLBA. In the word line bonding region WLBA, the lower bonding metals 1271b and 1272b of the peripheral circuit structure PERI may be electrically connected to the upper bonding metals 1371b and 1372b of the cell array structure CELL by a bonding manner.

Additionally, in the bit line bonding region BLBA, an upper metal pattern 1392 having the same shape as the lower metal pattern 1252 of the peripheral circuit structure PERI may be formed on the uppermost metal layer of the cell array structure CELL, corresponding to the lower metal pattern 1252 formed on the uppermost metal layer of the peripheral circuit structure PERI. A contact may not be formed on the upper metal pattern 1392 formed on the uppermost metal layer of the cell array structure CELL

In a three-dimensional semiconductor memory device and an electronic system including the same according to some example embodiments of the present disclosure, the electrode layers have protrusions arranged alternately front and back in the stepped form, and are in contact with the contact disk portions of the cell contacts. In addition, the pillar portions of the cell contacts may be insulated from other electrode layers positioned below the protruding portions by the contact insulation pattern and the end insulation pattern. Accordingly, it is possible to prevent or the chance thereof reduce the short circuit between the cell contacts and the electrode layers, to minimize or reduce the signal interference between the electrode layers, and to prevent or reduce the breakdown voltage drop. Accordingly, the operation errors of the three-dimensional semiconductor memory device may be prevented or reduced and reliability thereof may be improved.

When the terms "about" or "substantially" are used in this specification in connection with a numerical value, it is intended that the associated numerical value includes a manufacturing or operational tolerance (e.g., ±10 %) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10 %) around the stated numerical values or shapes.

As described herein, any electronic devices and/or portions thereof according to any of the example embodiments may include, may be included in, and/or may be implemented by one or more instances of processing circuitry such as hardware including logic circuits; a hardware/software combination such as a processor executing software; or any combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a DRAM device, storing a program of instructions, and a processor (e.g., CPU) configured to execute the program of instructions to implement the functionality and/or methods performed by some or all of any devices, systems, modules, units, controllers, circuits, architectures, and/or portions thereof according to any of the example embodiments, and/or any portions thereof.

While example embodiments are described above, a person skilled in the art may understand that many modifications and variations are made without departing from the scope of the present disclosure defined in the following claims. Accordingly, the example embodiments of the present disclosure should be considered in all respects as illustrative and not restrictive, with the scope of the present disclosure being indicated by the appended claims. For example, the example embodiments of Figs. 1A through 28 can be combined with each other.

## Claims

1. A three-dimensional semiconductor memory device comprising:
a substrate including a cell array region and a connection region side by side in a first direction; and
a stack structure including electrode layers and inter-electrode insulating layers alternately stacked in a second direction, the second direction being perpendicular to the substrate, the electrode layers including first electrode layers and second electrode layers alternately stacked,
each of the first electrode layers including
a first connection portion in the cell array region; and
a first front end and a first back end spaced apart from each other in a third direction, the third direction intersecting the first and second directions, in the connection region and positioned at a same level,
wherein the first front end and the first back end are connected to the first connection portion, the first front end has a first protrusion protruding toward the first back end, and the first protrusions of the first front ends do not overlap the second electrode layers.

2. The three-dimensional semiconductor memory device of claim 1, wherein each of the second electrode layers includes:
a second connection portion in the cell array region; and
a second front end and a second back end spaced apart from each other in the third direction in the connection region and positioned at a same level,
wherein the second front end and the second back end are connected to the second connection portion, the second back end has a second protrusion protruding toward the second front end, and the second protrusions of the second back ends do not overlap the first electrode layers.

3. The three-dimensional semiconductor memory device of claim 2, wherein upper surfaces of the first front ends are exposed without being covered by the second front ends.

4. The three-dimensional semiconductor memory device of claim 2 or claim 3, wherein upper surfaces of the second back ends are exposed without being covered by the first back ends.

5. The three-dimensional semiconductor memory device of any of claims 2-4, wherein
the first front ends form a step shape in the first direction, and
the first back ends form a step shape in the first direction.

6. The three-dimensional semiconductor memory device of any of claims 2-5,
wherein the second front ends form a step shape in the first direction, and
the second back ends form a step shape in the first direction.

7. The three-dimensional semiconductor memory device of any of claims 2-6, further comprising an end insulating pattern between the second front ends and the second back ends on the connection region,
wherein the end insulation pattern includes:
a pillar portion extending in the second direction perpendicular to an upper surface of the substrate; and
branch portions protruding from a side surface of the pillar portion to the second front ends and the second back ends.

8. The three-dimensional semiconductor memory device of claim 7, further comprising second cell contacts passing through the second protrusions and the branch portions and connected to the second protrusions, respectively.

9. The three-dimensional semiconductor memory device of any preceding claim, further comprising upper conductive lines positioned on an uppermost second electrode layer among the second electrode layers,
wherein each of the upper conductive lines has a line shape extending in the first direction, and the upper conductive lines are spaced apart from each other in the third direction, and
wherein ends of the upper conductive lines do not overlap the first protrusions.

10. The three-dimensional semiconductor memory device of claim 9, wherein
the upper conductive lines include first to sixth upper conductive lines sequentially in the third direction, and
the three-dimensional semiconductor memory device further includes:
a first upper separation pattern interposed between the first upper conductive line and the second upper conductive line and having a zigzag line shape in the first direction; and
a second upper separation pattern interposed between the third upper conductive line and the fourth upper conductive line and having a linear line shape in the first direction.

11. The three-dimensional semiconductor memory device of claim 10, wherein the second upper separation pattern does not pass through the first and second electrode layers.

12. The three-dimensional semiconductor memory device of any preceding claim, wherein
the substrate has a plurality of block regions arranged side by side in the third direction,
each of the block regions has a first width in the third direction, and
the first connection portion has the first width in the third direction.

13. The three-dimensional semiconductor memory device of any preceding claim, wherein, when viewed in a plan view, a side surface of the first protrusion of a lowest first electrode layer among the first electrode layers that meets an inner sidewall of the lowest first electrode layer is rounded.

14. The three-dimensional semiconductor memory device of any preceding claim, further comprising an end insulating pattern interposed between the first front ends and the first back ends on the connection region,
wherein the end insulation pattern includes:
a pillar portion extending in the second direction perpendicular to an upper surface of the substrate; and
branch portions protruding from a side surface of the pillar portion toward the first front ends and the first back ends.

15. The three-dimensional semiconductor memory device of claim 14, further comprising first cell contacts passing through the first protrusions and the branch portions and connected to the first protrusions, respectively.
